(19) Europäisches Patentamt
European Patent Office
Office européen des brevets

(11) **EP 1 202 352 B1**

(12) **EUROPEAN PATENT SPECIFICATION**

(45) Date of publication and mention
of the grant of the patent:
**06.08.2008 Bulletin 2008/32**

(51) Int Cl.:
*H01L 29/06* (2006.01)  *H01L 29/745* (2006.01)
*H01L 29/78* (2006.01)  *H01L 29/786* (2006.01)
*H01L 27/092* (2006.01)  *H01L 21/336* (2006.01)
*H01L 29/861* (2006.01)  *H01L 27/06* (2006.01)
*H01L 27/12* (2006.01)  *H01L 29/74* (2006.01)
*H01L 29/749* (2006.01)  *H01L 29/739* (2006.01)

(21) Application number: **01128222.5**

(22) Date of filing: **29.01.1992**

(54) **High breakdown voltage semiconductor device**

Halbleiterbauelement mit hoher Durchbruchspannung

Dispositif semiconducteur à tension de claquage élevée

(84) Designated Contracting States:
**DE IT**

(30) Priority: **31.01.1991 JP 3172091**
**28.03.1991 JP 9006891**
**16.04.1991 JP 10960591**
**20.09.1991 JP 26897091**

(43) Date of publication of application:
**02.05.2002 Bulletin 2002/18**

(62) Document number(s) of the earlier application(s) in
accordance with Art. 76 EPC:
**92300753.8 / 0 497 577**

(73) Proprietor: **KABUSHIKI KAISHA TOSHIBA**
**Tokyo 105-8001 (JP)**

(72) Inventors:
• **Matsudai, Tomoko,**
**Kabushiki Kaisha Toshiba**
**Tokyo 105 (JP)**
• **Nakagawa, Akio,**
**Kabushiki Kaisha Toshiba**
**Tokyo 105 (JP)**
• **Yasuhara, Norio,**
**Kabushiki Kaisha Toshiba**
**Tokyo 105-8001 (JP)**

(74) Representative: **Granleese, Rhian Jane**
**Marks & Clerk**
**90 Long Acre**
**London WC2E 9RA (GB)**

(56) References cited:
**EP-A- 0 280 535**  **DE-A- 3 806 164**
**US-A- 4 729 008**  **US-A- 4 807 012**

**Description**

The present invention relates to a high breakdown voltage semiconductor device.

In a high breakdown voltage semiconductor device, dielectric isolation method is known as an effective method of isolating each element.

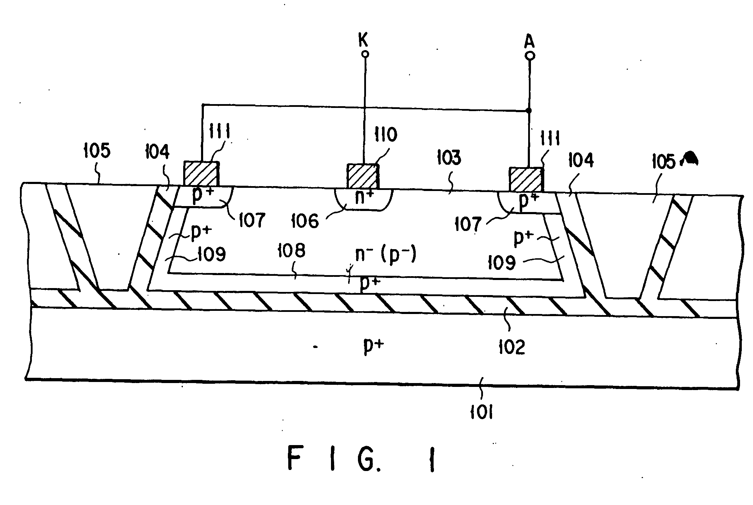

Fig. 1 shows a conventional high breakdown voltage diode obtained by using such a dielectric isolation method. Reference numeral 101 denotes a $p^+$ type silicon substrate, and there is formed a substrate wafer in which the $p^+$ type silicon substrate and an $n^-$ (or $p^-$) type silicon substrate are bonded to each other by a direct bonding method. Reference numeral 102 is an oxide film of a bonding interface. The $n^-$ type substrate of the substrate wafer is selectively etched up to the depth reaching the oxide film 102, so that a groove is formed. Thereby, an $n^-$ type layer 103, which is an island element region, is formed. In the groove, an oxide film 104 is formed inside and a polycrystalline silicon film 105 is buried therein. An $n^+$ type layer 106, serving as a cathode region, is formed in the central surface portion of the island $n^-$ type layer 103 isolated from other portions by the oxide films 102 and 104. Then, $p^+$ type layer 107, serving as an anode region, is formed in the peripheral surface portion. As a result, a diode is formed. $P^+$ layers 108 and 109 are formed along the oxide films 102 and 104 so as to enclose the surroundings of the island $n^-$ type layer 103. The $p^+$ type layers 108 and 109 are formed so as to allow large current to flow. A cathode electrode 110 and an anode electrode 111 are formed on the $n^+$ type layer 106 and $p^+$ type layer 107, respectively.

In the above diode, if reverse bias is applied to the portion between the anode and the cathode and a depletion layer extends to the $n^-$ type layer 103, and all applied voltages are applied between the $n^+$ type layer 106 of the surface portion and the $p^+$ type layer 108 of the bottom portion. Therefore, in order to obtain a diode having sufficient high breakdown voltage, it is required that a distance d between the $n^+$ type layer 106 and the $p^+$ type layer 108 be sufficiently largely made. More specifically, in order to obtain voltage of 600 V, d = 45 $\mu$m is needed.

If the thickness of the $n^-$ type layer 103 is made larger so as to ensure the above-mentioned distance d, the groove for the element isolation in a lateral direction must be deepened in accordance with the thickness of the $n^-$ type layer 103. This makes it extremely difficult to perform the element isolation in the lateral direction.

As mentioned above, according to the semiconductor device having the conventional dielectric isolation structure, it is necessary to make the thickness of the high resistance semiconductor layer whose depletion layer extends sufficiently large so as to obtain a sufficient high breakdown voltage. Due to this, there is a problem that the element isolation becomes difficult to be performed.

The following explains the other examples of the semiconductor device having the conventional dielectric isolation structure.

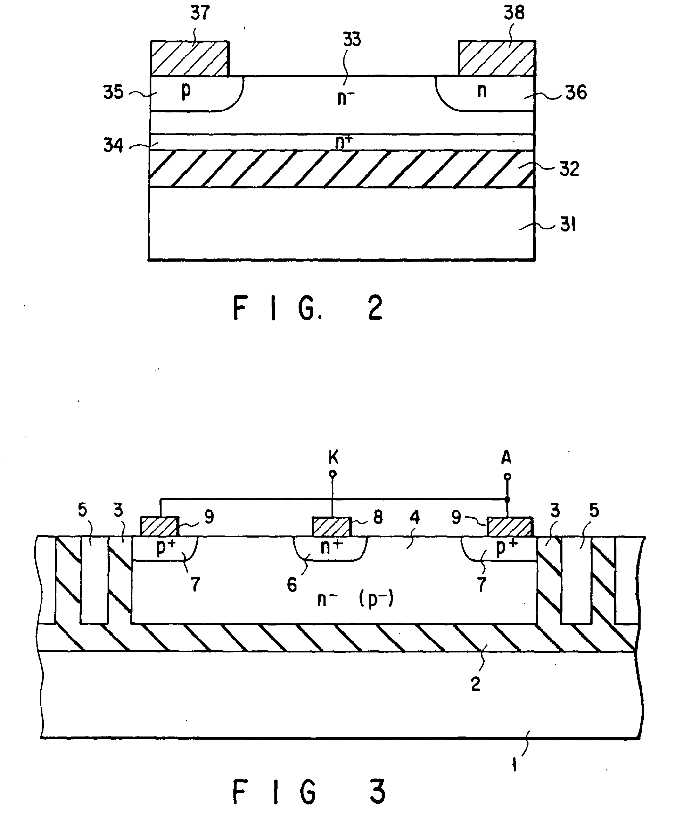

Fig. 2 shows a conventional lateral type diode having the conventional dielectric isolation structure. An $n^-$ type silicon layer (active layer) 33 is formed on a semiconductor substrate 31 via an insulating film 32 for isolation. An $n^+$ type layer 34 having a high impurity concentration is formed in the bottom portion of the active layer 33. A p-type anode layer 35 is formed in the active layer 33 and an n-type cathode layer 36 is formed in a portion which is away from the p-type anode layer 35 with a predetermined distance, and an anode electrode 37 and a cathode electrode 38 are formed on the anode layer 35 and the cathode layer 36, respectively.

In the above-mentioned lateral type diode, for example, considering a reverse bias state in which the anode electrode 37 and the substrate 31 are grounded and a positive voltage is applied to the cathode electrode 38, the voltage to be applied to the cathode is applied to the depletion layer extending to the active layer under the p-type anode layer 37, and the insulating film 32 for isolation.

Due to this, if the thickness of the active layer 33 under n-type cathode layer 36 is thin, a large electric field is shared at this portion, and an electric field concentration occurs in the vicinity of the curved portion of the bottom of the n-type cathode layer 36, and avalanche breakdown is generated at a low applied voltage. In order to avoid the above problem and realize the sufficient high breakdown voltage, the thickness of the active layer 33 is conventionally set to be 40 $\mu$m or more.

However, if the thickness of the active layer is large, a deep isolation groove is needed for the element isolation in the lateral direction by a V-groove, and an area of the isolation groove region becomes large. Due to this, work processing becomes difficult and an effective area of the element becomes small, so that the cost of an integrated circuit having the high breakdown voltage element increases.

As mentioned above, in the high breakdown voltage semiconductor device having the conventional dielectric isolation structure, if the active layer is thin, a sufficient breakdown voltage cannot be obtained. Moreover, if the active layer is thick, the element isolation in the lateral direction becomes difficult.

DE 3806164A1 corresponding to the preamble of claim 1 relates to a semiconductor device having a high breakdown voltage comprising a semiconductor layer with a low doping concentration provided above the main insulating film.

US 4 729 008 relates to a high voltage bipolar transistor and JFET with their geometry configured to work at the collector to base breakdown voltage as opposed to the collector to emitter breakdown voltage.

US 4 807 012 relates to integrated circuits having a shield layer.

EP 0280 535 relates to a conductively modulation MOSFET configured to accelerate dispersion of carriers during turn-off.

In order to solve the above-mentioned problems, an object of the present invention is to provide a semiconductor device having high breakdown voltage using the dielectric isolation structure wherein a sufficiently high breakdown voltage can be obtained even if a relative thin high resistance semiconductor layer is used.

According to the present invention, there is provided a semiconductor device which comprises:

a substrate;

an insulating layer formed on said substrate;

a high resistance semiconductor region formed on said insulating layer;

a dielectric isolation region formed in said high resistance semiconductor layer;

an element region formed in said high resistance semiconductor layer isolated by said dielectric isolation region in a lateral direction;

a first low resistance region of a first conductivity type formed in a surface portion of said element region; and

a second low resistance region of a second conductivity type formed in said element region between said first low resistance region and said dielectric isolation region to be separated from said first low resistance region

characterized by further comprising a third low resistance region of a first conductivity type formed contiguous with the isolation region, the device being configured such that a reverse bias voltage ($V_0$) applied between the first and second low resistance regions which causes a depletion layer generated between the insulating layer and second low resistance regions to electrically separate the first low resistance region from the third low resistance region is less than the breakdown voltage ($V_B$) between the second and third low resistance regions.

This invention can be more fully understood from the following detailed description when taken in conjunction with the accompanying drawings, in which:

Figs. 1 and 2 are cross sectional views showing a conventional high breakdown voltage diode;

Fig. 3 is a cross sectional view showing a diode of an example useful for understanding the present invention;

Fig. 4 is a cross sectional view showing a diode of an example useful for understanding the present invention in which a buffer layer is formed in a bottom portion of a device;

Fig. 5 is a cross sectional view showing a diode of an example useful for understanding the present invention in which anode and cathode are alternately formed;

Fig. 6 is a cross sectional view showing an example useful for understanding the present invention applied to a MOSFET;

Fig. 7 is a cross sectional view showing a diode of an example useful for understanding the present invention in which the anode and cathode of Fig. 3 are reversely formed;

Fig. 8 is a cross sectional view showing a diode of an example useful for understanding the present invention in which a low resistance region is formed on the side portion of the device;

Fig. 9 is a cross sectional view showing a diode of an example useful for understanding the present invention in which the buffer layer is formed in the bottom portion of the device of Fig. 8;

Fig. 10 is a cross sectional view showing a diode of an embodiment in which a low resistance region of the opposite conductivity type to that of Fig. 8 is formed on the side portion of the device;

Fig. 11 is a cross sectional view showing a diode of an example useful for understanding the present invention in which a pn junction isolation is made in a lateral direction;

Fig. 12 is a cross sectional view showing a diode of an example useful for understanding the present invention in which the buffer layer is formed in the bottom portion of the device of Fig. 11;

Fig. 13 is a cross sectional view showing an example useful for understanding the present invention in which a diode in which the pn junction isolation is made in a lateral direction;

Fig. 14 is a cross sectional view showing a diode of an embodiment in which a low resistance region and a pn junction having low voltage strength formed on the side portion of the device;

Fig. 15 is a cross sectional view showing extension of a depletion layer at the time when reverse bias is applied to the device of Fig. 14;

Fig. 16 is a cross sectional view showing the state of the depletion layer at the time when high reverse bias is applied to the device of Fig. 14;

Fig. 17 is a cross sectional view showing a diode of an embodiment in which the buffer layer is formed in the bottom portion of the device of Fig. 14;

Fig. 18 is a cross sectional view showing a diode of an embodiment in which the structure of Fig. 14 is slightly modified;

Fig. 19 is a cross sectional view showing a diode of an embodiment in which the buffer layer is formed in the bottom portion of the device of Fig. 18;

Fig. 20 is a cross sectional view showing an embodiment of a MOSFET in which the structure of Fig. 18 is modified;

Fig. 21 is a cross sectional view showing the extension of the depletion layer in the device of Fig. 20;

Fig. 22 is a cross sectional view showing the extension of the depletion layer at the time when reverse bias to be applied is higher in the device of Fig. 20;

Fig. 23 is a cross sectional view showing the extension of the depletion layer at the time when reverse bias to be applied is much higher in the device of Fig. 20;

Fig. 24 is a cross sectional view showing an embodiment in which high breakdown voltage characteristic is further improved based on the device of Fig. 20;

Fig. 25 is a cross sectional view showing an embodiment of an IGBT of based on the structure of Fig. 20;

Fig. 26 is a cross sectional view showing an embodiment of an MCT in which the embodiment of Fig. 25 is partially modified;

Fig. 27 is a cross sectional view showing an embodiment of the MCT in which the embodiment of Fig. 25 is partially modified;

Fig. 28 is a cross sectional view showing an embodiment of an EST in which the embodiment of Fig. 27 is partially modified;

Fig. 29 is a cross sectional view showing a diode of an embodiment in which each conductivity type of each portion of Fig. 14 is reversed;

Fig. 30 is a cross sectional view showing a diode of an embodiment in which the embodiment of Fig. 29 is slightly modified;

Fig. 31 is a cross sectional view showing a diode of an embodiment in which the lateral isolation groove of Fig. 14 is V-grooved;

Fig. 32 is a cross sectional view showing a diode of an embodiment in which a second low resistance region is deeply formed by impurity diffusion;

Fig. 33 is a cross sectional view showing a diode of an embodiment in which the buffer layer is formed in the bottom portion of the device of Fig. 32;

Fig. 34 is a cross sectional view showing a diode of an embodiment in which each conductivity type of each portion of Fig. 32 is reversed;

Fig. 35 is a cross sectional view showing an embodiment in which a high breakdown voltage diode is integrated with an npn transistor;

Fig. 36 is a cross sectional view showing an embodiment in which the structure of Fig. 35 is modified;

Fig. 37 is a cross sectional view showing an embodiment in which a high breakdown voltage MOSFET is integrated with the npn transistor;

Fig. 38 is a cross sectional view showing an IGBT of an embodiment in which the MOSFET of Fig. 37 is partially modified;

Fig. 39 is a cross sectional view showing an embodiment of the IGBT in which the embodiment of Fig. 38 is partially modified;

Fig. 40 is a cross sectional view showing an IGBT of an embodiment in which the IGBT of Fig. 39 is partially modified;

Fig. 41 is a cross sectional view showing an embodiment in which the present invention is applied to a p channel IGBT;

Fig. 42 is a cross sectional view showing an embodiment in which the IGBT of the embodiment of Fig. 41 is modified;

Fig. 43 is a cross sectional view showing an example useful for understanding the present invention in which a high resistance film is formed in the bottom portion of the high resistance silicon layer based on the example of Fig. 3;

Fig. 44 is a cross sectional view showing an example useful for understanding the present invention of an n channel IGBT using the same structure as that of Fig. 43;

Fig. 45 is a cross sectional view showing an IGBT of an example useful for understanding the present invention in which the structure of Fig. 44 is modified;

Fig. 46 is a cross sectional view showing an IGBT of an embodiment in which the structure of Fig. 44 is modified;

Fig. 47 is a cross sectional view showing an IGBT of an embodiment in which the structure of Fig. 46 is modified;

Fig. 48 is a cross sectional view showing an IGBT of an example useful for understanding the present invention in which the structure of Fig. 45 is modified;

Fig. 49 is a cross sectional view showing an example useful for understanding the present invention in which the lateral element isolation of the element of Fig. 46 is performed by LOCOS method;

Fig. 50 is a cross sectional view showing an example useful for understanding the present invention in which the structure of Fig. 49 is partially modified;

Fig. 51 is a cross sectional view showing an example useful for understanding the present invention in which the element isolation due to LOCOS method is applied to the embodiment of Fig. 48;

Fig. 52 is a cross sectional view showing an example useful for understanding the present invention in which an MCT is formed in the region isolated by the LOCOS;

Fig. 53 is a cross sectional view showing an example useful for understanding the present invention in which IGBT of the example of Fig. 49 is partially modified;

Fig. 54 is a cross sectional viewing showing an example useful for understanding the present invention in which the IGBT of the example of Fig. 44 is partially modified;

Fig. 55. is a cross section viewing showing an example useful for understanding the present invention where the example of Fig. 54 is partially modified;

Figs. 56A and 56P are cross sectional views showing a manufacture process of the device substrate of the example of Fig. 55;

Fig. 57 is a cross sectional view showing an example useful for understanding the present invention in which the example of Fig. 55 is partially modified;

Fig. 58 is a cross sectional view showing an example useful for understanding the present invention in which the example of Fig. 55 is partially modified;

FIG. 59 is a cross sectional view showing an example useful for understanding the present invention in which the example of Fig. 54 is partially modified;

Fig. 60 is a cross sectional view showing an example useful for understanding the present invention in which the example of Fig. 55 is partially modified;

Fig. 61 is a cross sectional view showing an example useful for understanding the present invention in which the example of Fig. 54 is partially modified;

Fig. 62 is a cross sectional view showing an example useful for understanding the present invention in which the example of Fig. 61 is partially modified;

Fig. 63 is a cross sectional view showing an example useful for understanding the present invention in which the example of Fig. 54 is partially modified;

Fig. 64 is a cross sectional view showing an example useful for understanding the present invention in which the example of Fig. 63 is partially modified;

Fig. 65 is a view showing an example useful for understanding the present invention applied to the lateral type diode;

Fig. 66 is a viewing showing a diode of an example useful for understanding the present invention in which the structure of Fig. 65 is slightly modified;

Fig. 67 is a view showing an example useful for understanding the present invention applied to the MOSFET;

Fig. 68 is a viewing showing a MOSFET of an example useful for understanding the present invention in which the structure of Fig. 67 is modified;

Fig. 69 is a view showing a MOSFET of an example useful for understanding the present invention in which the structure of Fig. 67 is modified;

Fig. 70 is a view showing a MOSFET of an example useful for understanding the present invention in which the structure of Fig. 68 is modified;

Fig. 71 is a view showing an example useful for understanding the present invention applied to the lateral type IGBT;

Fig. 72 is a view showing an IGBT of an example useful for understanding the present invention in which the structure of Fig. 71 is modified;

Fig. 73 is a view showing an IGBT of an example useful for understanding the present invention in which the structure of Fig. 71 is modified;

Fig. 74 is a view showing an IGBT of an example useful for understanding the present invention in which the structure of Fig. 72 is modified;

Fig. 75 is a view showing a diode of an example useful for understanding the present invention in which the structure of Fig. 65 is modified;

Fig. 76 is a viewing showing a MOSFET of an example useful for understanding the present invention in which the structure of Fig. 67 is modified;

Fig. 77 is a view showing a MOSFET of an example useful for understanding the present invention in which the structure of Fig. 76 is modified;

Fig. 78 is a view showing a MOSFET of an example useful for understanding the present invention in which the structure of Fig. 74 is modified;

Fig. 79 is a view showing a diode of an example useful for understanding the present invention in which a base high resistance film is added to the structure of Fig. 65;

Fig. 80 is a view showing a diode of an example useful for understanding the present invention in which a base high resistance film is added to the structure of Fig. 66;

Fig. 81 is a view showing a MOSFET of an example useful for understanding the present invention in which a base high resistance film is added to the structure of Fig. 67;

Fig. 82 is a view showing a MOSFET of an example useful for understanding the present invention in which a base high resistance film is added to the structure of Fig. 68;

Fig. 83 is a view showing a MOSFET of an example useful for understanding the present invention in which a base high resistance film is added to the structure of Fig. 69;

Fig. 84 is a view showing a MOSFET of an example useful for understanding the present invention in which a base high resistance film is added to the structure of Fig. 70;

Fig. 85 is a view showing an IGBT of an example useful for understanding the present invention in which a base high resistance film is added to the structure of Fig. 71;

Fig. 86 is a view showing an IGBT of an example useful for understanding the present invention in which a base high resistance film is added to the structure of Fig. 72;

Fig. 87 is a view showing an IGBT of an example useful for understanding the present invention in which a base high resistance film is added to the structure of Fig. 73;

Fig. 88 is a view showing an IGBT of an example useful for understanding the present invention in which a base high resistance film is added to the structure of Fig. 74;

Fig. 89 is a view showing a diode of an example useful for understanding the present invention in which a base high resistance film is added to the structure of Fig. 75;

Fig. 90 is a view showing a MOSFET of an example useful for understanding the present invention in which a base high resistance film is added to the structure of Fig. 76;

Fig. 91 is a view showing a MOSFET of an example useful for understanding the present invention in which a base high resistance film is added to the structure of Fig. 77;

Fig. 92 is a view showing a MOSFET of an example useful for understanding the present invention in which a base high resistance film is added to the structure of Fig. 78;

Fig. 93 is a view showing a diode of an example useful for understanding the present invention in which the structure of Fig. 79 is modified;

Fig. 94 is a view showing a diode of an example useful for understanding the present invention in which the structure of Fig. 80 is modified;

Fig. 95 is a view showing a MOSFET of an example useful for understanding the present invention in which the structure of Fig. 81 is modified;

Fig. 96 is a view showing a MOSFET of an example useful for understanding the present invention in which the structure of Fig. 82 is modified;

Fig. 97 is a view showing a MOSFET of an example useful for understanding the present invention in which the structure of Fig. 83 is modified;

Fig. 98 is a view showing a MOSFET of an example useful for understanding the present invention in which the structure of Fig. 84 is modified;

Fig. 99 is a view showing an IGBT of an example useful for understanding the present invention in which the structure of Fig. 85 is modified;

Fig. 100 is a view showing an IGBT of an example useful for understanding the present invention in which the structure of Fig. 86 is modified;

Fig. 101 is a view showing an IGBT of an example useful for understanding the present invention in which the structure of Fig. 87 is modified;

Fig. 102 is a view showing an IGBT of an example useful for understanding the present invention in which the structure of Fig. 88 is modified;

Fig. 103 is a view showing a diode of an example useful for understanding the present invention in which the structure of Fig. 89 is modified;

Fig. 104 is a view showing a MOSFET of an example useful for understanding the present invention in which the structure of Fig. 90 is modified;

Fig. 105 is a view showing a MOSFET of an example useful for understanding the present invention in which the structure of Fig. 91 is modified;

Fig. 106 is a view showing a MOSFET of an example useful for understanding the present invention in which the structure of Fig. 92 is modified;

Fig. 107 is a view showing a diode of an example useful for understanding the present invention in which the structure of Fig. 65 is modified;

Fig. 108 is a view showing a diode of an example useful for understanding the present invention in which the structure of Fig. 65 is modified;

Fig. 109 is a view showing a MOSFET of an example useful for understanding the present invention in which the structure of Fig. 67 is modified;

Fig. 110 is a view showing a MOSFET of an example useful for understanding the present invention in which the structure of Fig. 68 is modified;

Fig. 111 is a view showing a MOSFET of an example useful for understanding the present invention in which the structure of Fig. 67 is modified;

Fig. 112 is a view showing an IGBT of an example useful for understanding the present invention in which the structure of Fig. 71 is modified;

Fig. 113 is a view showing an IGBT of an example useful for understanding the present invention in which the structure of Fig. 71 is modified;

Fig. 114 is a view showing an IGBT of an example useful for understanding the present invention in which the structure of Fig. 71 is modified;

Fig. 115 is a view showing an IGBT of an example useful for understanding the present invention in which the structure of Fig. 71 is modified;

Fig. 116 is a view showing an IGBT of an example useful for understanding the present invention in which the structure of Fig. 71 is modified;

Fig. 117 is a view showing an IGBT of an example useful for understanding the present invention in which the structure of Fig. 71 is modified;

Fig. 118 is a view showing a diode of an example useful for understanding the present invention in which the structure of Fig. 65 is modified;

Figs. 119A to 119C are views showing an example of the structure of the lateral isolation of the device of an example useful for understanding the present invention;

Fig. 120 is a view showing the relationship between the total amount of impurities of an active layer and breakdown voltage in the example of Fig. 65;

Fig. 121 is a view showing the relationship between the thickness of an oxide film under the high resistance film and breakdown voltage in the example of Fig. 65;

Fig. 122 is a view showing the relationship between the thickness of the active layer and breakdown voltage in the example of Fig. 65;

Fig. 123 is a view showing a diode relating to an example useful for understanding the present invention of the present invention;

Fig. 124 is a view showing an IGBT relating to an example useful for understanding the present invention;

Fig. 125 is a view showing an IGBT of an example useful for understanding the present invention in which the structure of Fig. 124 is modified;

Fig. 126 is a view showing an IGBT of an example useful for understanding the present invention in which the structure of Fig. 124 is modified; and

Figs. 127 to 151 are views showing a diode or an IGBT of an example useful for understanding the present invention in which a high resistance film is removed in the example of Figs. 65 to 118.

It is assumed that reverse bias voltage is applied between first and second low resistance regions in a state that the first low resistance region is set to be a high potential and the second low resistance region is set to be a ground potential. At this time, the applied voltage is impressed to the high resistance semiconductor layer in a deep direction at the same time with the lateral direction. This is because a base semiconductor substrate is normally set to be a ground potential. Then, a depletion layer extends to the high resistance semiconductor layer from a pn junction around of the first or second low resistance region. When the applied voltage runs up to a certain value, the depletion layer reaches up to a first insulating film on the base semiconductor substrate, and the voltage in the deep direction is shared by the high resistance semiconductor layer and the first insulating film.

In order to prevent the avalanche breakdown in such a high voltage applying state, it is better that that portion of the applied voltage, which is shared by the first insulating film, is set to be larger. Moreover, since a dielectric flux density is continuous at the boundary surface between the high resistance semiconductor layer and the first insulating film, it is better that the electric field in the first insulating film is set to be small not to strengthen the electric field in the vertical direction in the high resistance semiconductor layer.

In the first high breakdown voltage semiconductor device relating to an example useful for understanding the present invention, since the thickness of the first insulating film is 1 $\mu$m or more, the electric filed in the first insulating film is relatively small even in a state that the depletion layer extends as mentioned above. Due to this, the vertical electric field of the high resistance semiconductor layer is controlled to be small. Moreover, since the applied voltage is mainly shared by the first insulating film, the applied voltage to be applied in the deep direction of the high resistance semiconductor layer is controlled to be small. As mentioned above, according to the semiconductor device relating to the present invention, even if the high resistance semiconductor is formed relatively thin, high breakdown voltage characteristic can be sufficiently obtained.

According to the first high breakdown voltage semiconductor device useful for understanding the present invention, particularly, if in the bottom portion of the high resistance layer, there is formed a buffer layer having low impurity concentration such that a total amount of impurity per a unit area is set to be $3 \times 10^{12}/cm^2$ or less, preferably 0.5 to $2.0 \times 10^{12}/cm^2$, much higher breakdown voltage can be obtained. This is because space charge having high concentration occurs from the high resistance semiconductor layer if the buffer layer is completely depleted at the time of reverse bias application. If a vertical component of the electric field at the boundary surface between the buffer layer and the first insulating film is Es on the semiconductor layer side, Ei on the insulating film side, a dielectric constant of the semiconductor layer is $\varepsilon s$, and a dielectric constant of the insulating film is $\varepsilon i$, an equation of Es = $(\varepsilon i/\varepsilon s)$ Ei can be obtained. Due to this, as the electric field in the first insulating film becomes larger, the electric field in the semiconductor layer becomes large in accordance with this. However, the space charge occurred in the buffer layer acts to relax the electric field on the semiconductor layer side. Therefore, by providing such a buffer layer, it is possible to make the electric field of the first insulating film larger as the electric field of the semiconductor layer is maintained small, thereby the high breakdown voltage can be obtained.

According to a second high breakdown voltage semiconductor device useful for understanding the present invention, the element isolation in the vertical direction is made by not the insulating film but the pn junction. Other than that, the structure of the second semiconductor device is the same as that of the first semiconductor device. Therefore, the second semiconductor device is a relatively thin high resistance semiconductor layer and can obtain a sufficient high breakdown voltage characteristic.

In the first high breakdown voltage semiconductor device, there is considered a case in which a third low resistance region of a first conductivity type is formed in the boundary surface portion between the second insulating film (isolating region) and the high resistance semiconductor layer of the element region. This structure cannot be avoided in a case in which a low resistance region of the first conductive type is formed on the groove side wall of the adjacent element region. This is because it is difficult to selectively diffuse a low resistance region in only one side of the groove side walls. According to this structure, there is a problem in breakdown occurring between the second and third low resistance regions when reverse bias is applied. First, if reverse bias is applied, the depletion layer extends to the high resistance semiconductor layer from the surroundings of the second low resistance region and the upper surface of the first insulating film. Where the first and third low resistance regions are connected through a neutral region, the potential of the third low resistance region follows the potential of the first low resistance region. When breakdown voltage of the pn junction between the second and third low resistance regions is $V_B$ and reverse bias voltage reaches to $V_B$ while the first and third low resistance regions regions are connected through the neutral region, breakdown is generated. If the thickness of the high resistance semiconductor layer and impurity concentration thereof are set such that the applied voltage at the time when the depletion layer under the second low resistance region reaches to the first insulating film is lower than $V_B$, the first and third low resistance regions is separated from each other by the depletion layer before breakdown occurs. As mentioned above, if the third low resistance region is separated from the first low resistance region by the depletion layer, the potential difference between the second low resistance region and the third low resistance region does not increase and breakdown between these low resistance regions is prevented.

According to a third high breakdown voltage semiconductor device, the second low resistance region is formed up to the depth reaching the first insulating film, so that the first and third low resistance regions are separated from each other. Therefore, the potential of the third low resistance region does not increase in accordance with the first low resistance region, and breakdown does not occur in the pn junction between the second and the third low resistance regions. Due to this, high breakdown voltage characteristic can be improved even if there is the third low resistance region.

According to a fourth high breakdown voltage semiconductor device useful for understanding the present invention, a high resistance film formed on the boundary surface between the first insulating film and the high resistance semiconductor layer acts to shield influence of the potential of the base semiconductor substrate, thereby excellent high breakdown voltage characteristic can be obtained.

Various embodiments of the present invention will be explained with reference to the drawings as follows.

Fig. 3 is a cross sectional view of a high breakdown voltage diode according to an example useful for understanding the present invention.

A reference numeral 1 is a monocrystal (or polycrystalline) silicon substrate. On the silicon substrate 1, there is formed an island high resistance silicon layer 4, which is separated from the substrate 1 by an oxide film 2 (first insulating film) and also separated from the other element regions in the lateral direction by an oxide film 3 (second insulating film). The thickness of the oxide film 2 is set to be 1 $\mu$m or more. The high resistance silicon layer 4 is an n⁻ type type (or p⁻ type). The element isolation region is formed by digging a trench, and the oxide film 3 is formed on the inner surface of the trench, thereafter a polycrystalline silicon film 5 is buried therein.

On the surface of the central portion of the high resistance silicon layer 4, there is formed an n⁺ type layer 6 (first low resistance region) having high impurity concentration, serving as a cathode region. On the surface of the peripheral portion of the high resistance silicon layer 4, there is formed a p⁺ type layer 7 (second low resistance region) having high impurity concentration, serving as an anode region. The p⁺ type layer 7 is formed to enclose the n⁺ type layer 6 seen from the top. A cathode electrode 8 is formed on the n⁺ type layer 6, and an anode electrode 9 is formed on the p⁺ type layer 7.

The manufacturing process of the above-mentioned diode is as follows.

The silicon substrate is bonded to the high resistance silicon substrate corresponding to the high resistance silicon layer 4 by the direct bonding technique. In other words, two substrates are mirror-polished, and these polished surfaces are bonded under a clean ambient atmosphere, and a predetermined thermal process is applied thereto, thereby these substrates are integrated. At this time, the oxide film 2 is formed on the adhesion surface of one substrate, thereby obtaining the integrated substrates in a state that they are electrically separated as shown in the figure. Then, the high resistance silicon substrate is polished so as to obtain the high resistance silicon layer 4 having a predetermined thickness which is necessary to the element region. Thereafter, a trench is formed in the element isolation region, and the oxide film 3 is formed on the inner surface of the high resistance silicon layer 4 isolated in an island manner. Then, the polycrystalline silicon film 5 is buried in the trench for isolation, thereafter, $n^+$ type layer 6 and $p^+$ type layer are sequentially diffused, and the electrodes 8 and 9 are formed.

In the above-structured diode, for example, if the substrate 1 and the electrode 9 are grounded, and a positive potential is applied to the electrode 8, the pn junction is reverse-biased, and the depletion layer extends into the high resistance silicon layer 4. The depletion layer extends to the upper portion from the boundary surface between the oxide film 2 and the high resistance silicon layer 4. If the applied voltage reaches to a certain value, the high resistance silicon layer 4 is filled with the depletion layer, and there occurs strong electrical field directing to the lower portion from the $n^+$ type layer 6.

However, according to the above-mentioned example, since the thickness of the oxide film 2 is set to be 1 $\mu$m or more, the applied voltage is mainly shared by the oxide film 2, the electrical field in the high resistance silicon layer 4 is controlled to be less than the value in which avalanche breakdown is generated. More specifically, even if the thickness of the high resistance silicon layer 4 is only 20 $\mu$m, high breakdown voltage of 350 V or more can be obtained. If the thickness of the oxide film 2 is set to be 2 $\mu$m or more, high breakdown voltage of 450 V or more can be obtained.

Furthermore, positive interface charge is naturally generated in the high resistance silicon layer 4 by the element forming process. The interface charge has an effect weakening the vertical electrical field in a case where the high resistance silicon layer 4 is n type, and such an effect contributes to improvement in the high breakdown voltage characteristic.

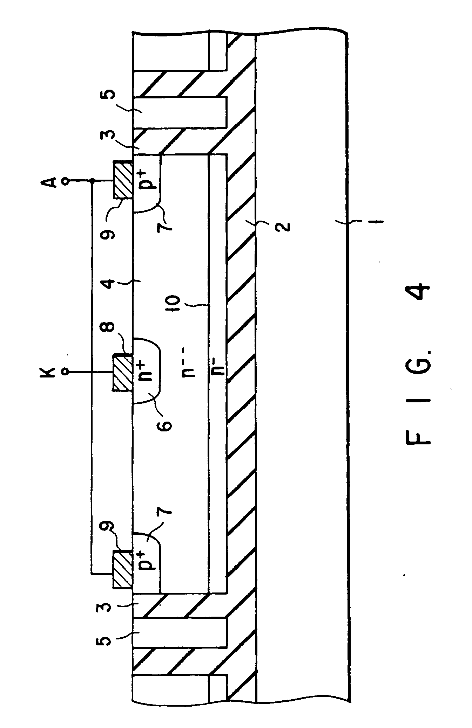

Fig. 4 shows an example useful for understanding the present invention in which an $n^-$ type buffer layer 10 having low impurity concentration (which is higher than the high resistance silicon layer 4) is formed in the bottom portion of the high resistance silicon layer 4 according to the device structure of the embodiment of Fig. 3. The buffer layer 10 is set such that a total amount of impurity is $3 \times 10^{12}/cm^2$ or less, preferably 0.5 to $2.0 \times 10^{12}/cm^2$.

According the above example, if reverse bias is applied between the anode and cathode and the buffer layer 10 is depleted, positive space charge occurs. The space charge acts to relax the electrical field in the high resistance silicon layer 4, so that high breakdown voltage characteristic can be improved.

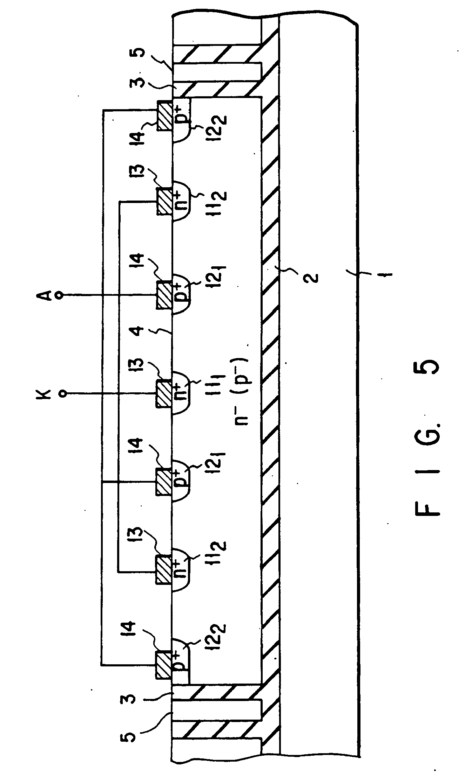

Fig. 5 shows an example useful for understanding the present invention in which an $n^+$ type layer 11, serving as a cathode region, and a $p^+$ type layer 12, serving as an anode region, are alternately formed based on the structure of Fig. 3. For example, an $n^+$ type layer 11a is formed in the central surface portion of the high resistance silicon layer 4, and a ring-shaped $p^+$ type layer 12b is formed so as to enclose the $n^+$ type layer 11a with a predetermined distance. Also, a ring-shaped $n^+$ type layer lib is formed outside of the $p^+$ type layer 12b with a predetermined distance. Furthermore, a ring-shaped $p^+$ type layer 12b is formed in the peripheral surface portion of the high resistance silicon layer outside of the $n^+$ type layer 11b. A cathode electrode 13 is formed on the $n^+$ type layer 11, and an anode electrode 14 is formed on the $p^+$ type layer 12. In this example, it is possible to repeat a stripe pattern may be repeated in place of the concentric ring-shaped pattern.

The above-mentioned structure is effective in that cathode current is dispersed and equalized when the element area is large. If reverse bias is applied between the cathode electrode 13 and the anode electrode 14, similar to the embodiment of Fig. 3, there occurs electrical field directing to the lower portion from the $n^+$ type layer 11. In this case, since the thickness of the oxide film 2 is set to be 1 $\mu$m or more, high breakdown voltage can be obtained.

Similarly, in the other examples to be explained later, the $n^+$ type layer and the $p^+$ type layer are alternately formed, and this is effective in reducing the on- state resistance of the element.

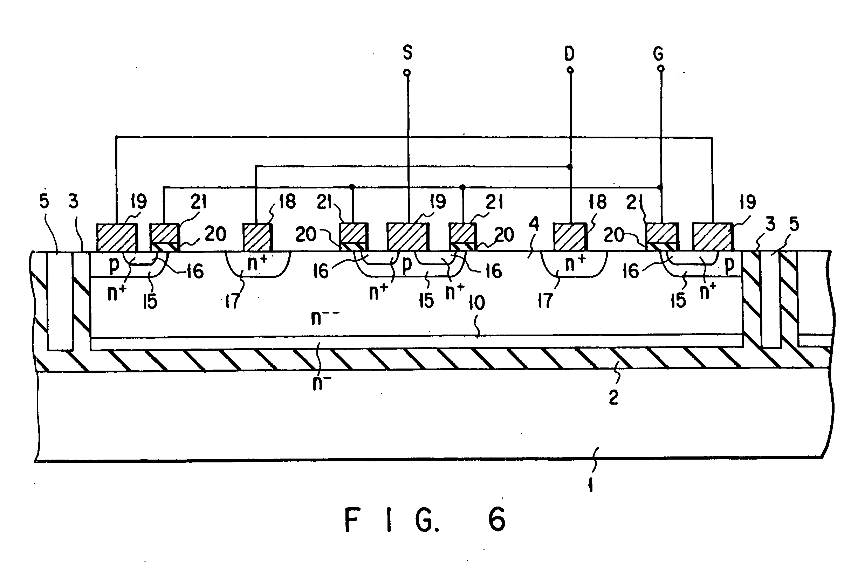

Fig. 6 is an example useful for understanding the present invention comprising a MOSFET based on the structure of Fig. 4. A p type base layer 15 is formed on the surface portion of the high resistance silicon layer 4, and an $n^+$ type source layer 16 is formed in the p type base layer 15. An $n^+$ type drain layer 17 is formed at the position with a predetermined distance from the p type base layer 15. An drain electrode 18 is connected to the $n^+$ type drain layer 17, and a source electrode 19 is connected to the $n^+$ type source layer 16. The source electrode 19 is also connected to the p type base layer 15. In this embodiment, similar to the embodiment of Fig. 5, there is shown the structure in which the source and drain are alternately arranged. The alternate pattern may be the striped shaped pattern or the concentric pattern.

The MOSFET of the above-mentioned example is operated by applying the positive voltage with regard to the source electrode 19 to the drain electrode 18. In an off state that a gate voltage is zero or negative and no channel is formed in the p type base layer 15, the high resistance silicon layer 4 and the buffer layer 10 are depleted at the time when the voltage between the drain and source reaches to a certain value. Thereby, there occurs strong electrical field directing to the lower portion from the $n^+$ type drain layer 17. Similar to the embodiment of Fig. 2, in the above-mentioned embodiment, the thickness of the oxide film 2 is set to be 2 $\mu$m or more, and the buffer layer 10 is depleted, so that the positive space charge is generated. Due to this, the applied voltage is mainly shared by the oxide film 2 and the electrical field in the high resistance silicon layer 4 is weakened, and high breakdown voltage can be obtained.

The buffer layer 10 may be omitted in the above-mentioned example.

In the diode structure of the other examples to be explained later, similar to the above-mentioned embodiment, there is formed an n+ type source layer in formed on the surface portion of a p+ type type layer, and a gate electrode is formed therein, thereby MOSFET can be formed. Moreover, a p+ type layer is formed in an n+ type drain layer, thereby IGBT can be obtained.

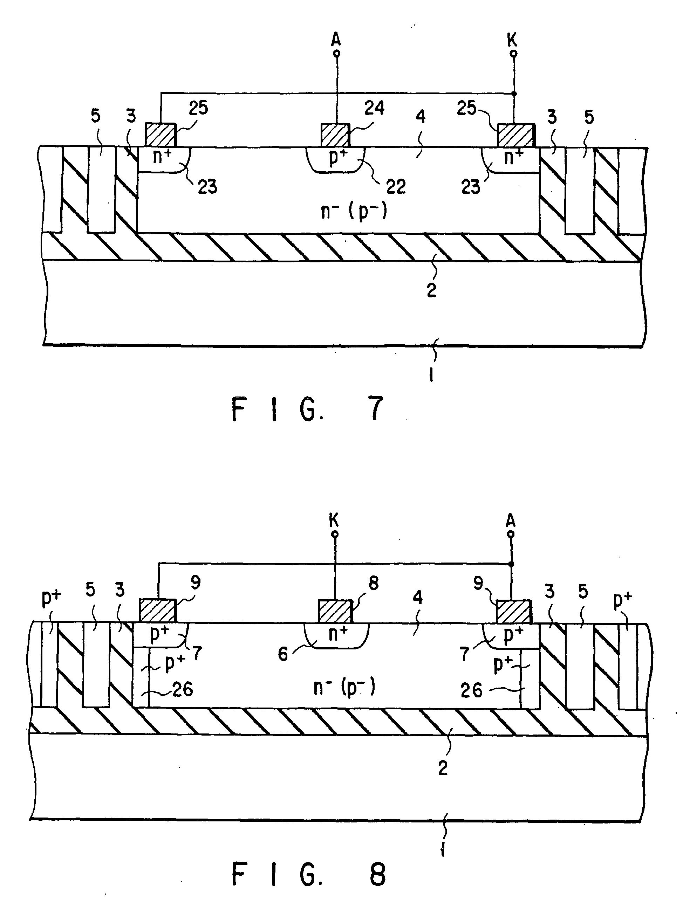

Fig. 7 shows an example useful for understanding the present invention in which the conductivity type of the first low resistance region and that of the second low resistance region are reversed. Unlike the embodiment of Fig. 1, a p+ type layer 22, serving as an anode layer, is formed on the surface of the central surface portion of the high resistance silicon layer 4, and an n+ type layer 23, serving as a cathode layer, is formed in the peripheral surface portion. An anode electrode 24 and a cathode electrode 25 are formed on the p+ type layer 22 and the n+ type layer 23, respectively. The other structure is the same as the embodiment of Fig. 5.

Similar to the example of Fig. 5, in the above-mentioned embodiment, the thickness of the oxide film 2 is set to be 1 μm or more, and the applied voltage is mainly shared by the oxide film 2 at the time of application of reverse bias, thereby high breakdown voltage can be obtained.

Fig. 8 shows an example useful for understanding the present invention in which a p+ type layer 26 having high impurity concentration is formed in the portion contacting the side of the high resistance silicon layer 4, that is, the oxide film 3 based on the structure of Fig. 3. In order to manufacture the diode, the trench for element isolation, which was explained in the manufacturing process of the diode of Fig. 5, is formed, thereafter, impurity may be diffused to the side surface of the trench before the oxide film 3 is formed.

Similar to the above-mentioned examples, the thickness of the oxide film 2 is set to be 1 μm or more, and high breakdown voltage characteristic can be obtained. Moreover, the potential of the p+ type layer 26 on the side of the high resistance silicon layer 4 can be maintained to be the same as that of the p+ type layer 7 at the time of application of reverse bias. Thereby, useless electrical field is prevented from being generated in the boundary surface portion between the p+ type layer 26 and the oxide film 3 having many defects. This also contributes to improvement of high breakdown voltage characteristic.

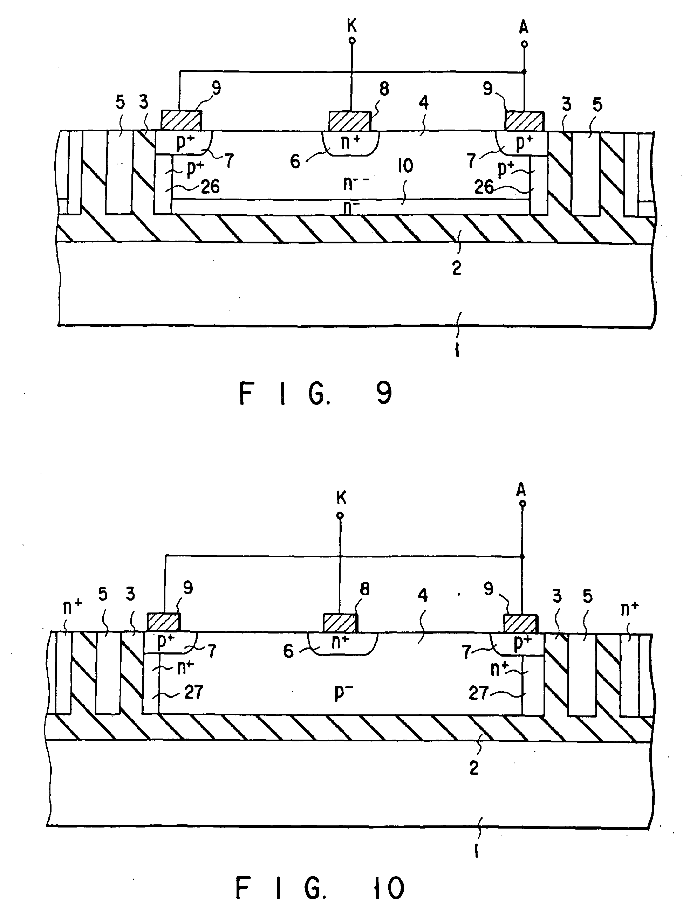

Fig. 9 shows an example useful for understanding the present invention in which, similar to Fig. 4, the n- type buffer layer 10 is formed in the bottom portion of the high resistance silicon layer 4 based on the structure of Fig. 8. Thereby, high breakdown voltage can be more improved.

Fig. 10 shows an embodiment of the present invention in which the high resistance silicon layer 4 is p- type, and an n+ type layer 27 of a conductivity type, which is opposite to the embodiment of Fig. 8, is formed as a low resistance region on the side of the high resistance silicon layer 4. The other structure is the same as the embodiment of Fig. 8.

According to the above-mentioned embodiment, the p+ type layer 7 in the peripheral surface portion contacts the n+ type layer 27, and the portion between the n+ type layer 27 and the n+ type layer 6 formed in the central surface portion are not electrically connected to each other. Due to this, when reverse bias is applied to the diode, no voltage is applied to the pn junction between the p+ type layer 7 and the n+ type layer 27, and no breakdown occurs therein. As a result, in this embodiment, the same high breakdown voltage characteristic as the embodiment of Fig. 3 can be obtained.

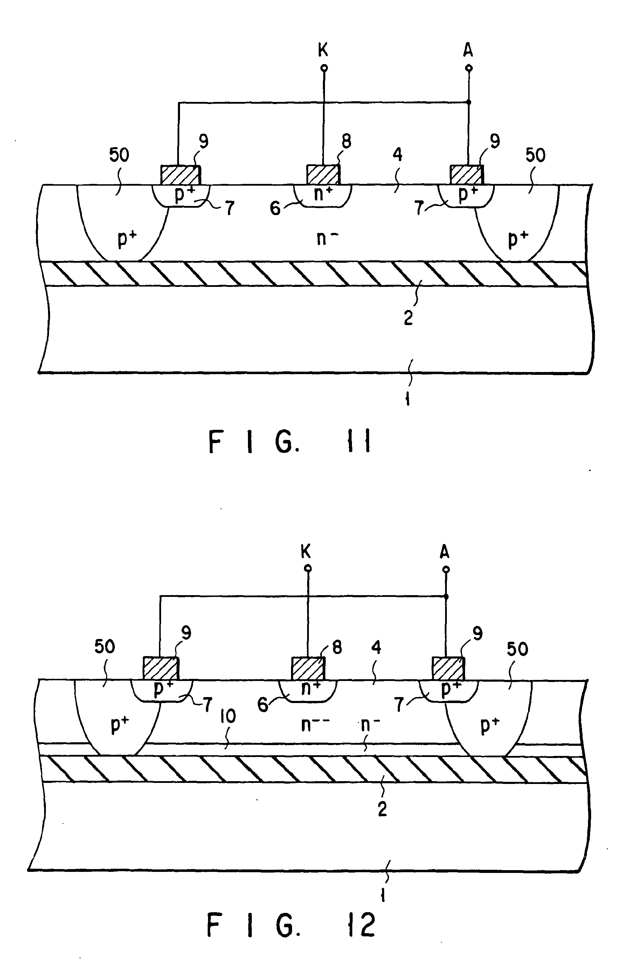

Fig. 11 shows a diode according to an example useful for understanding the present invention the lateral element isolation is performed by the pn junction. The high resistance silicon layer 4 is used as an n- type layer, and the element isolation is performed by that a p+ type layer 50 having a depth reaching to the oxide film 2 is formed by impurity diffusion so as to enclose the element region. The structure of the lateral element isolation is the same as the embodiment of Fig. 3. In the central surface portion of the element region, there is formed the n+ type layer 6 severing as a cathode region. In the peripheral surface portion, there is formed the p+ type layer 7 serving as an anode region.

At the time of application of reverse bias, the n+ type layer 6 becomes high potential, a large potential difference between the n+ type layer 6 and the substrate 1 occurs. However, since the thickness of the oxide film 1 is μm or more, the electrical field in the high resistance silicon layer 4 is controlled to be low. Due to this, the high resistance voltage characteristic can be obtained according to this embodiment.

Fig. 12 shows an example useful for understanding the present invention in which the n- type buffer layer 10 having low impurity concentration is formed in the bottom portion of the high resistance silicon layer 4 based on the structure of Fig. 11. Similar to the example of Fig. 4, the impurity concentration of the n- type buffer layer 10 is suitably set, so that the space charge of the n- type buffer layer 10 weakens the electrical field in the high resistance silicon layer 4 when the buffer layer 10 is depleted by application of reverse bias. Thereby, high breakdown voltage characteristic can be obtained.

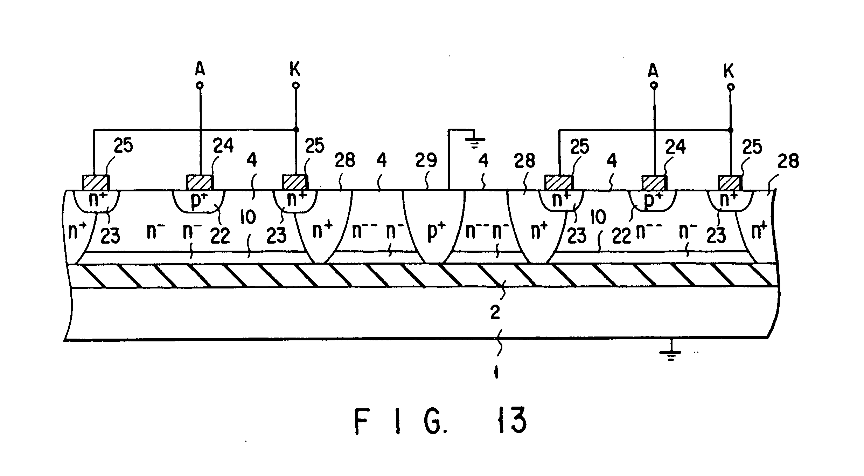

Fig. 13 shows an example useful for understanding the present invention in which the arrangement of the first and second low resistance regions, serving as the cathode region and the anode region, is set to be opposite to that of Fig. 12. A p+ type layer 22, serving as an anode region, is formed in the central surface portion of the high resistance silicon layer 4 which is enclosed with a p+ layer 29, serving as the lateral element isolation region. The n+ type layer 23, serving as a cathode region, is formed on the surface enclosing the p$^+$ type layer 22 and being away from the p$^+$ type layer 29 of the element isolation region with a predetermined distance. An n$^+$ type layer 28, which reaches to the depth of the oxide film 2, is formed so as to partially overlap the n$^+$ type layer 23. The anode electrode 24 is formed in the p$^+$ type layer 2 and the cathode electrode 25 is formed in the n$^+$ type layer 23.

In the above-mentioned example, it is necessary to consider breakdown which is generated between the n$^+$ type layers 23, 28, which become positive high potential at the time of application of reverse bias, and the p$^+$ type layer 29 of the element isolation region, which is normally set to be ground potential. Due to this, a certain degree of distance must be provided between these portions as shown in the drawing. Therefore, this is disadvantageous in view of the area. However, in the vertical direction, similar to the example of Fig. 12, high breakdown voltage can be obtained by the oxide film 2 having a thickness of 1 $\mu$m or more and the buffer layer 10.

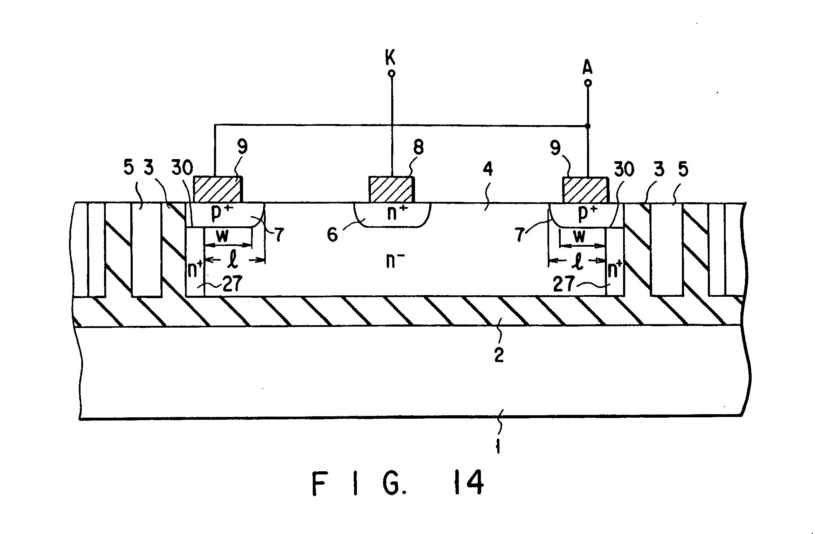

Fig. 14 is an embodiment of the present invention in which the high resistance silicon layer 4 is not p$^-$ layer but n$^-$ type layer based on the embodiment of Fig. 10.

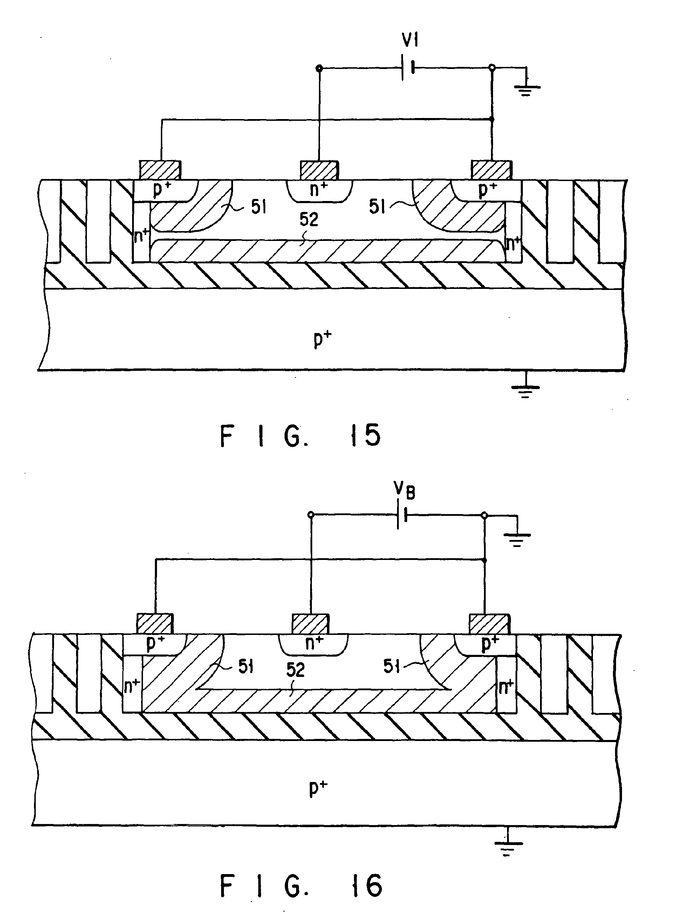

In this embodiment, unlike Fig. 8, since the n$^+$ type layer 6 in the central surface portion and the n$^+$ type layer 27 on the side thereof are not separated, there is a problem in voltage strength of a pn junction 30 between the p$^+$ type layer 7 in the peripheral surface portion and the n$^+$ type layer 27 at the time of application of reverse bias. However, even in this case, if the thickness of the oxide film 2, impurity concentration of the high resistance silicon layer 4, and the thickness thereof are appropriately set, sufficiently high breakdown voltage can be obtained. This will be explained with reference to Figs. 15 and 16.

As shown in Fig. 15, at the time of application of reverse bias, a depletion layer 51 extends downward from the p$^+$ type layer 7, and a depletion layer 52 simultaneously extends upward from the oxide film 2. If reverse bias is made larger, these depletion layers 51 and 52 are connected to each other as shown in Fig. 16. If these layers 51 and 52 are connected, the n$^+$ type layer 27 in the peripheral portion is electrically separated from the n$^+$ type layer 6 in the central surface portion of the element, and is in the floating condition. Even if reverse bias is made much larger, the potential of the n$^+$ type layer 27 does not follow the potential of the n$^+$ type layer 6. Therefore, if an inequality is $V_0 < V_B$ wherein $V_0$ is reverse bias when the depletion layers 51 and 52 are connected and $V_B$ is breakdown voltage of the pn junction, no voltage $V_B$ is applied to the pn junction and breakdown of the pn junction can be prevented.

More specifically, for example, it is assumed that the depth of the p$^+$ type layer 7 is 5 $\mu$m and breakdown voltage of the pn junction 30 is 10 V ($V_B$ = 10 V). Moreover, the width W of the p$^+$ type layer 7 shown in Fig. 14 is about 10 $\mu$m or more. In this case, impurity concentration of the high resistance silicon layer 4 is $1.3 \times 10^{14}/cm^3$ or less, and the thickness of the layer 4 is 20 $\mu$m, and the thickness of the oxide film 2 is 2 $\mu$m. Then, the following equation is satisfied:

$$VO = eC\{2t(\varepsilon s/\varepsilon i)+d-xj\}^2(d-xj)^2/8\varepsilon s\{t(\varepsilon s/\varepsilon i)+d-xj\}^2$$

As a result, reverse bias voltage $V_0$ where these depletion layers are connected as shown in Fig. 16 is 10 V or less, and no breakdown voltage $V_B$ is applied to the pn junction 30.

Moreover, in a case where W is small, for example, a length $\ell$ shown in Fig. 14 is 5 $\mu$m, impurity concentration of the high resistance silicon layer 4 is $1.1 \times 10^{14}/cm^3$ or less, the thickness of the silicon layer 4 is 20 $\mu$m, and the thickness of the oxidation film 2 is 2 $\mu$m, reverse voltage $V_0$ is determined to 10 V or less from a simultaneous equation between $V_0$ and x. Due to this, no breakdown is generated in the pn junction 30.

According to the above-mentioned embodiment, breakdown of the pn junction 30 can be prevented even if the breakdown voltage of the pn junction 30 is low. In other words, if the thickness of the oxide film 2 is 1 $\mu$m or more, the high breakdown voltage characteristic, which is similar to Fig. 1 or Fig. 8, can be obtained.

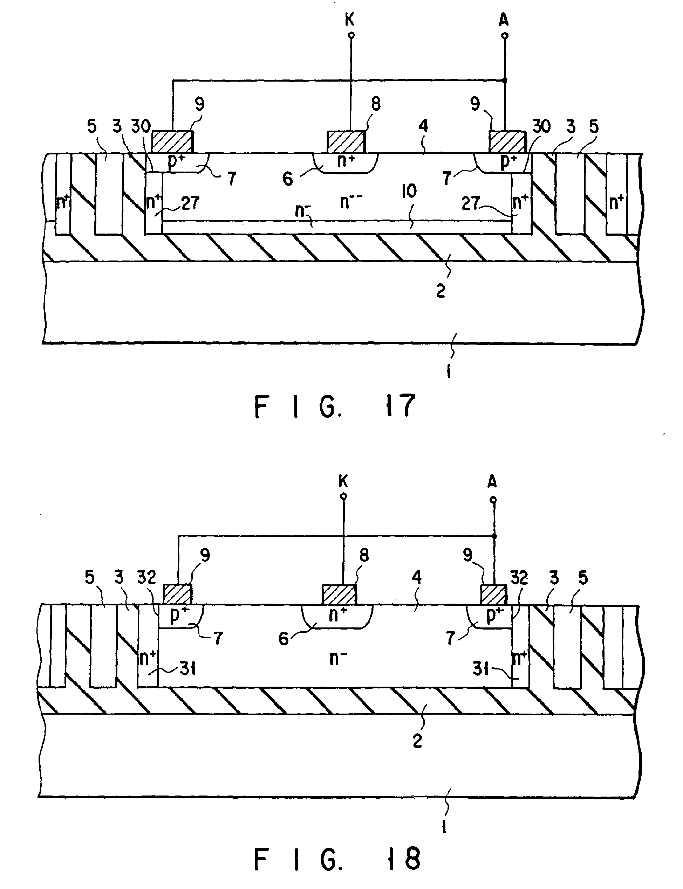

Fig. 17 shows an embodiment of the present invention in which the n$^-$ type buffer layer 10 is formed in the bottom portion of the high resistance silicon layer 4 based on the structure of Fig. 14, thereby improving high breakdown voltage.

Fig. 18 shows an embodiment in which the embodiment of Fig. 14 is slightly modified. In this embodiment, an n$^+$ type layer 31, which is formed in the side portion of the high resistance silicon layer 4 to be in contact with the oxide film 3, is exposed up to the surface, and an pn junction 32 is formed between the n$^+$ type layer 31 and the p$^+$ type layer 7. This structure can be obtained by the same layout of the diffusion layer shown in Fig. 14. In other words, the structure of Fig. 14 can be obtained by setting impurity concentration of the p$^+$ type layer 7 to be higher than that of the n$^+$ type layer 27. The structure of Fig. 18 can be obtained by setting impurity concentration of the n$^+$ type layer 31 to be higher than that of the p$^+$ type layer 7. Therefore, high breakdown voltage, which is similar to the embodiment of Fig. 14, can be obtained in this embodiment.

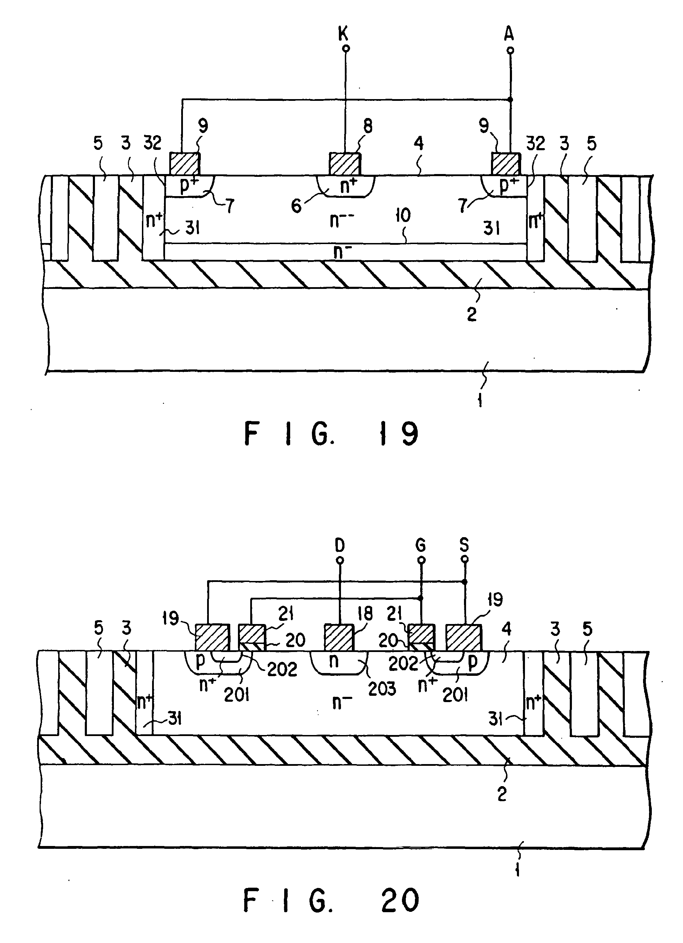

Fig. 19 shows an embodiment of the present invention in which the n$^-$ type buffer layer 10 is formed in the bottom portion of the high resistance silicon layer 4 based on the structure of Fig. 18, thereby improving high breakdown voltage.

Fig. 20 is an MOSFET of an embodiment of the present invention in which the structure of Fig. 18 is modified. A p channel region 201 is formed to be separated from the n$^+$ type region 31 formed in the side portion of the high resistance silicon layer 4. An n$^+$ type region 202, serving as s source, is formed in the p channel region 201. The drain electrode 18 is formed on an n region 203, and the source electrode 19 is formed over the p channel region 201 and the n$^+$ type region 202. On the surface of the p region 201, which is sandwiched between the n$^+$ type region 202 and the n$^-$ type high resistance silicon layer 4, there is formed the gate electrode 21 through the gate insulating film 20.

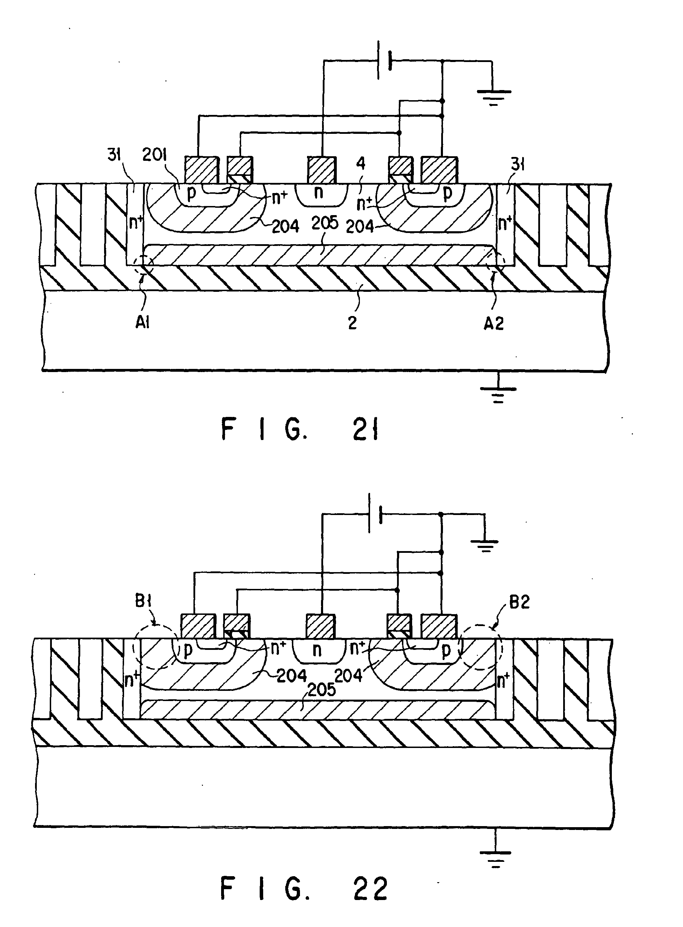

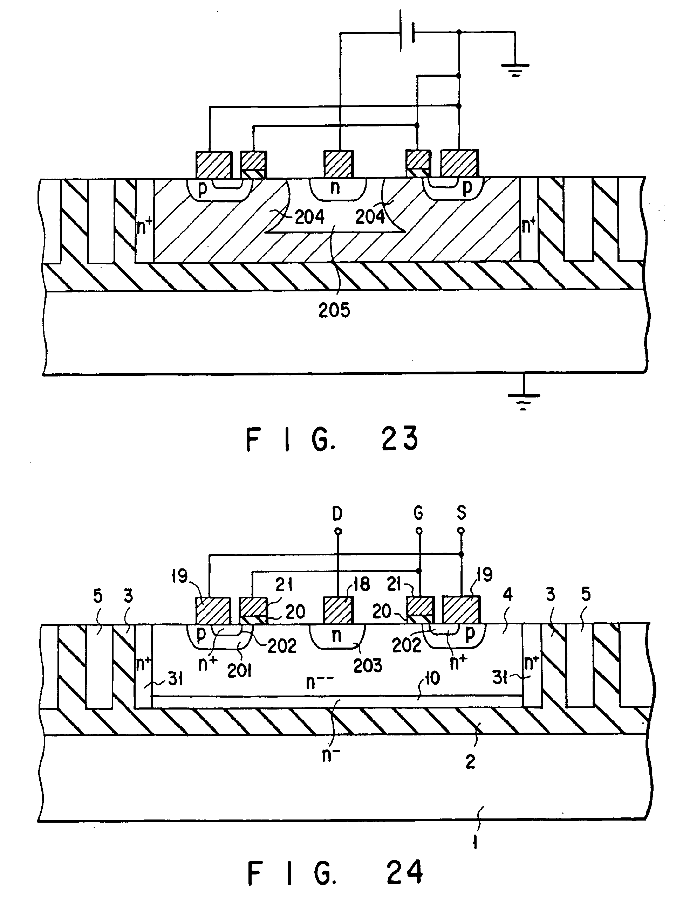

According to the MOSFET of the above embodiment, if voltage is applied between the source and drain in a state that the gate is turned off, depletion layers 204 and 205 spread to the high resistance silicon layer 4 from the surroundings of the p region 201 and the upper surface of the oxide film 2 as shown in Fig. 21. At this time, the n$^+$ type region 31 has the same potential as that of the drain, and the electric field strengthens at portions A$_1$ and A$_2$ enclosed with dotted circles. If applied voltage increases, the depletion layer 204 around the p region 201 reaches to the n$^+$ type layer 31, as shown in Fig. 22. In the n$^+$ type region 31, the depletion layer does not spread. Due to this, if applied voltage increases more than the above value, the electrical field strengthens at portions B$_1$ and B$_2$ enclosed with dotted circles. However, if applied voltage increases more than the above value, the depletion layers 204 and 205 are connected as shown in Fig. 23 before breakdown occurs at portions B$_1$ and B$_2$, and the potential of the n$^+$ type region 31 is separated from that of the drain. Therefore, breakdown does not occur in the vicinity of the n$^+$ type region 31.

For example, similar to the embodiment of Fig. 14, if the thickness of the high resistance silicon layer 4 is 20 $\mu$m, thickness of the oxidation film 2 is 2 $\mu$m, the depth of the p region 201 is 5 $\mu$m, and impurity concentration of high resistance silicon layer 4 is $1.3 \times 10^{14}$/cm$^3$, the depletion layers 204 and 205 are connected at the applied voltage of about 10 V, and the potential difference between the n$^+$ type region 31 and the source does not increase more. If the high voltage is applied and the extending of the depletion layers in the the high resistance silicon layer 4 is finished, strong electrical field in a vertical direction occurs under the n region 203. However, since the oxide film 2 is thick, high breakdown voltage characteristic can be obtained.

Fig. 24 is an embodiment of the present invention in which high breakdown voltage is further improved based on the embodiment of Fig. 20. In this embodiment, the n$^-$ type buffer layer 10 is formed in the bottom surface of the high resistance silicon layer 4.

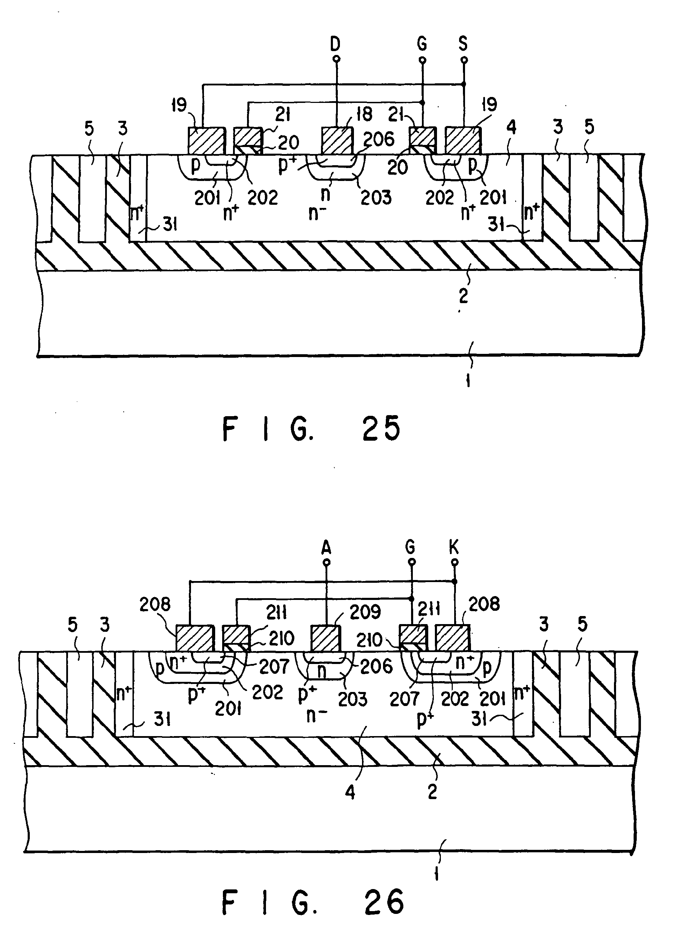

Fig. 25 is an embodiment of IGBT on which M$\theta$SFET of Fig. 20 is based. In this embodiment, a p$^+$ type region 206, serving as a drain region, in the n region 203. The same high breakdown voltage characteristic as that of the embodiment of Fig. 20 can be obtained.

Fig. 26 is an embodiment of MCT in which the embodiment of Fig. 25 is partially modified. In this embodiment, a p$^+$ type region 207 is formed in the n$^+$ type region 202. A cathode layer 208 is formed over the p$^+$ type region 207 and the n$^+$ type region 202, and an anode electrode 209 is formed on the p$^+$ type region 206. Moreover, there is formed a gate electrode 211 through a gate insulating film 210 over the surface of the p region 201, which is sandwiched between the p$^+$ type region 207 and the n$^-$ type high resistance silicon layer 4, and the surface of the n$^+$ type region 202.

MCT of this embodiment is operated by applying voltage between the anode and cathode such that the anode becomes higher potential. A cathode potential is used as a reference, and positive gate voltage is applied and an n channel is formed in the surface portion of the p type region 201, thereby the device is turned on. On the other hand, negative gate voltage is applied and a p channel is formed on the surface portion of the n$^+$ type region 202, thereby the device is turned off. This embodiment also shows that the same high breakdown voltage characteristic as that of the embodiment of Fig. 20 can be obtained.

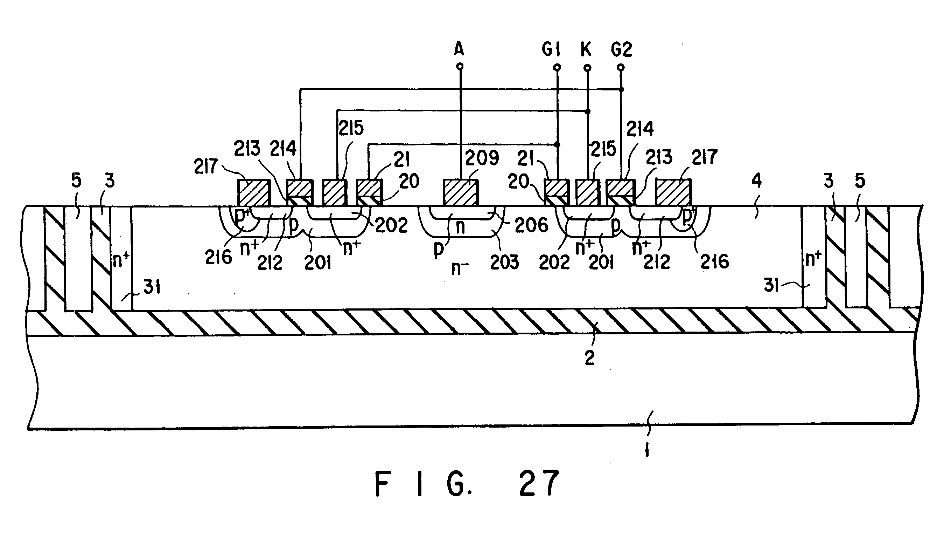

Fig. 27 is an embodiment of another MCT in which the embodiment of Fig. 25 is partially modified.

An n$^+$ type region 212 is formed in the p region 201 to be parallel with the n$^+$ type region 202. There is formed a second gate electrode 214 through a gate insulating film 213 on the surface of the p region 201 which is sandwiched between the n$^+$ type region 202 and the n$^+$ type region 212. A cathode electrode 215 is formed on the n$^+$ type region 202 and the anode electrode 209 is formed on the p$^+$ type region 206.

A p$^+$ type region 216 is formed so as to improve contact of the boundary portion between the surface of the p region 201 and the n$^+$ type region 212, and an electrode 217 is formed over the n$^+$ type region 212 and the p$^+$ type region 216. However, in this case, the electrode 217 may not be always formed.

The device of this embodiment is driven to be turned on by the first gate electrode 21, and turned off by the second gate electrode 214. This embodiment also shows that the same high breakdown voltage characteristic as that of the embodiment of Fig. 20 can be obtained.

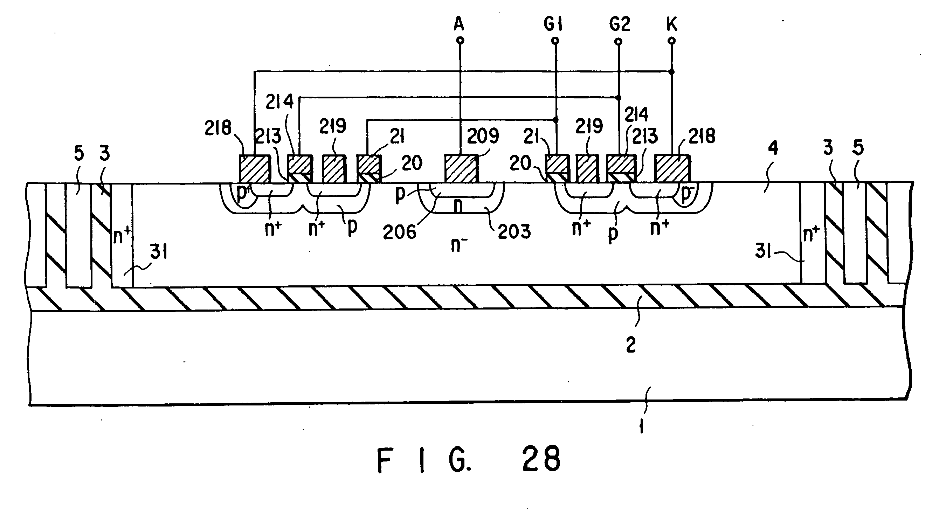

Fig. 28 is an embodiment of EST in which the embodiment of Fig. 27 is partially modified. A cathode electrode 218 is formed over the n$^+$ type region 212 and the p$^+$ type region 216. Also, an electrode 219 is formed on the n$^+$ type region 202. However, in this case, the electrode 219 may not be always formed.

The element of this embodiment is driven to be turned on by the first gate electrode 21 and second gate electrode 214, and turned off by the second gate electrode 214. This embodiment also shows that the same high breakdown voltage characteristic as that of the embodiment of Fig. 20 can be obtained.

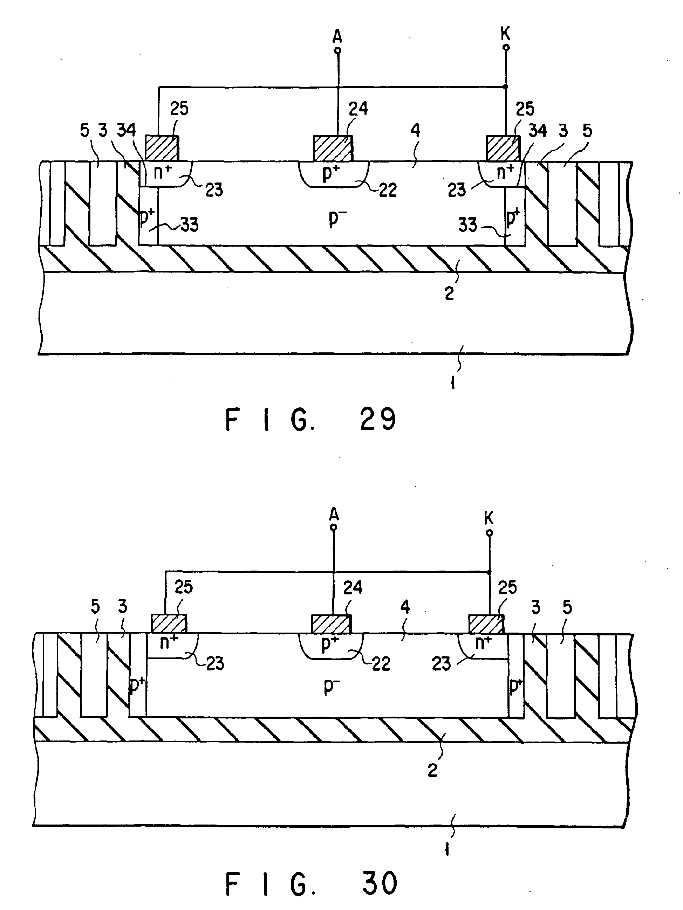

Fig. 29 is an embodiment in which the conductivity type of each portion of the embodiment of Fig. 14 is reversed.

More specifically, the high resistance silicon layer 4 is p- type, and the p+ type layer 22, serving as an anode layer, is formed in the central surface portion. Also, the n+ type layer 23, serving as a cathode layer, is formed in the peripheral surface portion. Moreover, a p+ type layer 33 is formed in the side surface portion, which is in contact with the oxide film 3. A pn junction 34 is formed between the n+ type layer 23 and the p+ type layer 33.

According to this embodiment, breakdown voltage of the pn junction 34 is low. However, similar to the embodiment of Fig. 14, the thickness of the high resistance silicon layer 4 and impurity concentration is suitably set, so that breakdown of the pn junction 34 can be prevented. Therefore, this embodiment also shows that high breakdown voltage characteristic can be obtained

Fig. 30 is an embodiment in which the conductivity type of each portion of the embodiment of Fig. 18 is reversed.

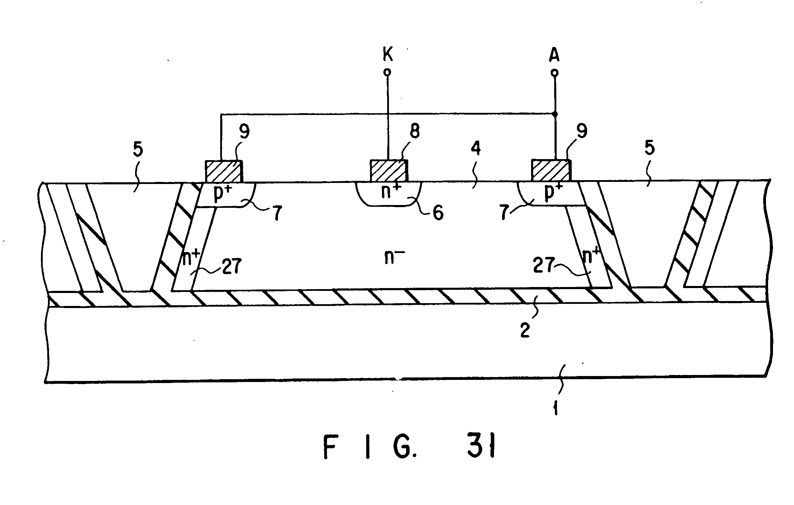

Fig. 31 is an embodiment in which the element isolation region in the lateral direction is formed to be V-grooved in place of the U-shaped trench. The structure of the diffusion layer is the same as that of the embodiment of Fig. 14. However, such a V groove can be formed in each embodiment already explained other than the embodiment of Fig. 31. Such a V groove can be formed by anisotropic etching.

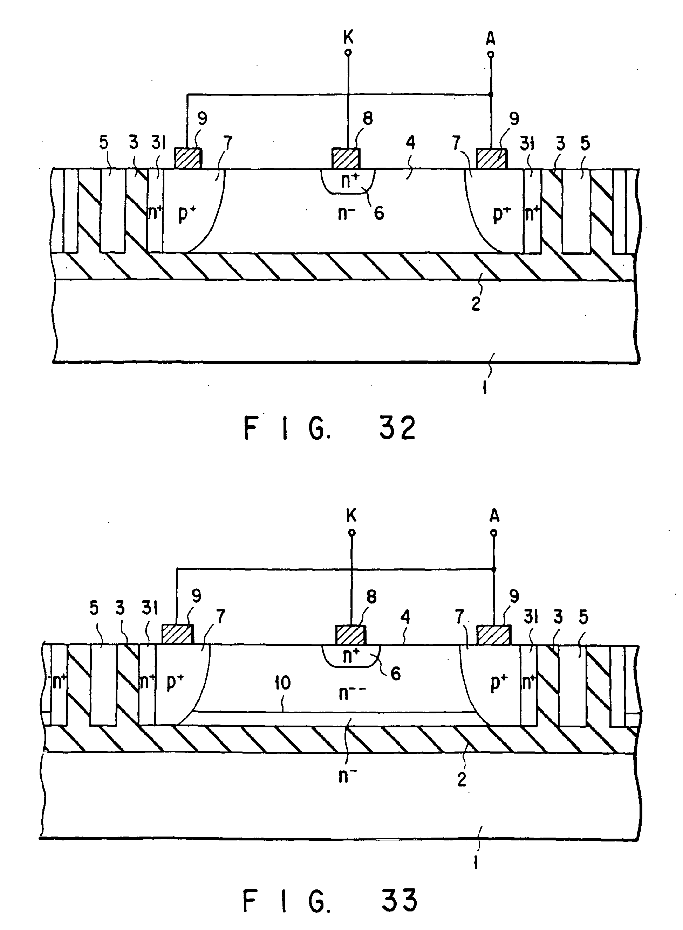

Fig. 32 is an embodiment in which the p+ type layer 7, serving as an anode region of, is formed in the peripheral portion up to the depth reaching to the oxide film 2 of the base based on the structure of Fig. 18.

According to the structure of this embodiment, the n+ type layer 6 formed in the central portion of the device and the n+ type layer 31 formed in the peripheral side portion of the device are electrically separated, and are not connected to each other at the neutral region unlike the embodiment of Fig. 16. Due to this, breakdown voltage of the pn junction between the p+ type layer 7 and the n+ type layer 31 has no influence on the breakdown voltage characteristic of the device, and high breakdown voltage characteristic can be obtained.

Fig. 33 is an embodiment in which the n- type buffer layer 10 is formed in the bottom portion of the high resistance silicon layer 4 based on the embodiment of Fig. 31 so as to obtain further high breakdown voltage.

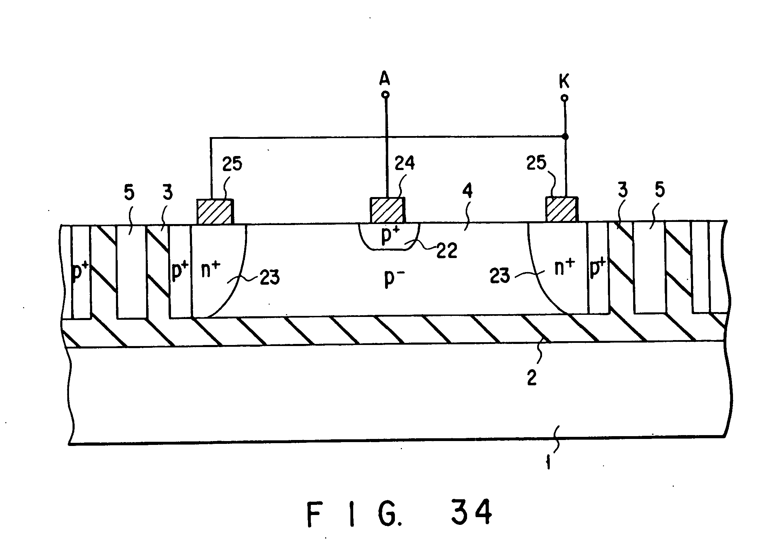

Fig. 34 is an embodiment in which the n+ type layer 23 in the peripheral portion of the embodiment of Fig. 30 is formed up to the depth reaching to the oxide film 2. In other words, this is the embodiment in which the conductivity type of each portion of Fig. 33 is reversed. This embodiment also shows that high breakdown voltage characteristic can be obtained.

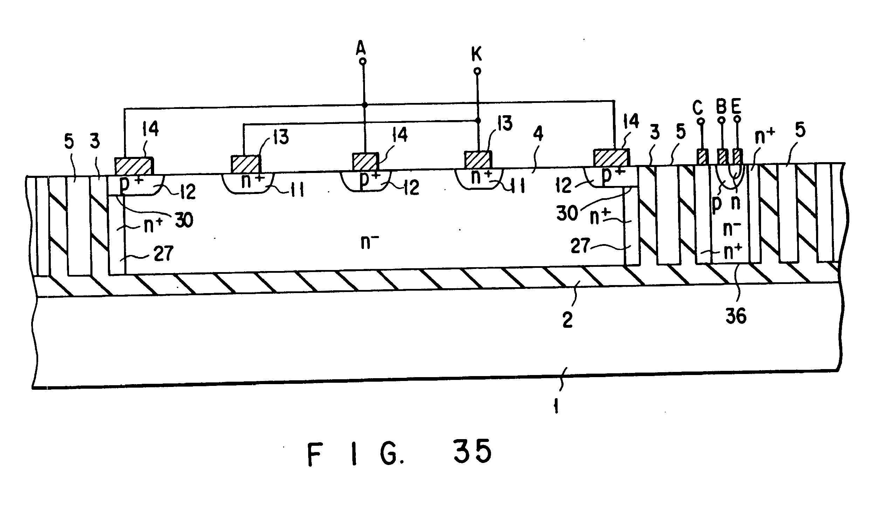

Fig. 35 is an embodiment in which the high breakdown voltage diode and an npn transistor 36 are integrated on the same substrate. The diode to be used is basically the same as that of the embodiment of Fig. 5. Two elements are dielectrically isolated by the trench groove. The npn transistor 36 is structured such that the n+ type layer is formed by impurity diffusion in the portion adjacent to the side surface of the trench in order to reduce the collector resistance. After forming the trench, the n+ type diffusion layer is formed before the oxide film 3 is formed on the side wall. At the same time, the n+ type layer 27 is formed on the side surface of the trench of the diode region. For example, the n+ type layer 27 adjacent to the side surface of the trench, which was explained in the embodiments of Figs. 10 and 14, is formed for the above reason.

In the high breakdown voltage diode, the pn junction having low voltage strength due to the p+ type layer 12 and the n+ type layer 27 is formed in the peripheral surface portion. However, similar to the embodiment of Fig. 14, the thickness of the high resistance silicon layer 4 and impurity concentration thereof are appropriately set, thereby breakdown of the pn junction 30 can be prevented.

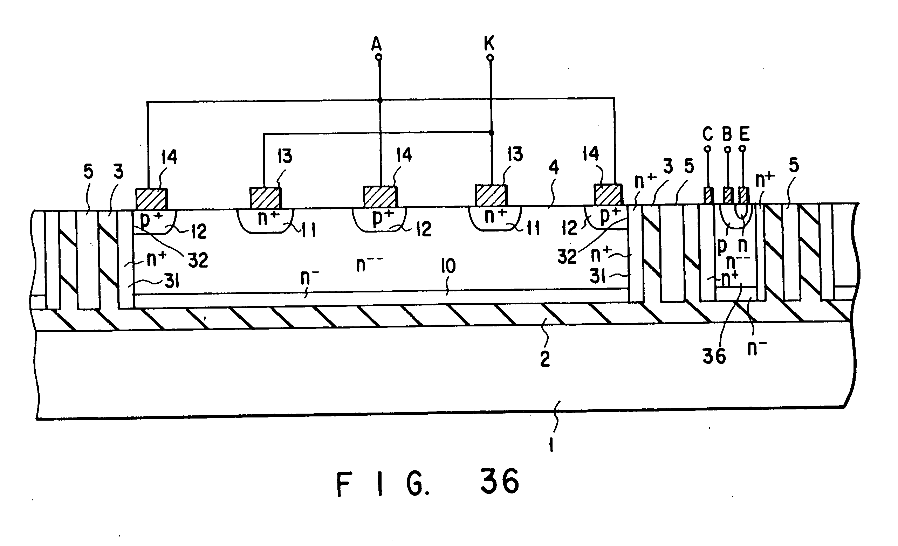

Fig. 36 is an embodiment in which the embodiment of Fig. 35 is partially modified. The pn junction 32 is laterally formed between the n+ type layer 31 and the p+ type layer 7 in a state that the n+ type layer 31 formed in the side portion is exposed up to the surface.

The structure of this portion is the same as that of Fig. 18. Also, in this embodiment, the n+ type layer 31 is cut from the cathode potential by the depletion layer at the time of application of reverse bias, thereby obtaining high breakdown voltage. Moreover, the n- type buffer layer 10 is formed in the bottom portion of the high resistance silicon layer 4, thereby obtaining further high breakdown voltage.

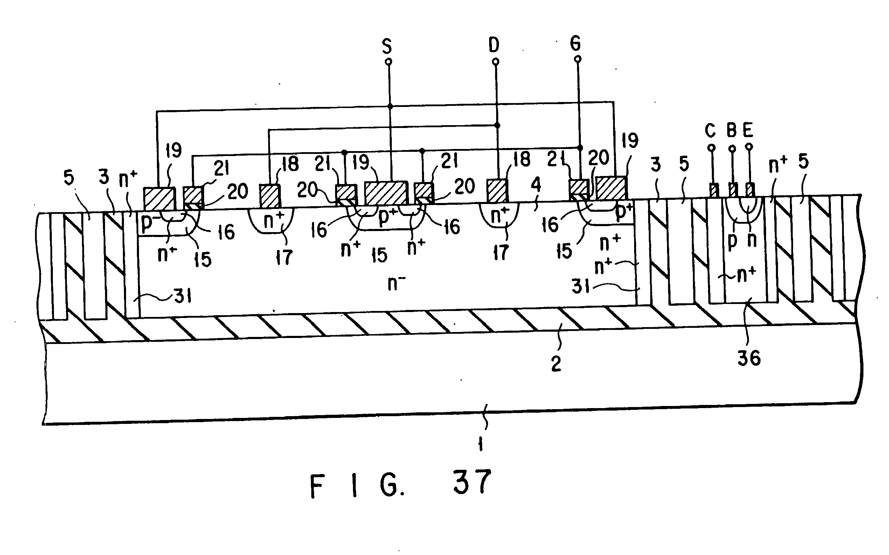

Fig. 37 is an embodiment in which high breakdown voltage MOSFET and the npn transistor 36 are integrated on the same substrate. The structure of the high breakdown voltage MOSFET is the same as that of the embodiment of Fig. 6. For the same reason explained in the embodiment of Fig. 35, the n+ type layer 31 is formed in the side portion of the high breakdown voltage MOSFET.

In the MOSFET of this embodiment, a depletion layer extending downward from the p base layer 15 is connected to a depletion layer extending upward from the oxide film 2 in a state that the gate voltage is zero or negative and reverse bias is applied between the source and drain, the n+ type layer 31 formed in the peripheral portion is isolated from the n+ type layer 17, serving as the drain region, and is in the floating condition. Then, if reverse bias voltage under this state is lower than breakdown voltage of the pn junction between the p type base layer 15 and the n+ type type layer 31, breakdown of the pn junction can be prevented. Due to this, the high breakdown voltage characteristic of MOSFET can be obtained.

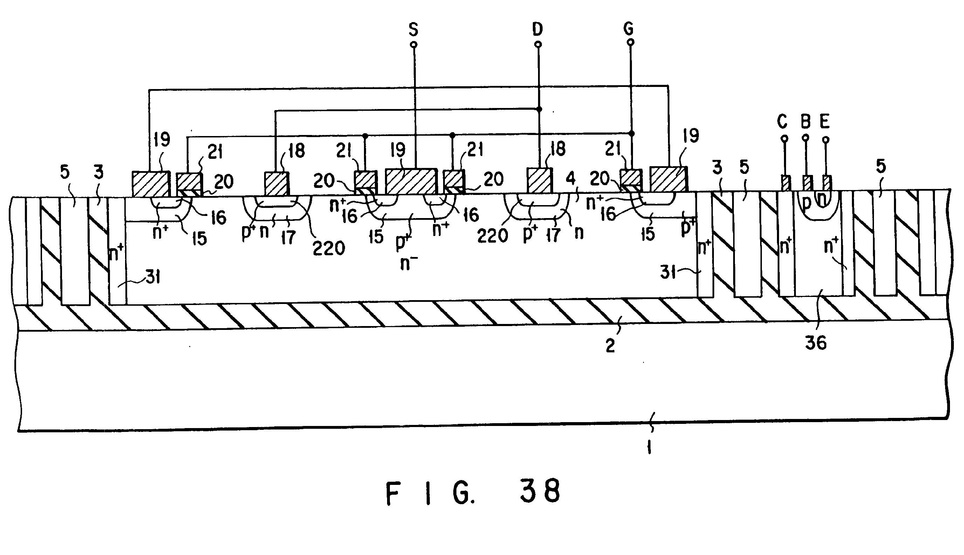

Fig. 38 is an embodiment of IGBT in which MOSFET of Fig. 37 is partially modified. A p+ type drain layer 220 is formed in the n type region 17. The high breakdown voltage characteristic of Fig. 38 is the same as that of Fig. 37.

The source region of IGBT is modified as shown in Figs. 26, 27, and 28, and the modification can be used as MCT or EST.

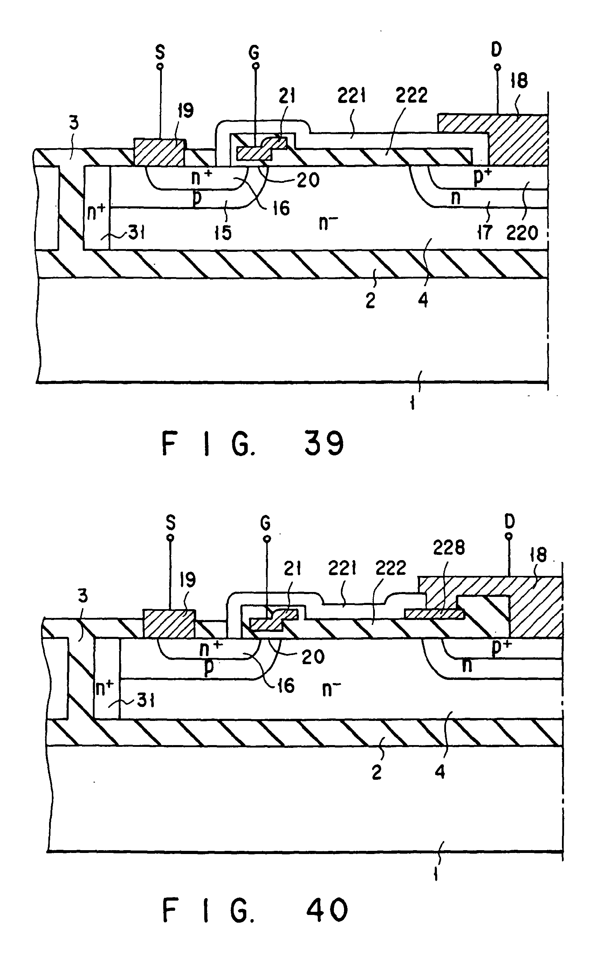

Fig. 39 is a cross sectional view showing a part of an embodiment in which a high resistance film 221 such as SIPOS is formed over the portion between the source and drain of the IGBT of the embodiment of Fig. 38. An insulating film 222 is formed on the surface of the high resistance silicon layer 4 between the p type base layer 15 and the $p^+$ type drain layer 220. On the insulating film 222, there is formed the high resistance film 221 serving as a resistive field plate. One end of the high resistance film 221 is connected to the surface of the $n^+$ type source layer 16, and the other end is connected to the surface of the $p^+$ type drain layer 220 and the drain electrode 18.

According to this embodiment, the high breakdown voltage characteristic of IGBT of the embodiment of Fig. 38 is further improved depending on the effect of the resistive field plate, that is, high resistance film 221. Since one end of the high resistance film 221 is connected to the surface of the $p^+$ type drain layer 220, one end thereof may be separated from the drain electrode 18. Moreover, other end thereof may be connected to the source electrode 19.

Even in each embodiment previously explained, the high resistance film such as SIPOS is formed over the portion between the source and drain or between the anode and cathode, so that the high breakdown voltage characteristic can be improved.

Fig. 40 is an embodiment in which a method of the connection of the high resistance film 221 to the drain side is changed based on the IGBT of the embodiment of Fig. 39. A polycrystalline silicon electrode 223 is formed on the insulating film 222 of the drain, and one of the high resistance film 221 and the drain electrode 18 are connected thereto. The polycrystalline silicon electrode 228 is formed so as to improve the connection between the high resistance film 221 and the drain electrode 18. The formation of the electrode 228 can bring about an effect improving the field plate. The end portion of the high resistance film 221 may be connected to the source electrode 19.

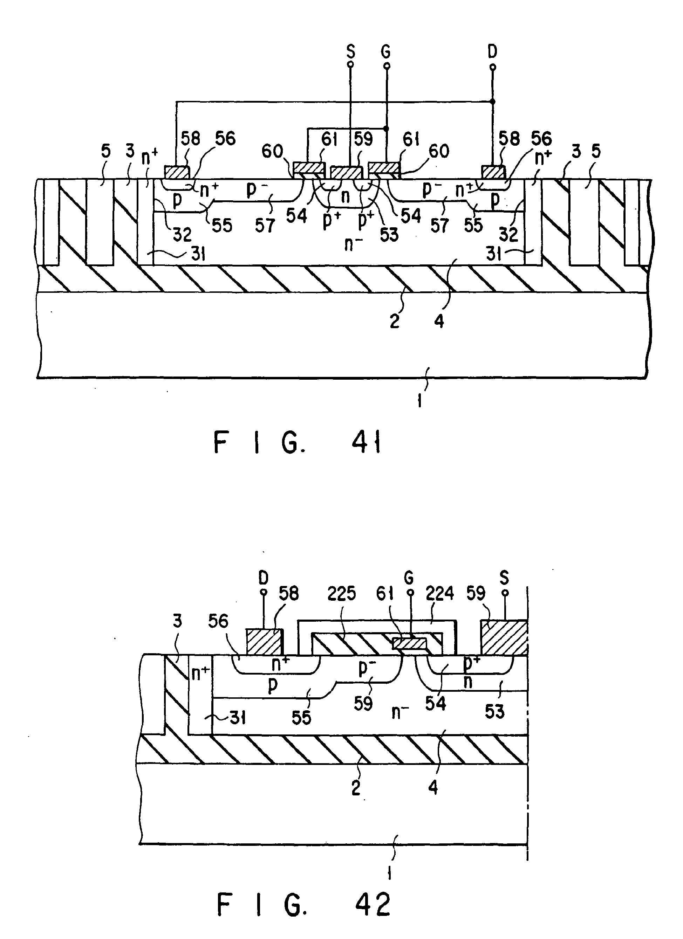

Fig. 41 is an embodiment of a p channel IGBT. An n type base layer 53 is formed in the central surface portion of the high resistance silicon layer 4 which is dielectrically isolated similar to the embodiments explained above. A $p^+$ type source layer 54 is formed in the n type base layer 53. A source electrode 59 is formed so as to be in contact with the $p^+$ type source layer 54 and the n type base layer 53 at the same time. A p type base layer 55 is formed in the peripheral portion of the high resistance silicon layer 4, and a $n^+$ type drain layer 56 is formed therein. A drain electrode 58 is connected to the $n^+$ type drain layer 56. A $p^-$ type reserve layer 57 is formed inside of the p type source layer 54. On the surface portion sandwiched between the $p^+$ type source layer 54 and the $p^-$ type reserve layer 57, there is formed a gate electrode 61 through a gate insulating film 60. Similar to the embodiment of Fig. 37, the $n^+$ type layer 31 is formed in the side portion of the high resistance silicon layer 4.

IGBT of this embodiment is operated by applying the positive voltage to the source electrode 59 with regard to the drain electrode 58. If the gate voltage is zero or positive and is in an off state, the depletion layer extends to the high resistance silicon layer 4 and the $p^-$ type reserve layer 57. If the $n^+$ type layer 31 is isolated from the n type base layer 53 by the depletion layer under the condition of a source-drain voltage, which is less than breakdown voltage of the pn junction between the $n^+$ layer 31 and the p type base layer 55, breakdown of the pn junction is prevented. Due to this, similar to the embodiments previously explained, the high breakdown voltage characteristic can be obtained.

Fig. 42 is an embodiment in which a high resistance film 224 such as SIPOS is formed in the p channel IGBT of the embodiment of the embodiment of Fig. 41, so that the high breakdown voltage characteristic is improved. Similar to the embodiment of Fig. 39, an insulating film 225 is formed on the surface of the high resistance silicon layer 4, and the high resistance film 224, serving a resistive field plate, is formed thereon. One end of the high resistance film 224 is connected to the surface of the $p^+$ type source layer 54, and the other end is connected to the surface of the $n^+$ type drain layer 56. Both ends of the high resistance film 224 may be connected to the drain electrode 58 and the source electrode 59, respectively.

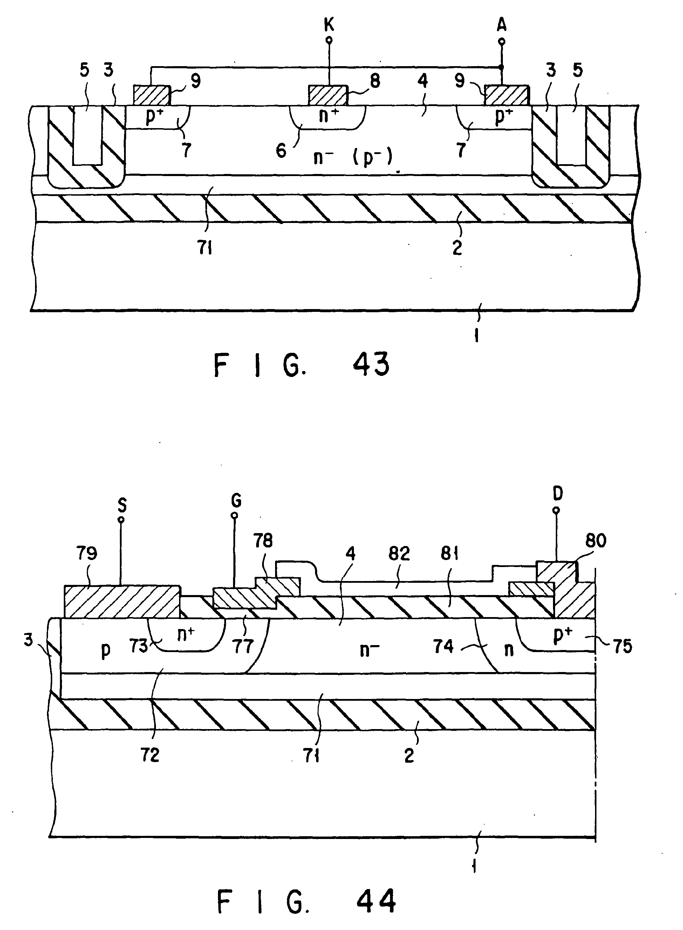

Fig. 43 is a an example useful for understanding the present invention in which a high resistance film 71 such as SIPOS is formed on the bottom portion of the high resistance silicon layer 4, that is, a boundary portion between the high resistance silicon layer 4 and the oxide film 2 based on the embodiment of Fig. 3. The manufacturing process of this diode will be explained as follows.

The high resistance film 71, such as SIPOS is deposited on the high resistance silicon substrate corresponding to the high resistance silicon layer 4, and the oxide film 2 is formed thereon by CVD. The oxide film 2 is directly bonded to the silicon (or polycrystalline silicon) substrate 1. This substrate may be formed by depositing the polycrystalline silicon thick, in place of the above-mentioned bonding. Next, the surface of the high resistance silicon substrate side is polished, thereby obtaining the high resistance silicon layer 4 whose thickness is controlled to a predetermined size. Then, the trench groove reaching to the high resistance film 71 is formed in the element isolation region. The inner surface of the trench groove is oxidized and the oxide film 3 is formed, and the polycrystalline silicon 5 is buried therein. Then, the surface is flattened, thereafter, the $n^+$ type layer 6 and the $p^+$ type layer 7 are formed by impurity diffusion, thereby the diode of this embodiment can be formed.

In the diode of this example, in a case where the substrate 1 is grounded and the cathode 8 is set to be high potential, the $n^-$ type substrate is depleted from the oxide film 2 if there is no high resistance film 71. However, if there is the high resistance film 71, the electrical field of the substrate 1 is shielded by the high resistance film 71. Due to this, there is no influence of the potential of the substrate 1, and breakdown voltage between the cathode 8 and the anode 9 is improved. This is because if the electrical field is applied to the high resistance film 71 such as SIPOS, electrical charge is divided by the level of the bandgap, and electric lines of force is stopped here. Moreover, micro-current flows in the high resistance film 71, and the current determines potential gradient, so that this helps to prohibit the potential out of the external unit. Therefore, even if the oxide film 2 is thinned to be 1 $\mu$m or less, the above-mentioned structure can be useful.

According to the above-mentioned example, influence of the potential of the base substrate 1 on the high resistance silicon layer 4 is shielded, and the high breakdown voltage characteristic can be effectively obtained.

Fig. 44 is an example useful for understanding the present invention of an channel IGBT using the same structure as that of Fig. 43.

Similar to Fig. 43, high resistance film 71 is formed on the bottom portion of the high resistance silicon layer 4. The thickness of the high resistance silicon layer 4 is controlled to be 1 $\mu$m to 5 $\mu$m. In the central portion of the high resistance silicon layer 4 in which the element-isolation is made, there is formed an n type base layer 74 reaching to the depth of the high resistance film 71. The n type base layer 74 is connected to the high resistance film 71. A $p^+$ layer drain layer 75 is formed in the n type base layer 74. In the peripheral portion of the high resistance silicon layer 4, there is also formed the n type base layer 74 reaching to the depth of the high resistance film 71. The n type base layer 74 is electrically connected to the high resistance film 71. An $n^+$ type source layer 73 is formed in the p type base layer 72.

A source electrode 79 is formed to be in contact with the source layer 73 and the p type base layer 72 at the same time. In the region sandwiched between the $n^+$ type source layer 73 and the high resistance silicon layer 4, there is formed an gate electrode 78 through a gate insulating film 77. An insulating film 81 is formed on the surface of the high resistance silicon layer 4 between the n type base layer 74 and the p type base layer 72. A high resistance film 82, serving as a resistive field plate, is formed on the insulating film 81. One end of the high resistance film 82 is connected to the gate electrode 78, and the other end is connected to the drain electrode 80.

IGBT of this example is operated by applying the positive voltage to the drain electrode 80 against the source electrode 79. If the gate voltage is zero or negative, the element is in an off-state. If voltage is applied between the source and drain in the off-state, the depletion layer extends to the high resistance silicon layer 4. At this time, the high breakdown voltage characteristic can be improved by the function of the voltage sharing due to the oxide film 2 having a thickness of 1 $\mu$m or more and relaxation of electrical field, shield effect to the substrate potential due to the high resistance film 71, and field plate effect of the upper high resistance film 82. It is noted that thickness of the oxide film 2 may be set to 1 $\mu$m or less since there is shield effect in the high resistance film 71.

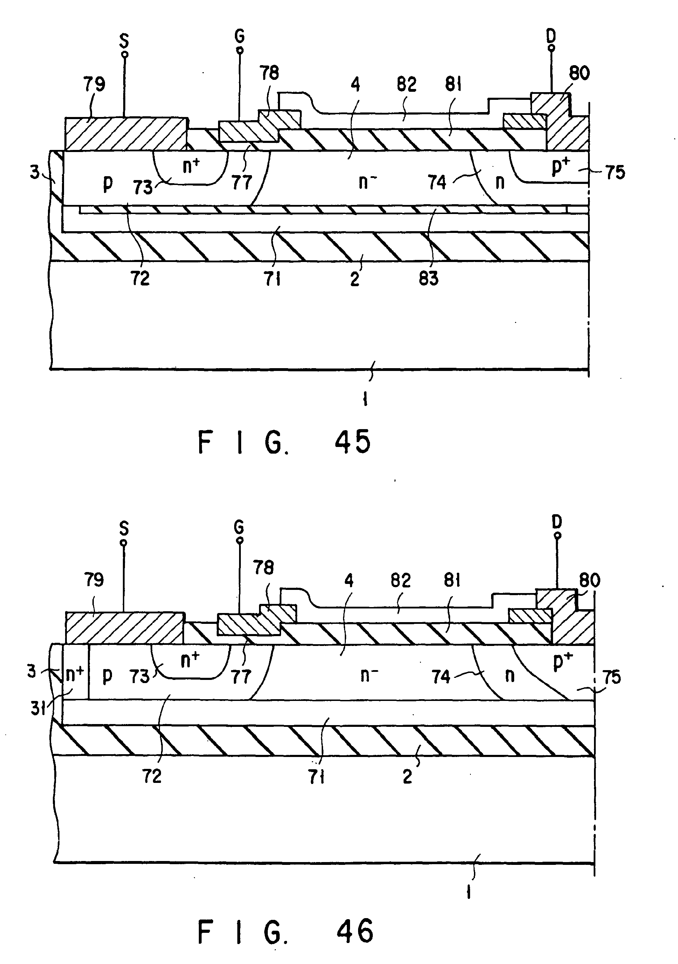

Fig. 45 is an example useful for understanding the present invention of IGBT in which the example of Fig. 44 is modified. According to this example, an oxide film 83 is formed between the high resistance silicon layer 4 and the high resistance film 71. The oxide film 83 has an opening under the source region and the drain region. Due to this, one end of the high resistance film 71 is set to be source potential through the p type base layer 72, and the other end is set to be drain potential through the n type base layer 74. Since the portion therebetween is insulated from the high resistance silicon layer 4 by the oxide film 83, potential gradient generated in the high resistance film 71 is more equalized than that of Fig. 44.

In order to prepare such IGBT, the oxide film 83 is formed on the surface of the substrate, serving as the high resistance silicon layer 4, an opening for contact is formed, and the high resistance film 71 such as SIPOS is deposited thereon. An oxide film is formed on either the surface of the high resistance film 71 or that of the base substrate 1 or both surfaces by CVD or thermal oxidation, and these substrates are directly bonded. The base substrate may be formed by depositing polycrystalline silicon in place of the bonding. The method of performing the element isolation due to the trench groove thereafter is the same as that of Fig. 43. Moreover, similar to the embodiment of Fig. 44, since the thickness of the high resistance silicon layer is set to be about 1 $\mu$m to 5 $\mu$m, the p type base layer 72 and the n type base layer 74 reach to the high resistance film 71.

According to this example, the high resistance film 71 of the bottom portion of the high resistance silicon layer 4 shields influence of the potential of the substrate. As the same time, similar to the upper high resistance film 8, the high resistance film 71 serves as a field plate. Due to this, this example also shows that the sufficiently high breakdown voltage characteristic can be obtained.

Fig. 46 is an embodiment of IGBT in which the embodiment of Fig. 44 is modified. The drain layer 75 reaches up to the high resistance film 71. Also, similar to Fig. 32, the $n^+$ type layer 31 is formed in the side portion of the high resistance silicon layer 4. Due to this, the high resistance voltage characteristic can be also obtained according to this embodiment.

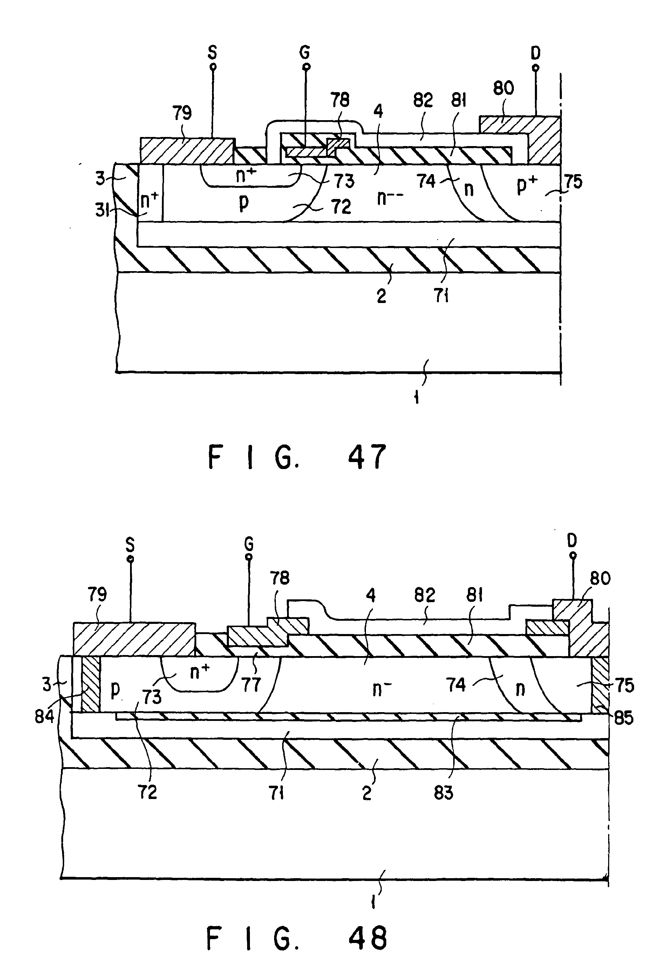

Fig. 47 is an embodiment of IGBT in which the connection method of the high resistance film 82 is changed based on the embodiment of Fig. 46 One of the high resistance film 82 is connected to the surface of the $n^+$ type source layer 73, and the other end is connected to the $p^+$ type drain layer 75 and the drain electrode 80. On the drain side, the high resistance film 82 and the drain electrode 18 may be separated from each other. Moreover, the source side end of the high resistance film 82 may be connected to the source electrode 19.

Fig. 48 an example useful for understanding the present invention of IGBT in which the example of Fig. 45 is modified. The drain layer 75 is formed to reach the high resistance film 71. Conductive members 84 and 85 such as metallic wires are connected to the source electrode 79, the drain electrode 80 and the high resistance film 71, thereby further high breakdown voltage can be obtained.

The formation of the high resistance film such as SIPOS in the bottom portion of the element as explained in the embodiments and examples of Figs. 43 to 48 is useful to the embodiments and examples previously shown.

Since the high resistance silicon layer 4 is thin in the embodiments and examples of Figs. 44 to 48, the oxide film reaching to the high resistance film 71 from the surface can be easily formed. Due to this, the element isolation can be performed by an LOCOS method in place of the formation of the element isolation groove.

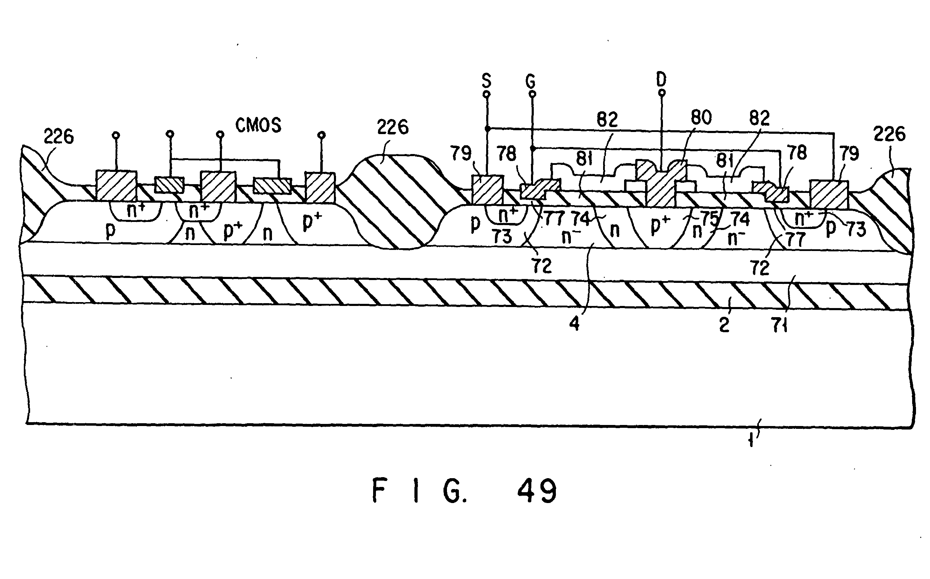

Fig. 49 is an example useful for understanding the present invention in which the element isolation is performed by the LOCOS method. There is locally formed an oxide film 226 reaching to the high resistance film 71 from the surface of the high resistance silicon layer 4, thereby the element isolation in the lateral direction is performed. According to this embodiment, IGBT shown in Fig. 46 is formed in one of the regions separated by the oxide film 226, and a CMOS circuit, serving as a logic circuit, is formed in the other region. It is noted that the $n^+$ type layer 31 of Fig. 46 is formed on the side surface of the trench and is not shown in Fig. 49. An $n^+$ type layer corresponding to the $n^+$ type layer 31 may be formed under the source electrode 79 of IGBT to reach to the high resistance film 71. Thereby, the electrical connection between the source electrode 79 and the high resistance film 71 can be much improved.

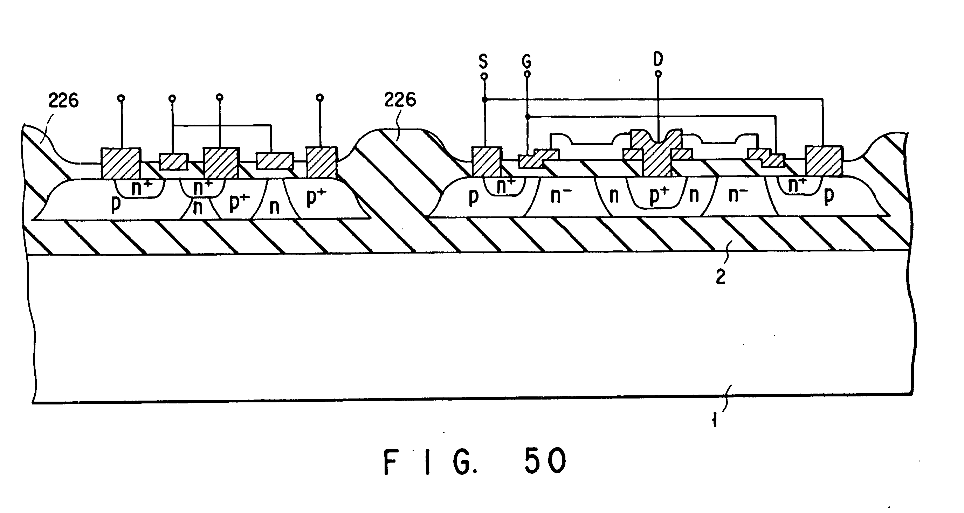

Fig. 50 is an example useful for understanding the present invention in which no high resistance film 7 of Fig. 49 is formed. In place of the high resistance film 71, the thickness of the oxide film 2 is set to be 2 $\mu$ or more, thereby the high breakdown voltage characteristic can be obtained.

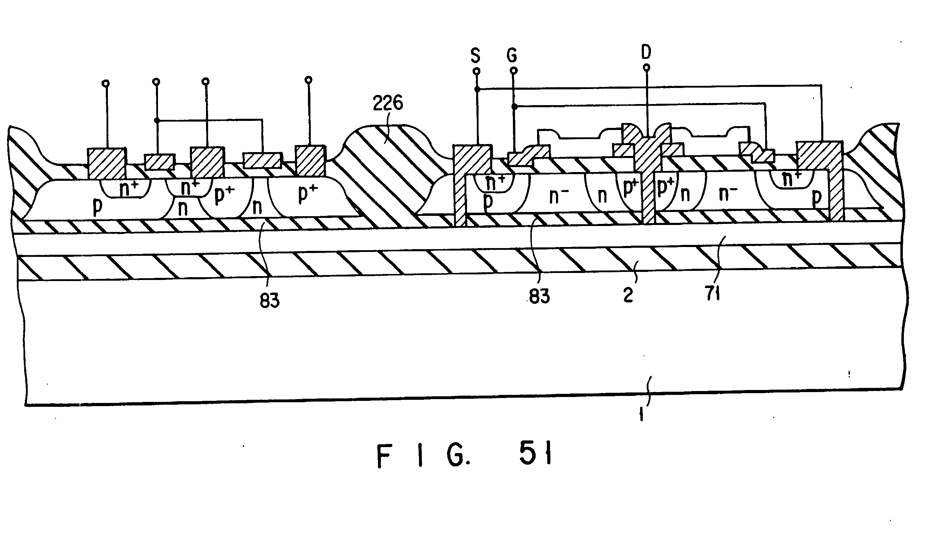

Fig. 51 an example useful for understanding the present invention in which the element isolation by the LOCOS method is applied to the example of Fig. 48. The LOCOS oxide film 226 is formed so as to reach the oxide film 83 from the surface of the high resistance silicon layer 4.

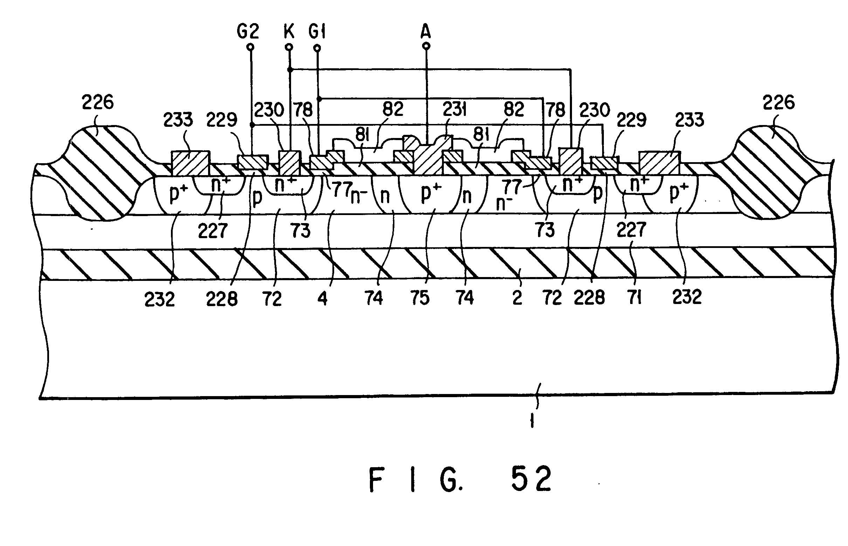

Fig. 52 an example useful for understanding the present invention in which MCT is formed in the region separated by the LOCOS method. The MCT is formed by partially modifying IGBT of the example of Fig. 49. An $n^+$ type region 227 is formed in the p type region 72 to be parallel to the $n^+$ type region 73. On the surface portion of the p type region 72 sandwiched between the $n^+$ region 73 and the $n^+$ region 227, there is formed a second gate electrode 229 through the gate insulating film 228. A cathode electrode 230 is formed on the $n^+$ type region 73, and an anode electrode 231 is formed on the $p^+$ type region 75. A $p^+$ type region 232 is formed adjacent to the $n^+$ type region 227 so as to improve contact with the p type region. An electrode 233 is formed over the $n^+$ type region 227 and the $p^+$ region 232. It is noted that the electrode 233 may not be formed in this case.

The element of this example is driven to be on by the first gate electrode 78, and off by the second gate electrode 229.

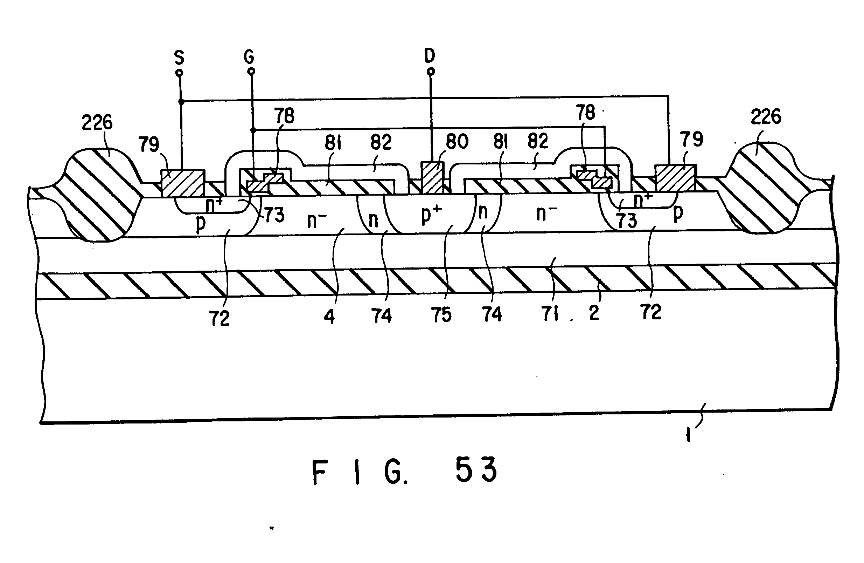

Fig. 53 is an example useful for understanding the present invention in which the IGBT of the example of Fig. 49 is partially modified. Both ends of the high resistance film 82 are connected to the surface of the $n^+$ type source layer 73 and the surface of the $p^+$ type drain layer 75, respectively. The source side end may be connected to the source electrode 79.

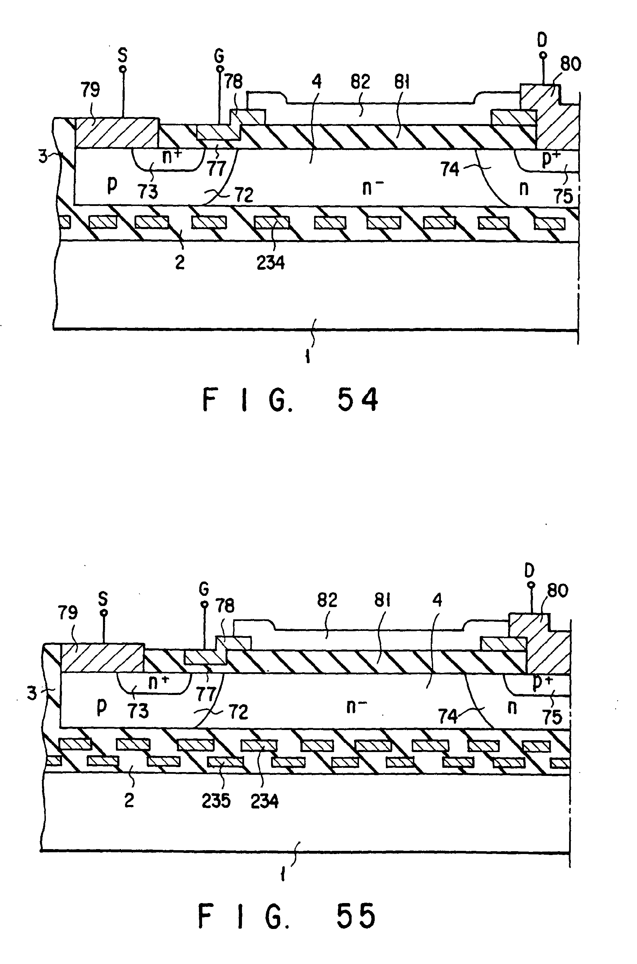

Fig. 54 is an example useful for understanding the present invention in which the IGBT of the examples of Fig. 49 is partially modified. According to this example, no high resistance film 71 of Fig. 44 is formed. In place of the high resistance film 71, a polycrystalline silicon film 234 is buried in the oxide film 2. The polycrystalline silicon film 234 is set to have a predetermined resistivity by an ion implantation, and patterned in a strip form or a mesh form with a suitable space. The polycrystalline silicon film 234 serves as a field plate, and the element having the high voltage characteristic can be realized.

Fig. 55 is an example useful for understanding the present invention in which a polycrystalline silicon film 235, which is similar to the polycrystalline silicon film 234, under the polycrystalline silicon film 234 based on the element of the examples of Fig. 54. These two-layered polycrystalline silicon layers 234 and 235 are alternately arranged such that the spaces thereof do not correspond to each other. More specifically, these films are patterned such that the polycrystalline silicon film 235 is surely arranged under the space of the polycrystalline silicon film 234. By such an arrangement of the polycrystalline silicon films, influence of the potential of the substrate 1 on the element is effectively shielded.

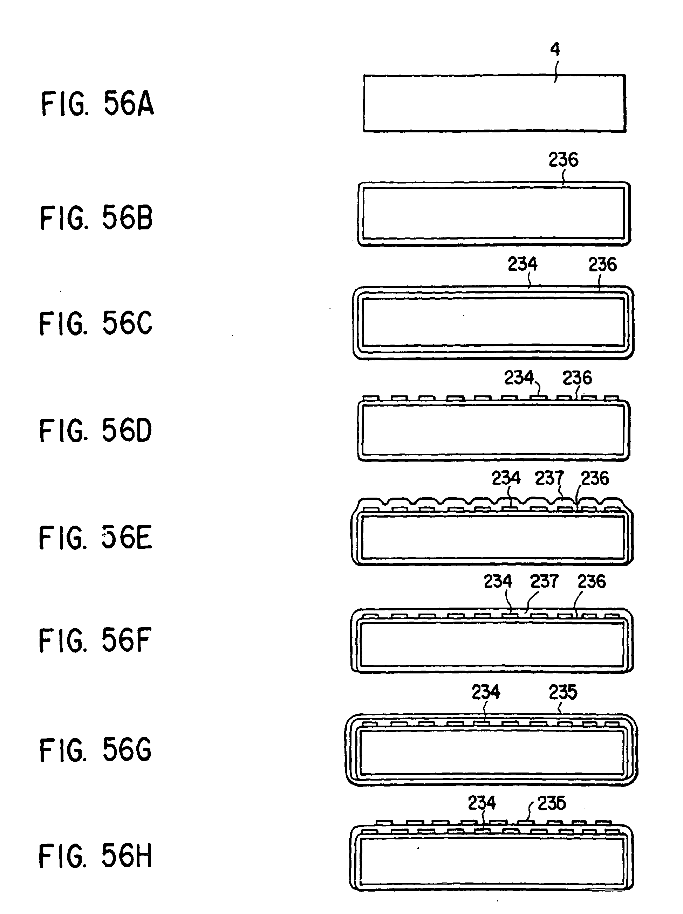

Figs. 56A to 56P are views showing the manufacturing process of the dielectic isolation element substrate of Fig. 55.

A silicon substrate of Fig. 56A is used as the high resistance silicon layer 4 which is the element region. As shown in Fig. 56B, an oxide film 236 is formed on the silicon substrate by thermal oxidation. Then, as shown in Fig. 56C, a polycrystalline silicon film 236 is formed thereon. Thereafter, an impurity is doped by the ion plantation, and as a result, a predetermined resistivity is applied to the polycrystalline silicon film 236. Then, as shown in Fig. 56D, the polycrystalline silicon film 234 is formed in a stripe pattern or a mesh pattern to have a predetermined space. Thereafter, as shown in Fig. 56E, the upper portion of the polycrystalline silicon film 234 and the space portion are completely buried with an oxide film 237 by CVD.

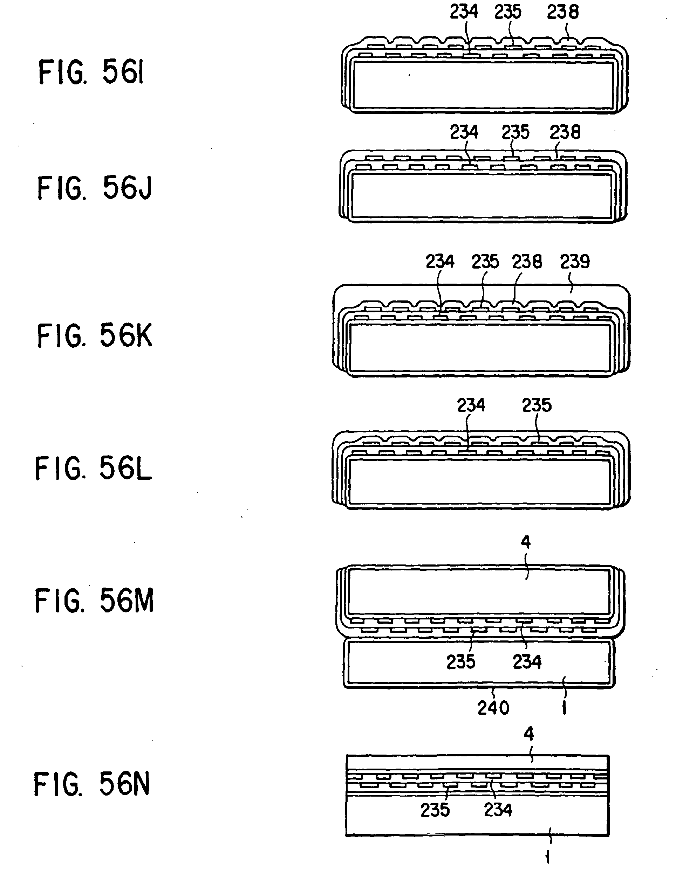

Then, as shown in Fig. 56F, the surface of the film is polished and flattened, and the polycrystalline silicon film 235 is again deposited thereon, and patterned as shown in Fig. 56H. Thereafter, as shown in Fig. 56I, a CVD oxide film 238 is deposited thereon, and the surface thereof is polished and flattened as shown in Fig. 56J. The process shown in Figs. 56G to 56J is the repetition of the process shown in Figs. 56C to 56F.

In place of the process in which the deposited film of Fig. 56I is polished as shown in Fig. 56J, it is possible to perform a process in which a thicker polycrystalline silicon film 239 is deposited, and polished as shown in Fig. 56K, so that the flattened substrate can be obtained as shown in Fig. 56L.

Other than the substrate of Fig. 56J (or Fig. 56L) having the oxide film formed by burying two-layered polycrystalline silicon films, the silicon substrate having a thermal oxide film 240 is prepared. Then, as shown in Fig. 56M, the silicon substrate is directly bonded to the two-layered polycrystalline silicon films, thereby obtaining the integrated substrate. Then, as shown in Fig. 56N, the integrated substrate is polished such that the high resistance silicon layer 4 has a predetermined thickness, so that the device substrate is completed. In this case, an incomplete bonded portion which is the peripheral portion of the device substrate is cut. The thermal oxide film 240 of the substrate 1 of Fig. 56M is not always formed.

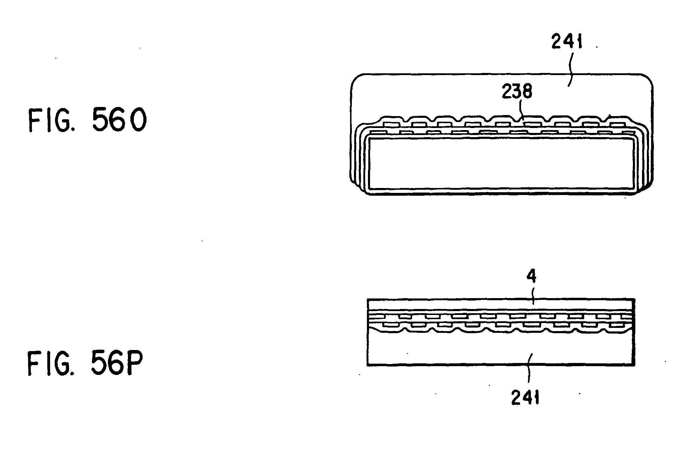

In the above example, the manufacturing process of the dielectric isolation element using two substrates has been explained. However, the device substrate can be obtained using one substrate. For example, after the substrate is formed as shown in Fig. 56I, a polycrystalline silicon 241 is deposited thick as shown in Fig. 56O, and the polycrystalline silicon 241 is used as a base substrate as it is. Then, as shown in Fig. 56P, the high resistance silicon layer 4 is polished to have a predetermined thickness, thereby obtaining the same device substrate.

In the above element substrate forming process, if the deposition step of a polycrystalline silicon film 235, and the patterning step are omitted, the device substrate shown in the embodiment of Fig. 55 can be obtained.

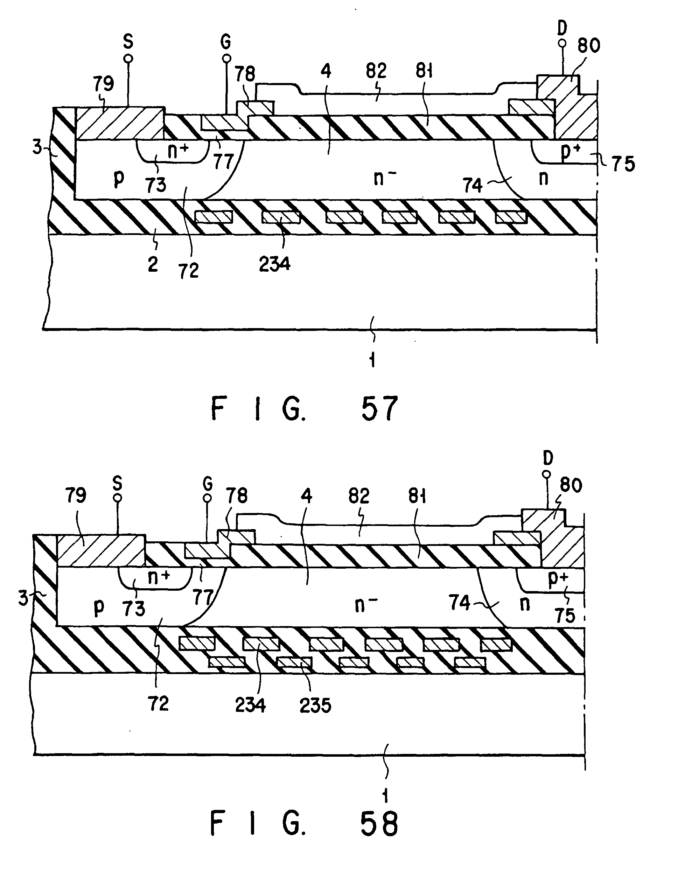

Fig. 57 is an example useful for understanding the present invention in which the example of Fig. 55 is partially modified. In this example, the polycrystalline silicon film 234 is formed only under a drift layer between the p type base layer 72 and the n type base layer 74.

Fig. 58 is an example useful for understanding the present invention in which the example of Fig. 55 is partially modified. In this example, the polycrystalline silicon films 234 and 235 are formed only under the drift layer between the p type base layer 72 and the n type base layer 74.

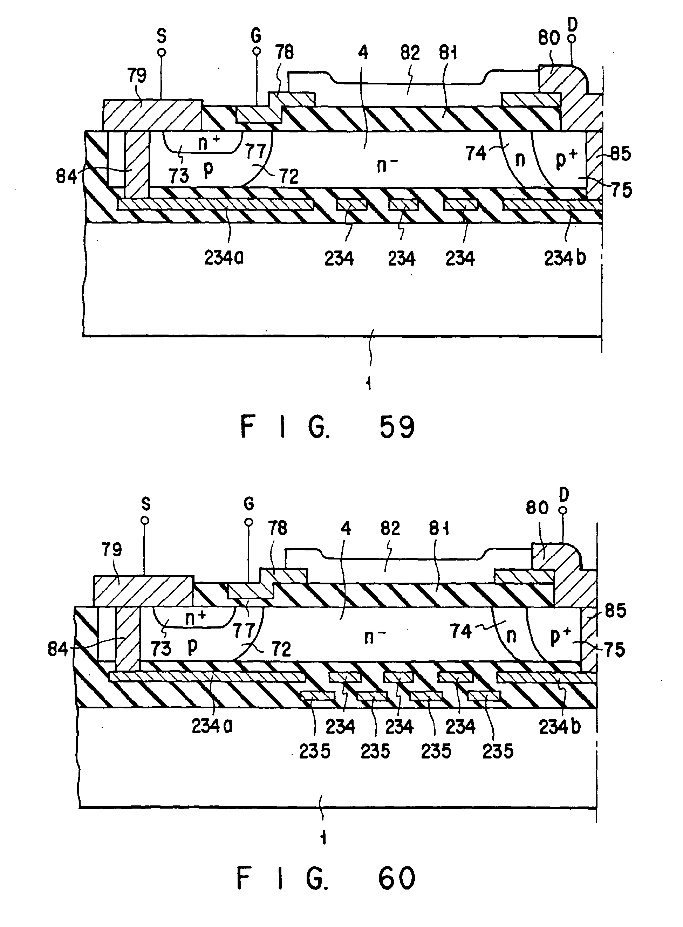

Fig. 59 is an example useful for understanding the present invention in which the example of Fig. 54 is partially modified. Similar to the example of Fig. 48, the conductive members 84 and 85 such as mental are buried under the source electrode 79 and the drain electrode 80, thereby the polycrystalline silicon 234 formed in the bottom portion of the device is connected to the source electrode 79 and the drain electrode 80. Each of portions 234a and 234b to be connected to each of conductive members 84 and 85 is designed to have a suitable length for a field plate.

Fig. 60 is an example useful for understanding the present invention in which the polycrystalline silicon 235 is formed under the polycrystalline silicon 234 as shown in the example of Fig. 55 and influence of the substrate potential is effectively shielded based on the example of Fig. 59.

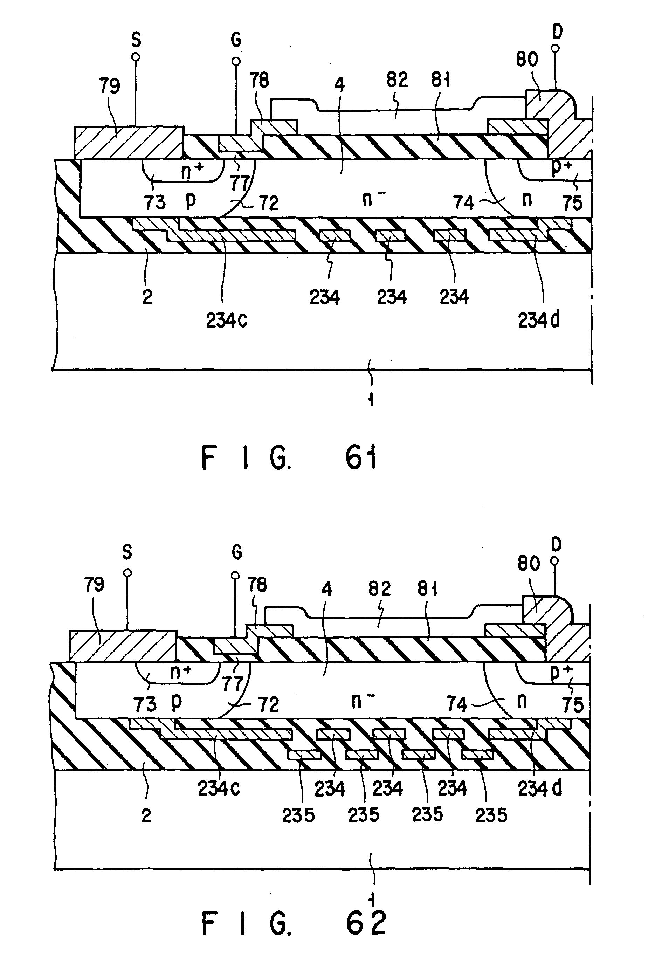

Fig. 61 is an example useful for understanding the present invention in which the example of Fig. 54 is partially modified. That portions 234c and 234d of the polycrystalline silicon film 234 buried in the silicon oxide film 2 which are formed under the p type base layer 72 and the n type buffer layer 74, are exposed to the upper surface of the oxide film 2, and connected to the p type base layer 72 and the n type buffer layer 74, respectively. Due to this, that portion of the polycrystalline film 234, which is just under the source and that portion of the polycrystalline film 234, which is just under the drain thereof, are set to be source potential and drain potential, respectively. The portions 234c and 234d of the polycrystalline silicon film 234 having the above-set potential are set to have suitable lengths as field plates similar to the example of Fig. 59.

In order to manufacture the above-mentioned device structure, to the steps explained in Figs. 56A to 56P, there may be added a step of forming an opening in an oxide film 236 at a portion to be used as a connecting portion between the p type base layer 72, and the polycrystalline silicon 234c, and between the n type buffer layer 74, and and the polycrystalline silicon 234d.

Fig 62 is an example useful for understanding the present invention in which the polycrystalline silicon film 235 is formed at a level lower that that of the polycrystalline silicon film 234 similar to the examples of Fig. 58.

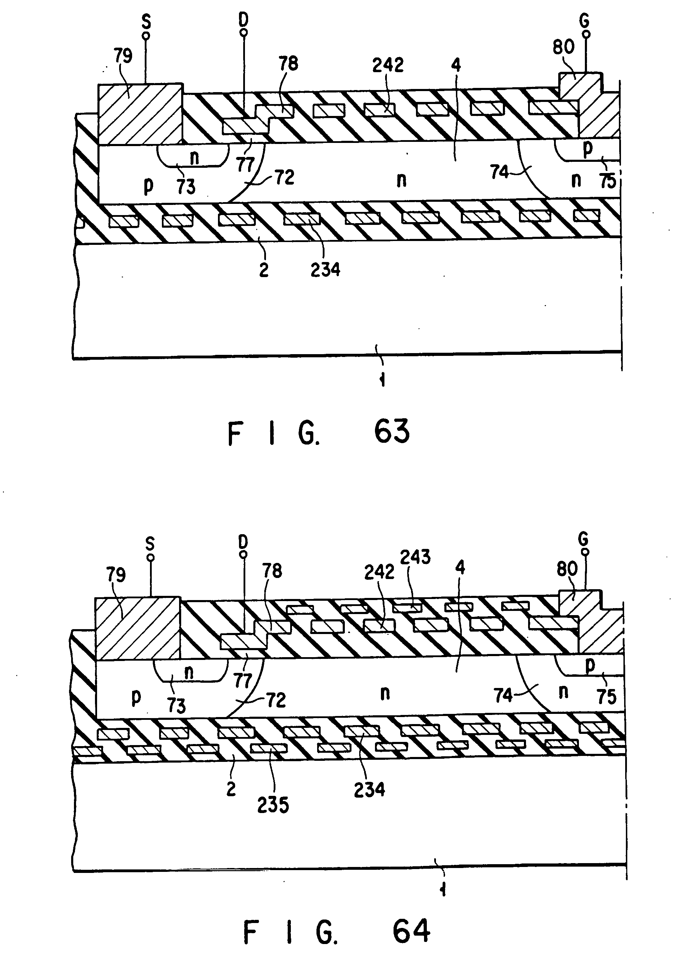

Fig. 63 is an example useful for understanding the present invention in which IGBT of the example of Fig. 54 is partially modified. In this example, in place of the high resistance film 82 of the example of Fig. 54, a polycrystalline silicon film 242, which is similar to the polycrystalline silicon film 234 buried in the oxide film 2, is formed as a field plate. Since the polycrystalline silicon film 242 can be formed at the same time with the gate electrode 78, the manufacturing process of this example is easier than that of the example of Fig. 54.

Fig. 64 is an example useful for understanding the present invention in which the polycrystalline silicon film 235 is further formed at a level lower than that of the polycrystalline silicon film 234 of the bottom portion as in the embodiment of Fig. 55 and the polycrystalline silicon film 243 is further formed at a level higher than that of the polycrystalline silicon film 242. Thereby, shield effect against the upper and lower elements increases.

The material of the films 234, 235, 242, and 243 explained the examples of Figs. 54 to 64 are not limited to polycrystalline silicon. It is possible to replace polycrystalline silicon with SIPOS and the other conductive materials, or resistance materials. Moreover, the modifications explained in Figs. 54 to 64 are useful for the diode, MOSFET, MCT, EST.

As explained above, in a high breakdown voltage semiconductor device comprising the high resistance semiconductor layer, which is separated from the base semiconductor substrate by the first insulating film and separated in the lateral direction by the second insulating film or the pn junction, and the first low resistance region of the first conductive type and the low resistance region of the second conductive type formed in the surface portion of the high resistance semiconductor layer, the thickness of the first insulating film is set to be 1 $\mu$m or more, reverse bias voltage of the device is largely shared by the first insulating film, and electrical field in the high resistance semiconductor layer, which depends on the electrical field in the first insulating film, is weakened, thereby sufficiently high breakdown voltage can be obtained even if the high resistance semiconductor layer is thin. Moreover, since the high resistance semiconductor layer can be made thin, the element separation can be easily made.

According to an example useful for understanding the present invention, a thin active layer is used such that a high impurity concentration layer formed in a high resistance active layer reaches to the first insulating film for isolation. With the structure of the present invention, for example, it is assumed that the high impurity concentration layer of the first conductivity type is formed to reach to the depth of the first insulating film, and high voltage is applied to the high impurity concentration layer of the first conductivity type such that the pn junction becomes reverse bias in a state that the high impurity concentration of the second conductivity type and the substrate are grounded. At this time, voltage to be applied to the high impurity concentration layer of the first conductivity type is all shared by the first insulating film in the vertical direction. The lateral potential distribution of the surface of the active layer is made uniform in accordance with the uniform potential distribution to be formed in the high resistance film formed in the surface of the active layer. Thereby, the field concentration in the active layer is relaxed and the high breakdown voltage characteristic, which cannot be expected from the prior art, can be obtained.

Moreover, according to the present invention, since the thin active layer is used, the element isolation in the lateral direction can be easily performed.

The second specific form of an example useful for understanding the present invention will be explained with reference to the drawings.

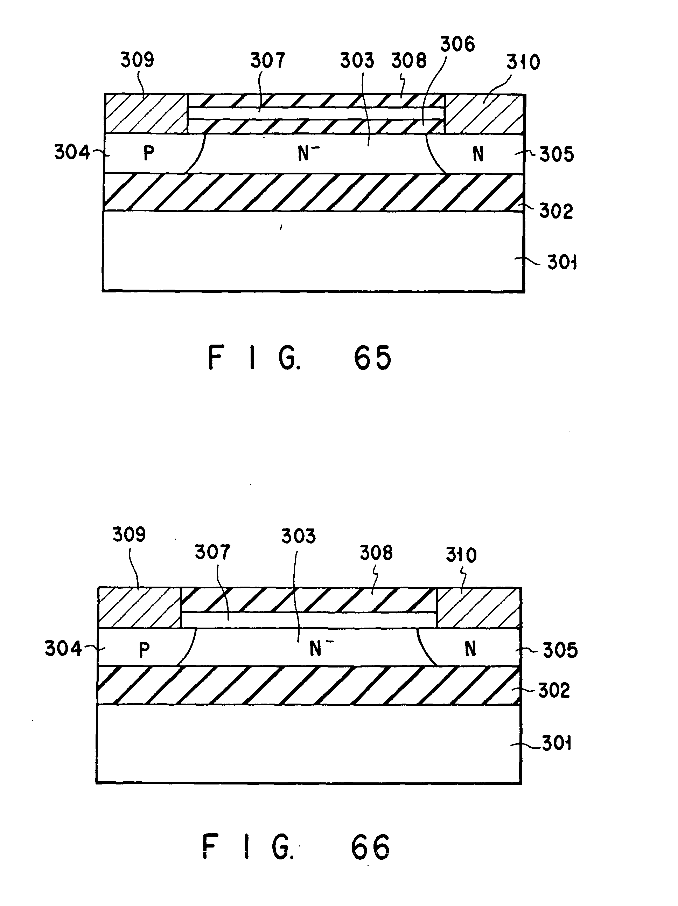

Fig. 65 shows a lateral type diode relating to an example useful for understanding the present invention. An n⁻ type high resistance silicon layer (active layer) 303 is formed on a silicon substrate 301 through a silicon oxide film (first insulating layer) 302. The thickness of the silicon oxide film 302 is set to be about 1 to 5 $\mu$m. The n⁻ type active layer 303 is set to have the thickness of 2 $\mu$m or less, preferably 0.4 $\mu$ or less, the total amount of impurities of $1.0 \times 10^{10}/cm^2$ to $2.0 \times 10^{12}/cm^2$, preferably 0.5 to $1.8 \times 10^{12}/cm^2$. A p type anode layer 304 having high impurity concentration and an n type cathode layer 305 having high impurity concentration are formed in the active layer 303 to be separated from each other with a predetermined distance. The p type anode layer 304 and the n type cathode layer 305 are formed by impurity diffusion to the depth reaching to the silicon oxide film 302 as shown in the drawing. However, the p type anode layer 304 may be formed by impurity diffusion to the depth which does not reach to the silicon oxide film 302.

On the region sandwiched between the p type anode layer 304 of the active layer 303 and the n type cathode layer 305, there is formed a high resistance film 307 through a silicon oxide film (second insulating film) 306. The thickness of the high resistance film 307 is set to be 0.3 $\mu$m or less, preferably 0.2 $\mu$m or less. As the high resistance film 307, for example, SIPOS (Semi-Insulating Polycrystalline Silicon) is used. The surface of the high resistance film 307 is coated with a silicon oxide film 308, serving as a protection film.

An anode electrode 309 and a cathode electrode 310 are formed on the p type anode layer 304 and the n type cathode layer 305, respectively. Both ends of the high resistance film 307 are connected to the anode electrode 309 and the cathode electrode 310.

According to this example, excellent high breakdown voltage can be obtained. For example, it is assumed that the p type anode layer 304 and the substrate 301 are grounded and positive high voltage is applied to the n type cathode layer 305. Since the n type cathode layer 305 is formed to the depth reaching to the silicon oxide film 302, voltage to be applied to the n type cathode layer 305 is all shared by the silicon oxide film 302. Moreover, micro-current flows in the high resistance film 307 formed on the surface of the active layer 303, and a uniform potential distribution is formed in the high resistance film 307 in the lateral direction. Also, in the active layer 303 right under the high resistance film 397, such a uniform potential distribution is formed in the lateral direction by influence of the potential distribution in the high resistance film 307. As a result, field concentration in the device is relaxed and high breakdown voltage can be realized.

In order to have sufficient influence of the uniform potential distribution in the high resistance film 307 on the active layer 303, it is better that the silicon oxide film 306 under the high resistance film 307 is thinned, and favorable high voltage characteristic strength can be obtained if the thickness of the high resistance film 307 is 0.2 $\mu$m or less. Moreover, in order to make influence of the substrate potential on the active layer 3 small and make influence of the potential of the high resistance film 307 thereon relatively large, it is better that the silicon oxide film 302 under the active layer 303 is thicker than the active layer.

The specific data supporting the effect of the above embodiment will be explained as follows.

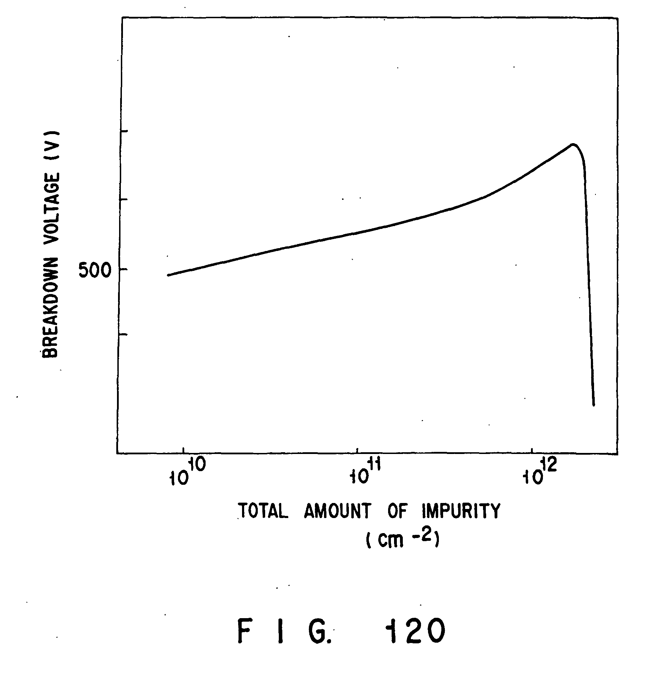

Fig. 120 shows the relationship between the total amount in impurities of the n⁻ type active layer 303 and voltage strength. As is obvious from Fig. 120, when the total amount of impurities exceeds the point of about 1. $8 \times 10^{12}$/cm², breakdown voltage rapidly drops. Therefore, the range of the total amount of impurities, which can be allowed to obtain breakdown voltage of about 500 V or more, is $1.0 \times 10^{10}$/cm² to $2.0 \times 10^{12}$/cm².

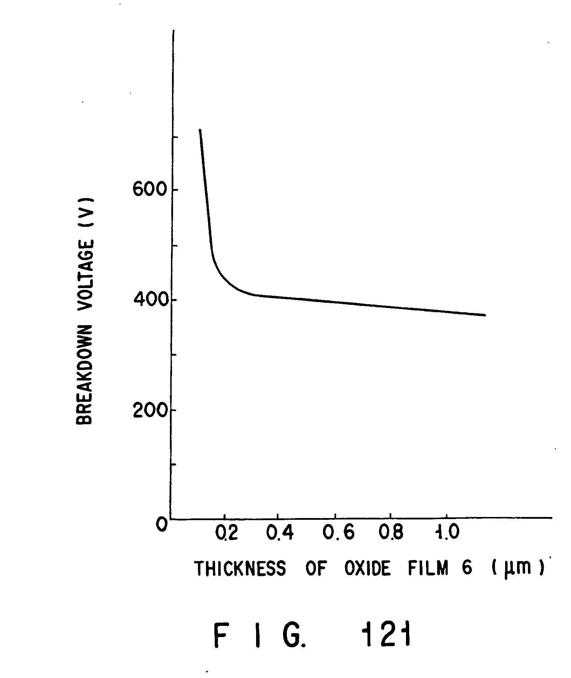

Fig. 121 shows the relationship between the thickness of the oxide film 306 under the high resistance film 307 and breakdown voltage when the thickness of the active layer 303 is 0.1 μm. If the thickness of the oxide film 306 is too large, the effect of the uniform potential distribution of the active layer due to high resistance film 307 cannot be obtained. If the thickness of the oxide film 306 is 0.3 μm or less, the effect can be brought about. Particularly, if the thickness is 0.2 μm or less, it is understood that the effect to improvement of high breakdown voltage can be considerably brought about.

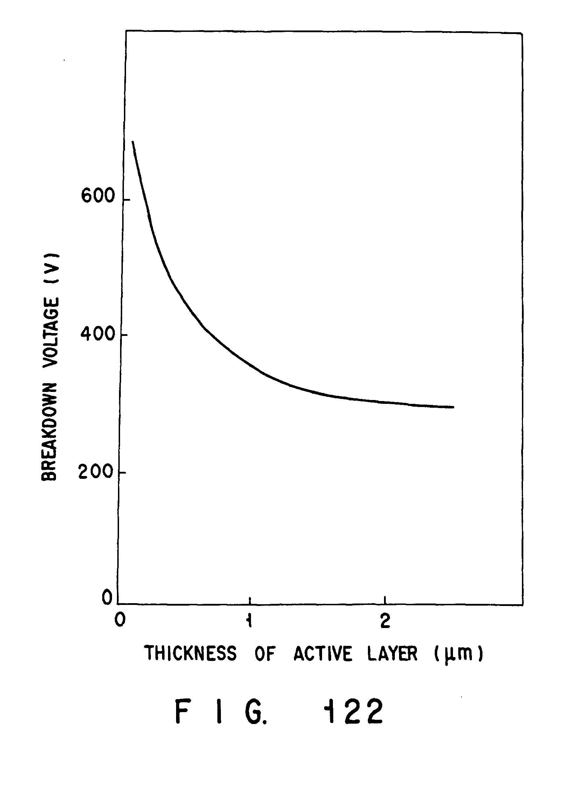

Fig. 122 is data showing the relationship between the thickness of the active layer 303 and breakdown voltage. In a case where the thickness of the active layer is 2 μm or less, breakdown voltage is improved as the active layer becomes thinner. This is because the p type anode layer 304 and the cathode layer 305 are formed to reach the depth of the oxide film 302 and there is the effect of the uniform potential distribution in the active layer 303 due to the high resistance film 307 on the active layer 303.

Fig. 66 is an example useful for understanding the present invention in which the formation of the silicon oxide film under the high resistance film 307 is omitted and the high resistance film 307 is directly formed on the surface of the active layer 303 based on the structure of the example of Fig. 65. According to this structure, the uniform potential distribution of the high resistance film 307 is directly transmitted to the inside of the active layer, and field concentration is effectively relaxed.

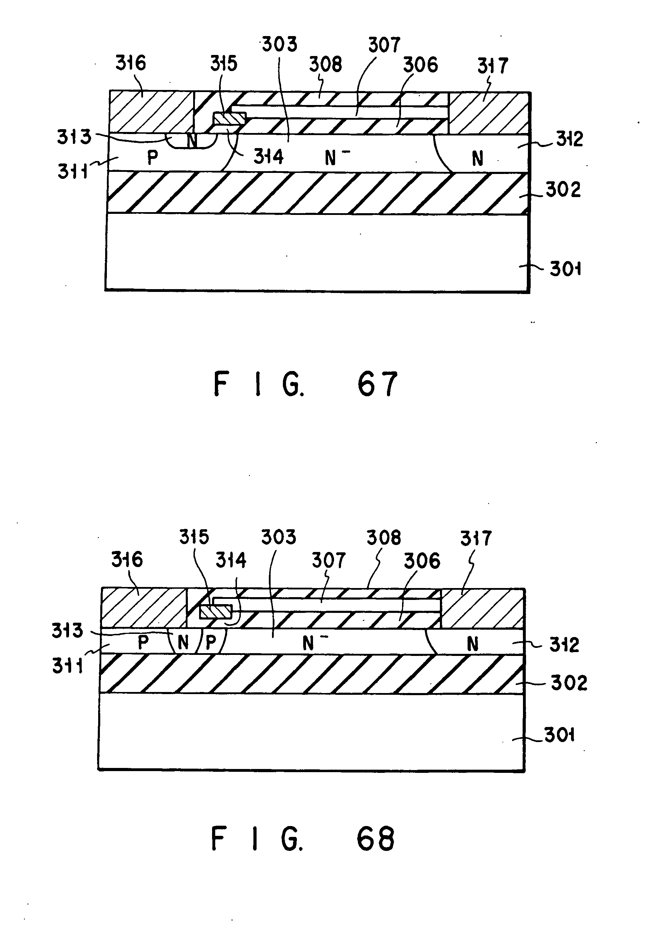

Fig. 67 is an example useful for understanding the present invention in which the present invention is applied to MOSFET. Similar to the example of Fig. 65, the n⁻ type high resistance silicon thin layer 303 having a thickness of 2 μm or less is formed on the silicon substrate 301 through the silicon oxide film 302. The total amount of impurities of the n⁻ type active layer 303 is also the same as that of the example of Fig. 65. A p type base layer 311 and an n type drain layer 312, which correspond to the p type anode layer 304 and the n type cathode layer 305, respectively, are formed in the active layer 303. The p type base layer 311 and the n type drain layer 312 are formed to reach to the depth of the silicon oxide film 302. However, the p type base layer 311 may be formed to be shallower than the depth of the silicon oxide film 302. An n type source layer 313 is formed in the p type base layer 311. The surface portion of the p type base layer 311, which is sandwiched between the n type source layer 313 and the n⁻ type active layer 303, is used as a channel region, and a gate electrode 315 is formed thereon through a gate oxide film 314 having a thickness of about 60 nm.

On the surface of the active layer 303, which is sandwiched between the p type base layer 311 and the n type drain layer 312, similar to the the example of Fig. 65, there is formed the high resistance film 307 through the silicon oxide film 306 having a thickness of 0.3 μm or less, preferably 0.2 μm or less. The upper portion of the high resistance film 307 is coated with the silicon oxide film 308.

A source electrode 316 is formed to be in contact with the n type source layer 313 and the p type base layer 311 at the same time. A drain electrode 317 is formed on the n type drain layer 312. The end portion of the high resistance film 307 is connected to the gate electrode 315 and the drain electrode 317.

MOSFET of this example can also obtain the excellent high breakdown voltage characteristic which is similar to the diode of the example of Fig. 65.

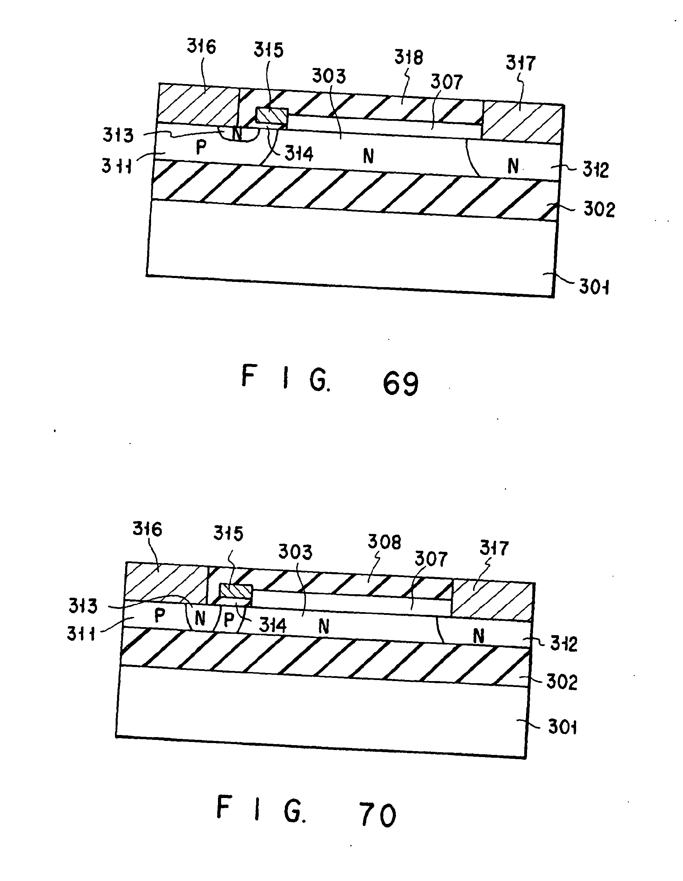

Fig. 68 is an example useful for understanding the present invention in which the active layer 303 is formed to be thinner such that the n type source layer 313 reaches to the silicon oxide film 302 based on the structure of Fig. 67. Figs. 69 and 70 are examples in which the high resistance film 307 is directly formed on the surface of the n⁻ type active layer 303.

These examples also show that excellent high breakdown voltage.

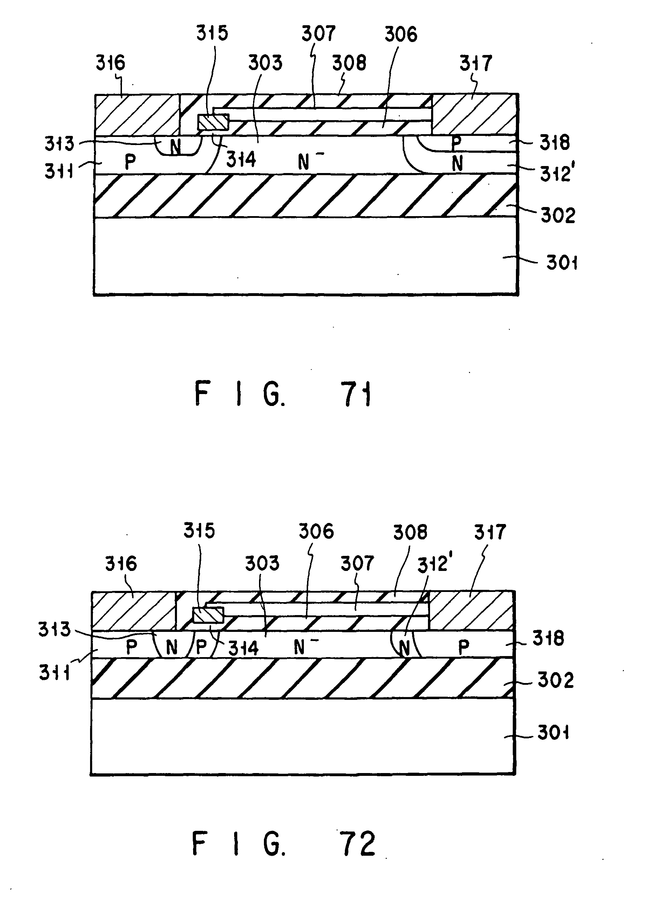

Fig. 71 is an example useful for understanding the present invention in which the present invention is applied to the lateral type IGBT. The basic structure is the same as that of the example of Fig. 67. In this example, an n⁻ type base layer 312' corresponds to the n type drain layer 312 of Fig. 67, and the p type drain layer 318 is formed in the n type base layer 12'.

Fig. 72 is an example useful for understanding the present invention in which the active layer 303 is formed to be thinner such that the n type source layer 313 and the p type drain layer 318 reach to the silicon oxide film 302, similar to the example of Fig. 68. At this time, since the p type drain layer 318 is in contact with the silicon oxide film 302, there is a case that a channel using a p type inversion layer is formed in the bottom portion of the active layer. In order to prevent this case, impurity concentration of the n type base layer 312' must be set to be higher. More specifically, impurity concentration of the n type base layer 312' may be $1 \times 10^{17}$/cm³ or more.

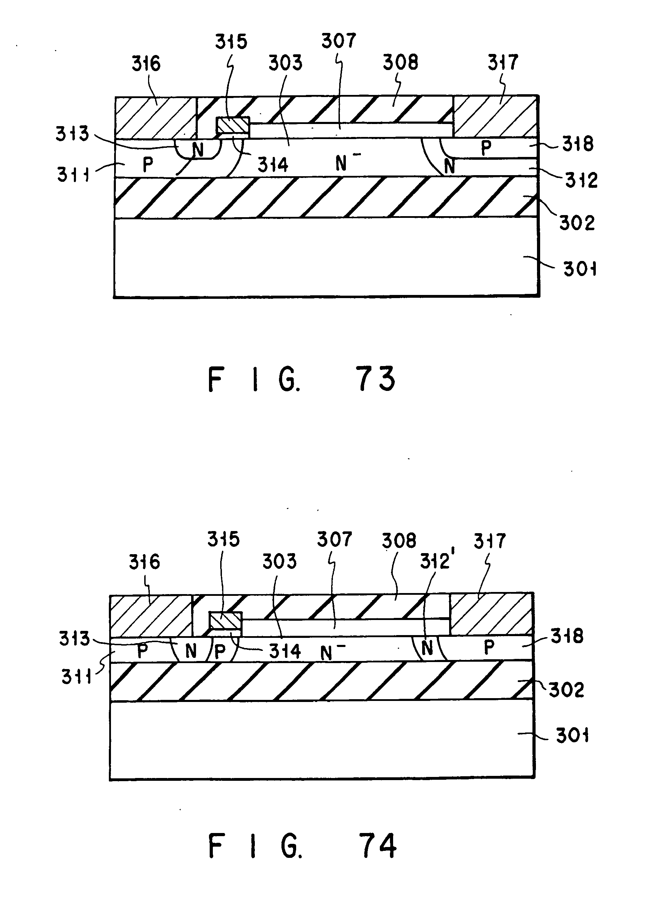

Figs. 73 and 74 are examples useful for understanding the invention in which the high resistance film 307 is directly formed on the surface of the active layer 303 based on the structure of Figs. 71 and 72.

These examples also show that excellent high breakdown voltage.

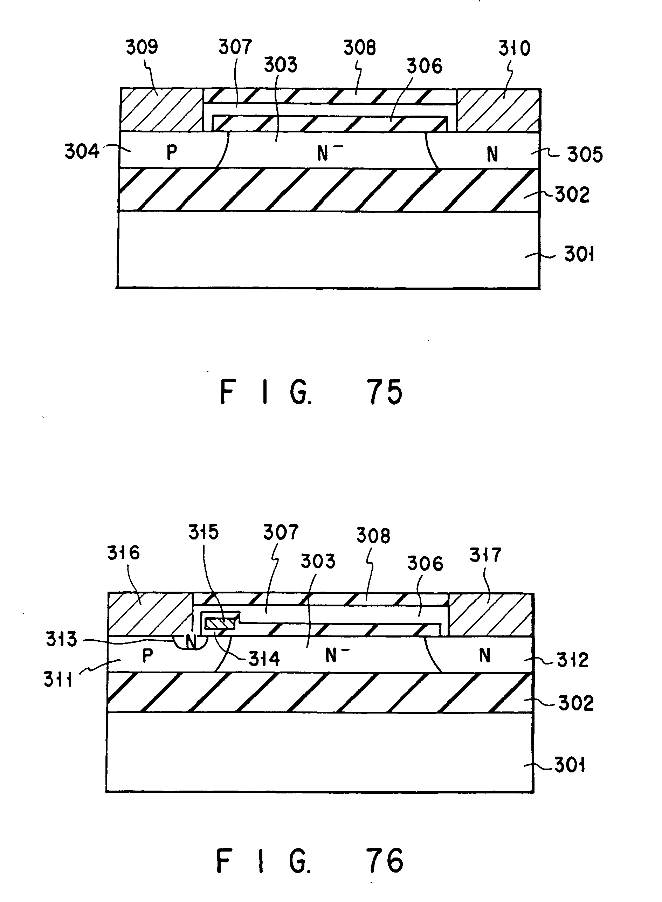

Fig. 75 is an example useful for understanding the present invention in which both ends of the high resistance film 307 is directly brought into contact with the p type anode layer 304 and the n type cathode layer 305.

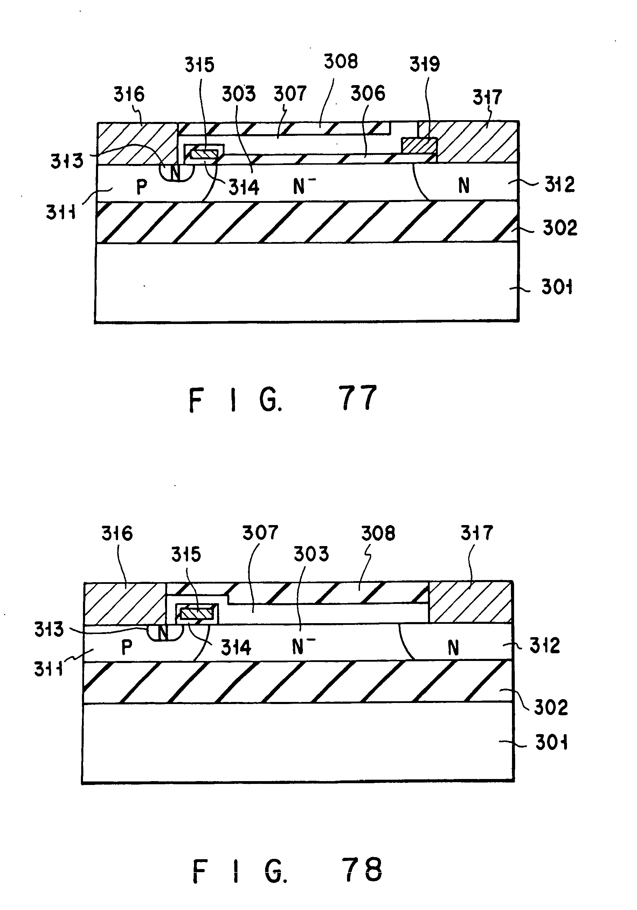

Fig. 76 is an example useful for understanding the present invention in which the both ends of the high resistance film 307 are brought into contact with the n type source layer 313 and the n type drain layer 312, respectively, based on the MOSFET of Fig. 67. Fig. 77 is an example useful for understanding the present invention in which the drain side end portion of the high resistance film 307 is connected to the drain electrode 317 through a polycrystalline silicon film 319 doped with impurity based on the structure of Fig. 76. Fig. 78 is an example useful for understanding the present invention in which the source side end portion of the high resistance film 307 is connected to the n type source layer 313 based on MOSFET of Fig. 69.

In the examples of IGBT shown in Figs. 71 to 74, the connection of the end portions of the high resistance film 307 can be modified (not shown) similar to the embodiment of MOSFET.

These embodiments also show that excellent high breakdown voltage.

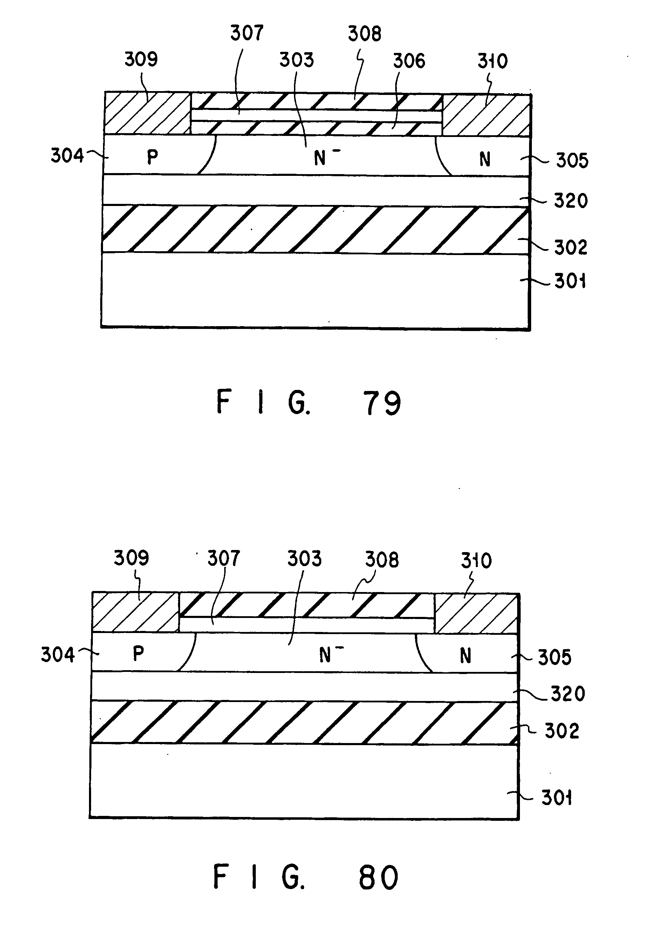

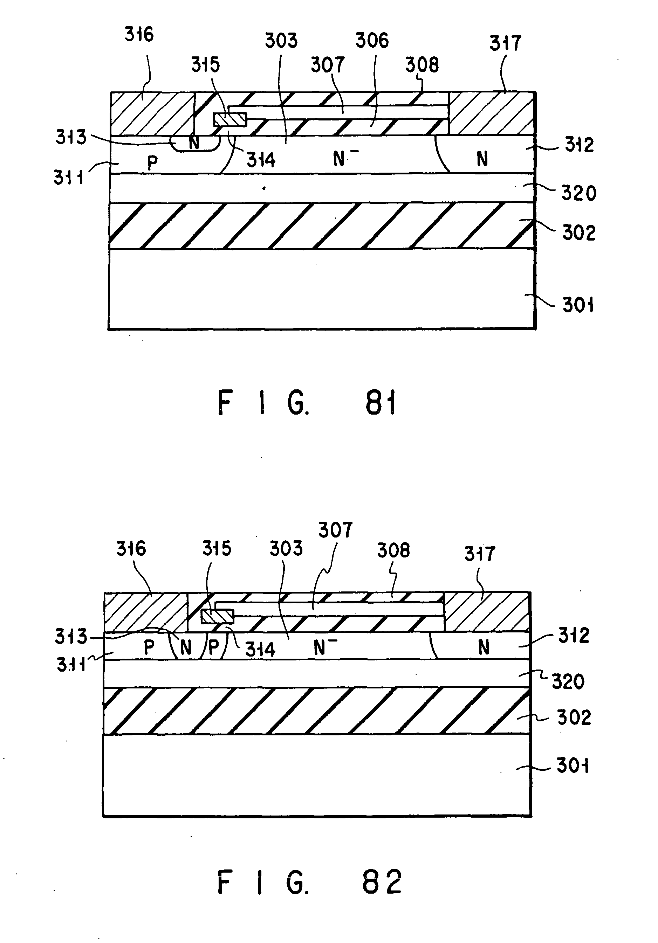

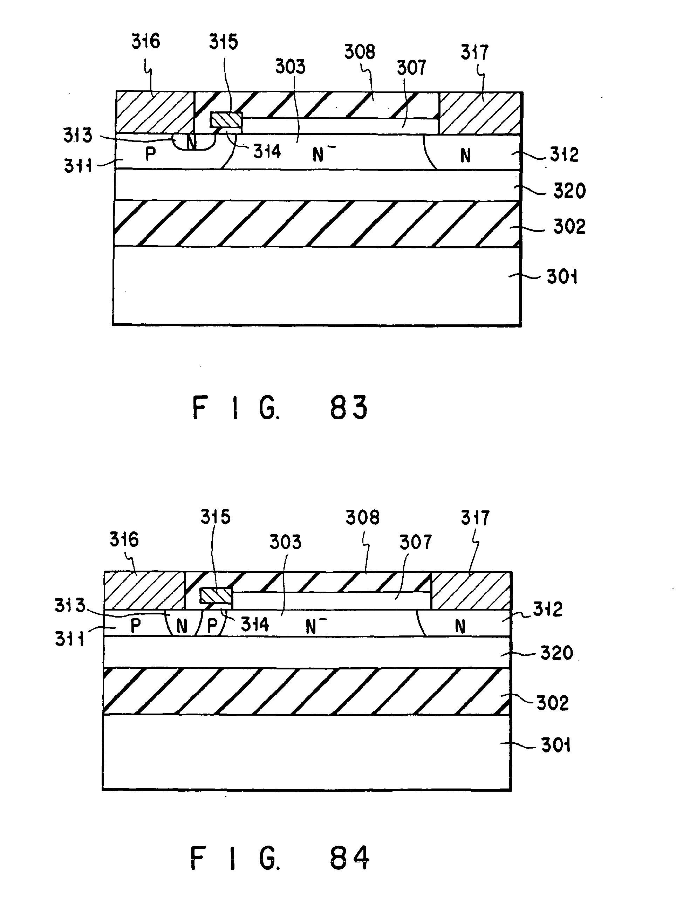

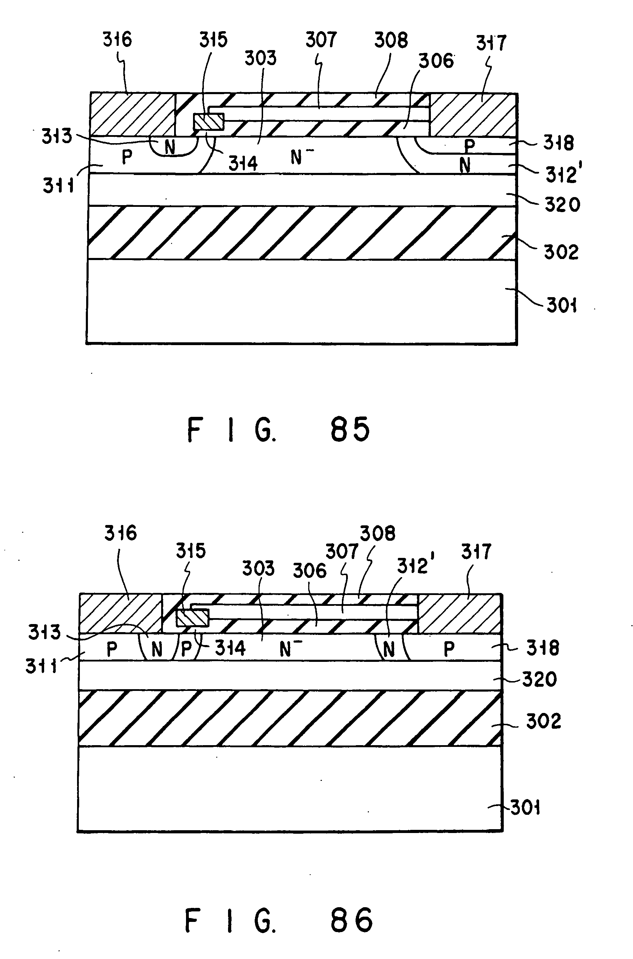

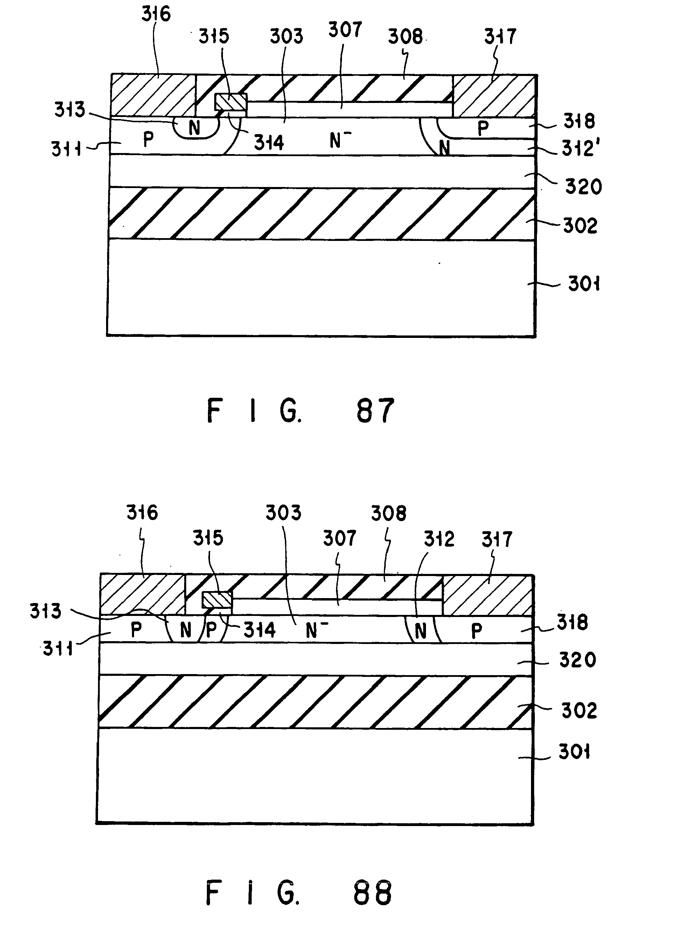

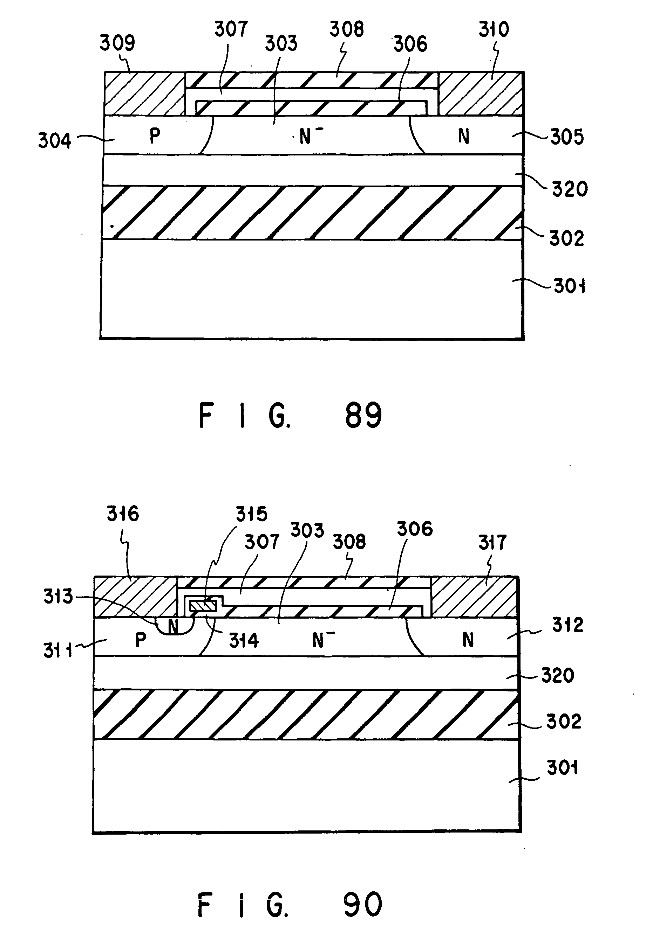

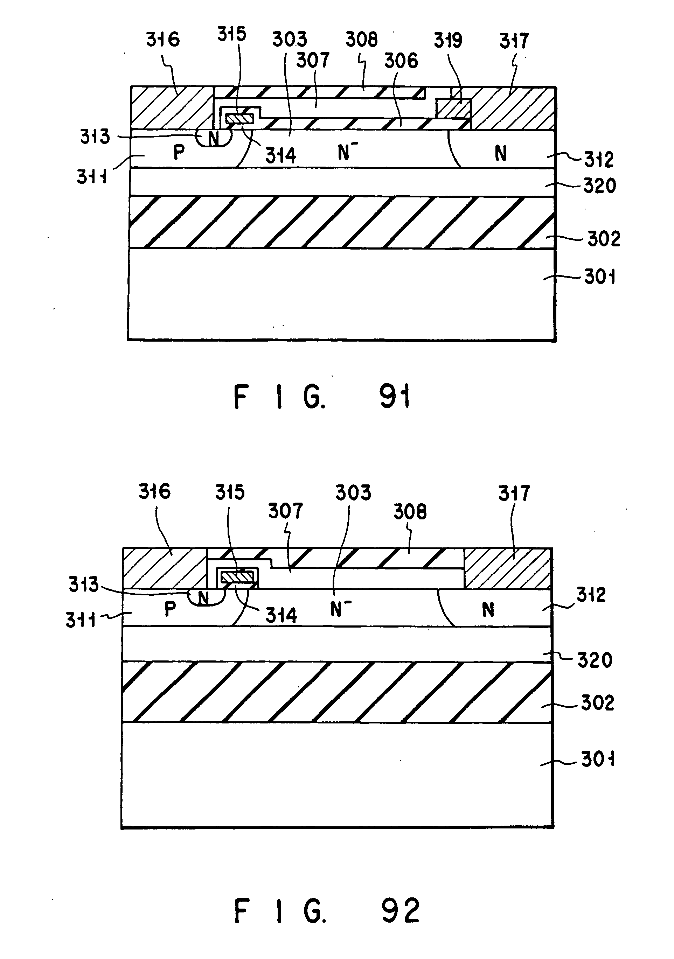

Figs. 79 to 92 are examples useful for understanding the invention in which a high resistance film 320 such as SIPOS is formed in the bottom portion of the active layer 303 based on the examples of Figs. 65 to 78.

The high resistance film 320 formed in the bottom portion of the active layer 303 has the same function as the high resistance film 307 formed on the surface of the active layer 303. Thereby, field concentration in the element is further effectively relaxed and high breakdown voltage characteristic can be obtained.

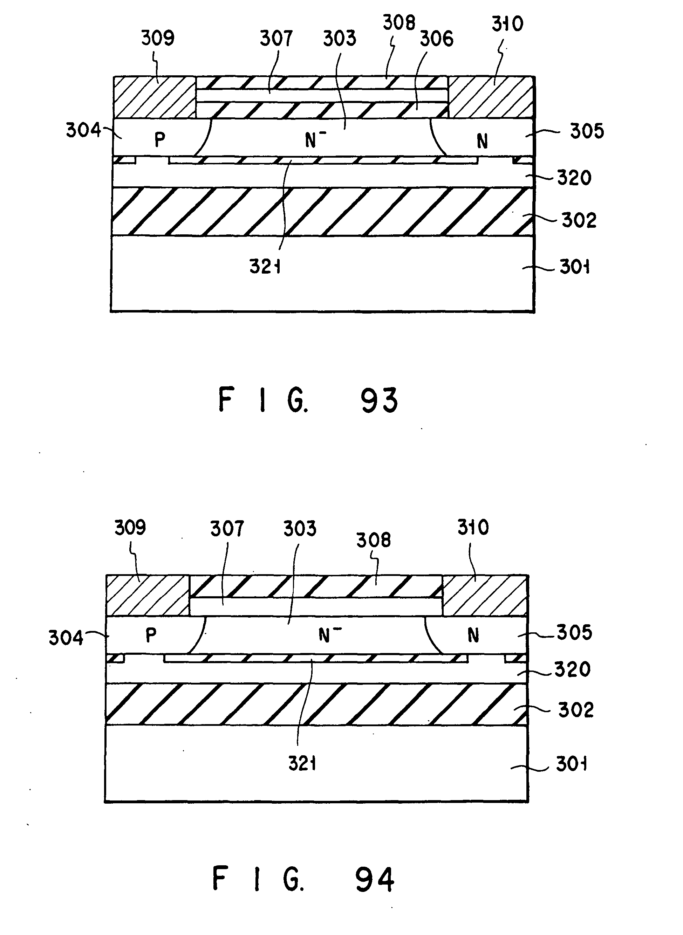

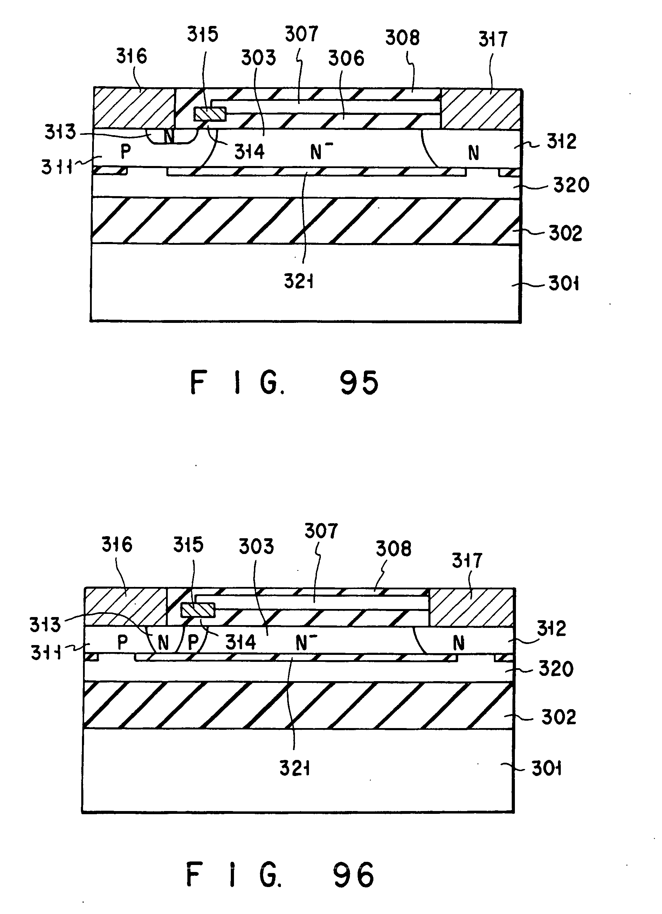

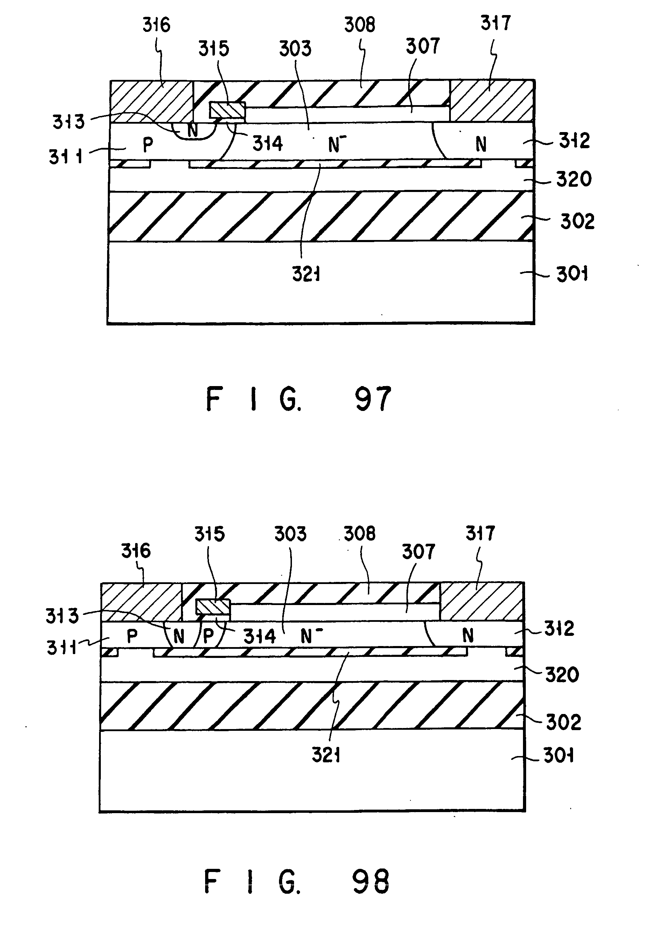

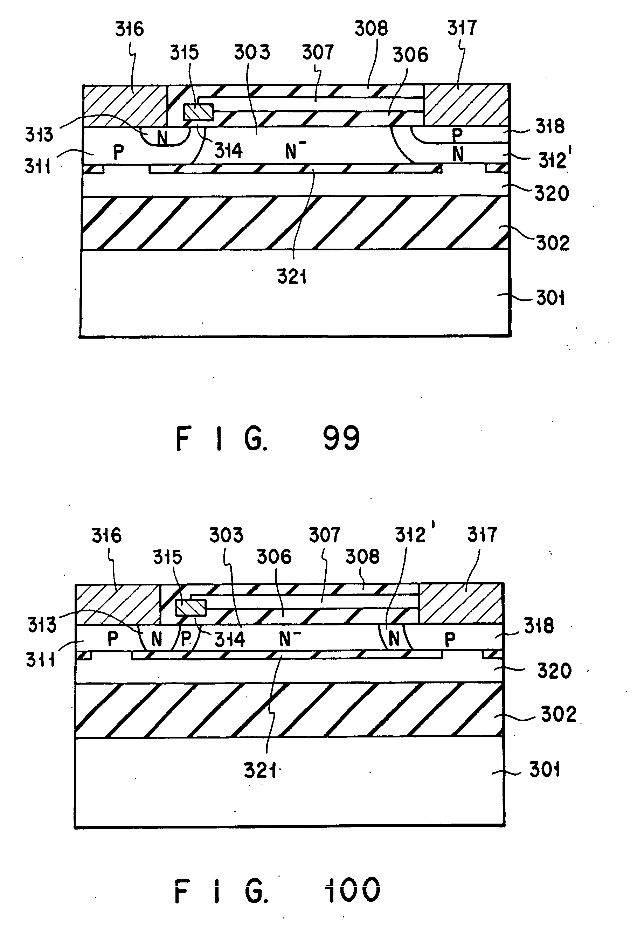

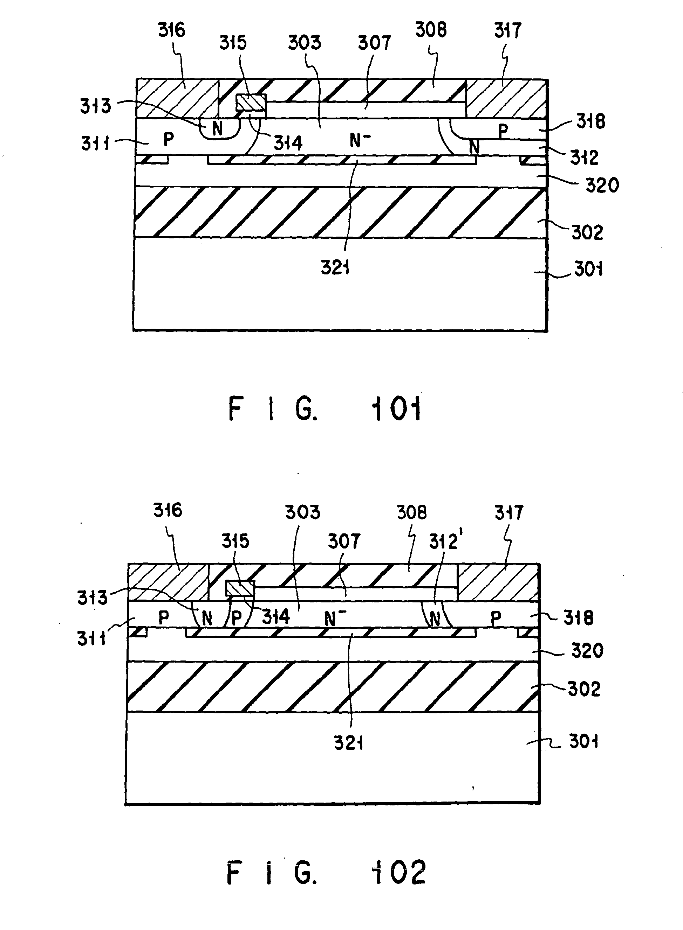

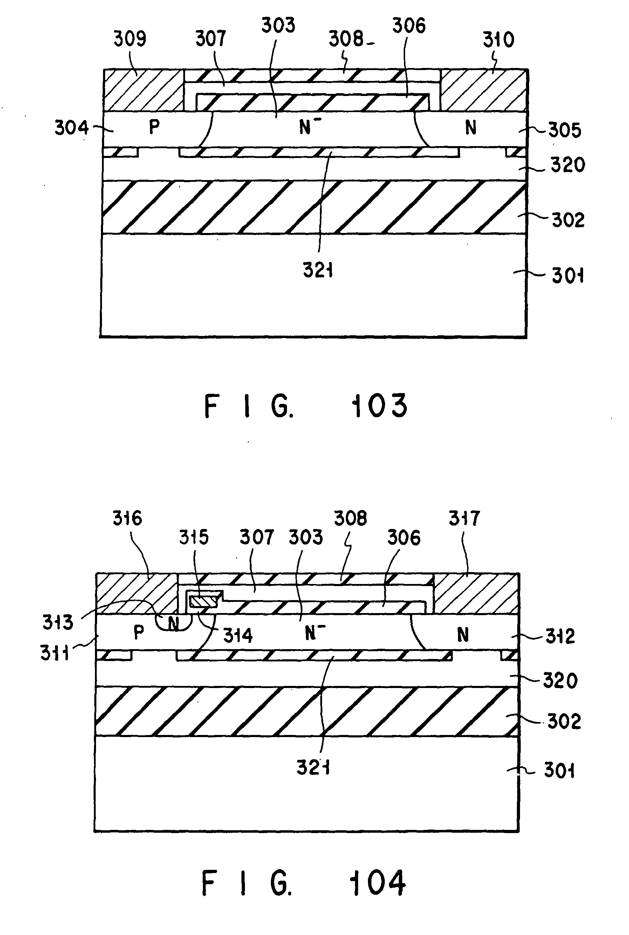

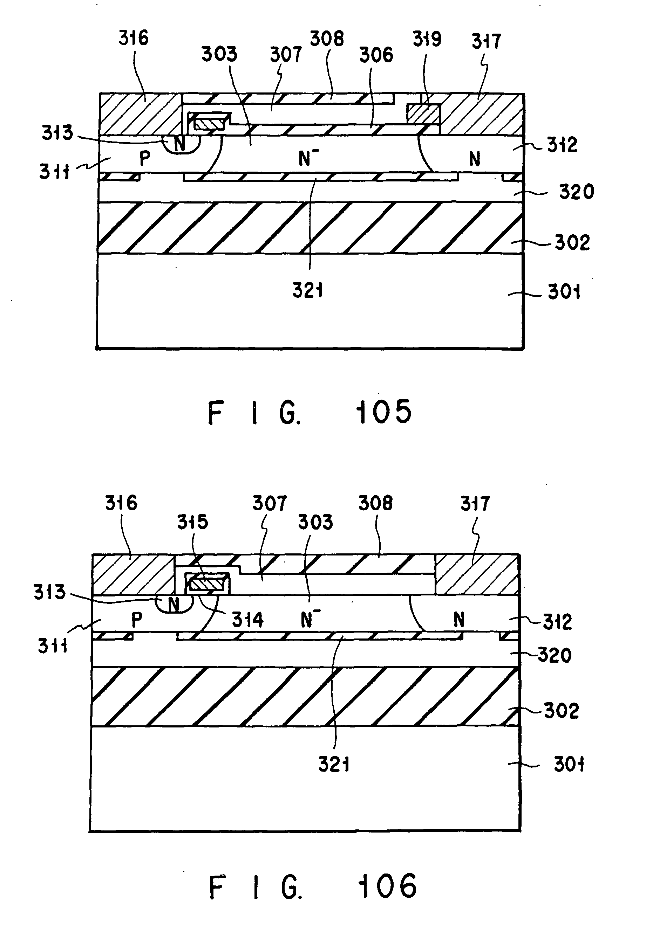

Figs. 93 to 106 are examples useful for understanding the invention in which a thin silicon oxide film 321 is formed between the active layer 303 and the high resistance film 320 based on the structure of Figs. 79 to 92. These examples also show that excellent high breakdown voltage characteristic can be obtained if the silicon oxide film 321 is sufficiently thinned, preferably 0. 2 $\mu$m or less.

In Figs. 79 to 92 and Figs. 93 to 106, the anode - cathode potential or the drain - source potential is applied to the high resistance film 320 of the bottom portion of the device through the diffusion layer. However, the electrode may be connected to the high resistance film 320 by, for example, forming the groove.

In the examples explained so far, like the anode and cathode impurity layers of the diodes, there was explained the case in which the impurity layers of different conductivity types opposing to each other in the lateral direction in the active layer are in contact with the base oxide film of the active layer. However, the present invention is effective if at least one of impurity layers is in contact with the lower oxide film. The following explains several examples having such the structure.

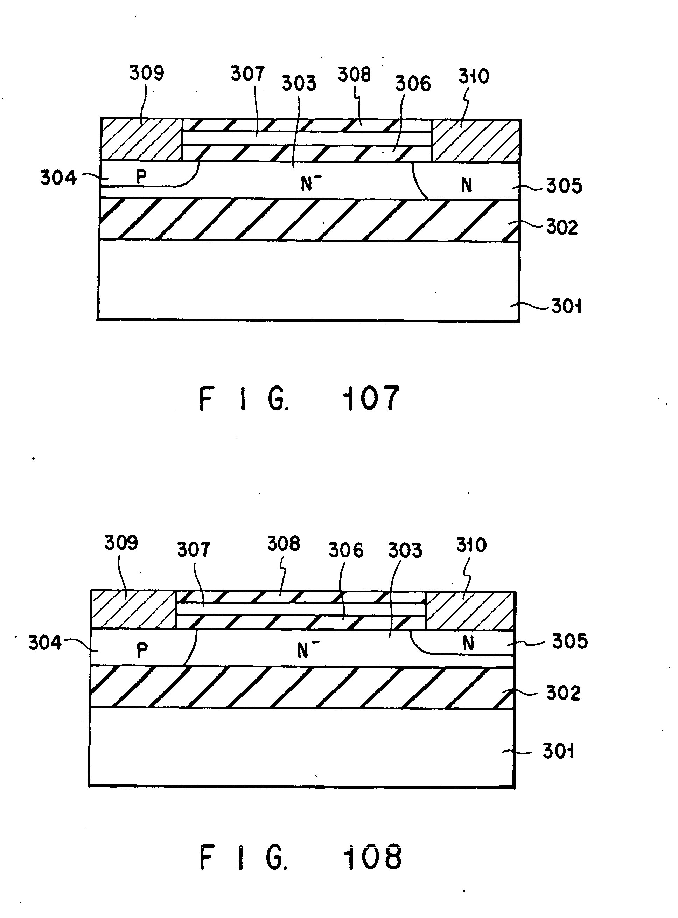

Fig. 107 is an example useful for understanding the present invention in which the p type anode layer 304 is not in contact with the lower oxide film 302 based on the example of Fig. 65. Since it is the side of the n type cathode layer 305 that breakdown occurs by field concentration at the time of application of reverse bias, the high breakdown voltage characteristic can be sufficiently obtained in the example

Reversing to the Fig. 107, Fig. 108 is an example useful for understanding present invention in which the p type anode layer 304 is formed so as to reach the oxide film 302, and the n type cathode layer 305 is formed not to reach the oxide film 302. In the structure of this example, if the thickness of the active layer remaining under the n type cathode layer 305 is extremely small, sufficiently high breakdown voltage characteristic can be obtained.

The similar modification can be made in the other examples; of the diode.

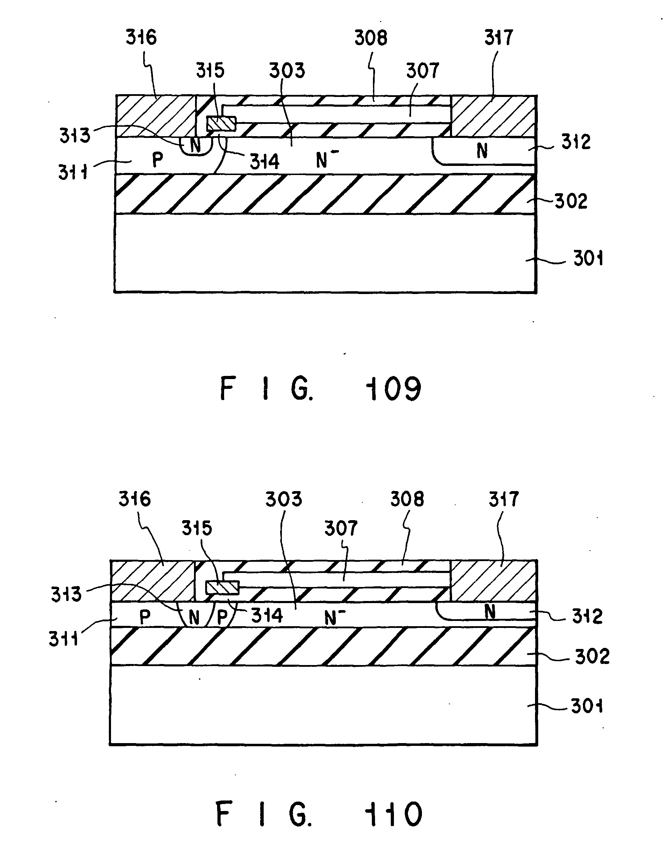

Figs. 109 and 110 are examples useful for understanding the invention in which the n type drain layer 312 is formed not to reach the base oxide film 302 in MOSFET of the examples of Figs. 69 and 70. In these examples, necessary high breakdown voltage characteristic can be obtained if the thickness of the active layer remaining under the n type drain layer 312 is small.

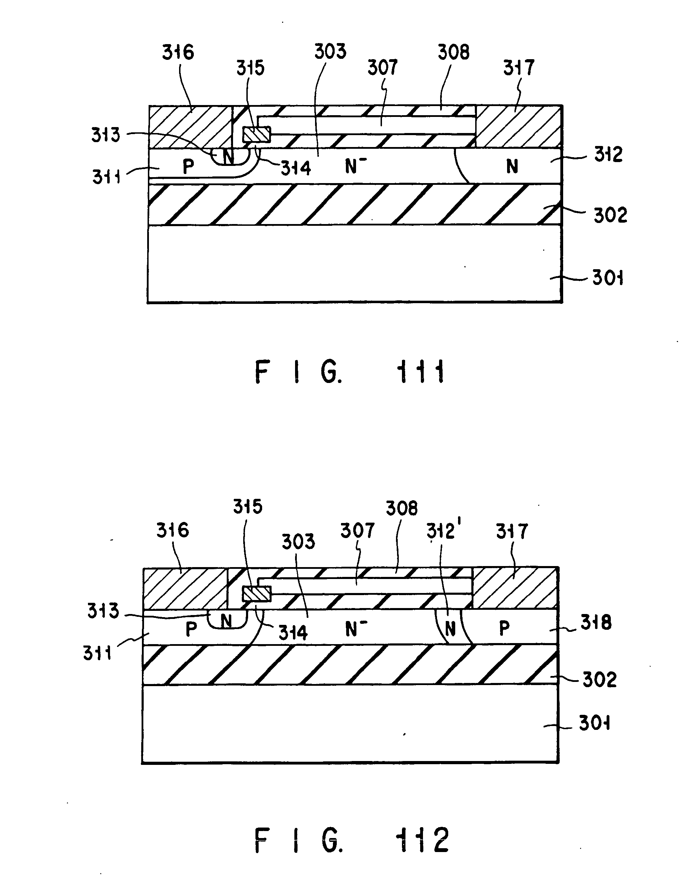

Fig. 111 is an example useful for understanding the present invention in which the p type base layer 311 is formed to have a depth which does not contact the base oxide film 302 in the MOSFET of the example of Fig. 69. In this case, for the same reason as the example of the diode of Fig. 107, the high breakdown voltage characteristic can be obtained.

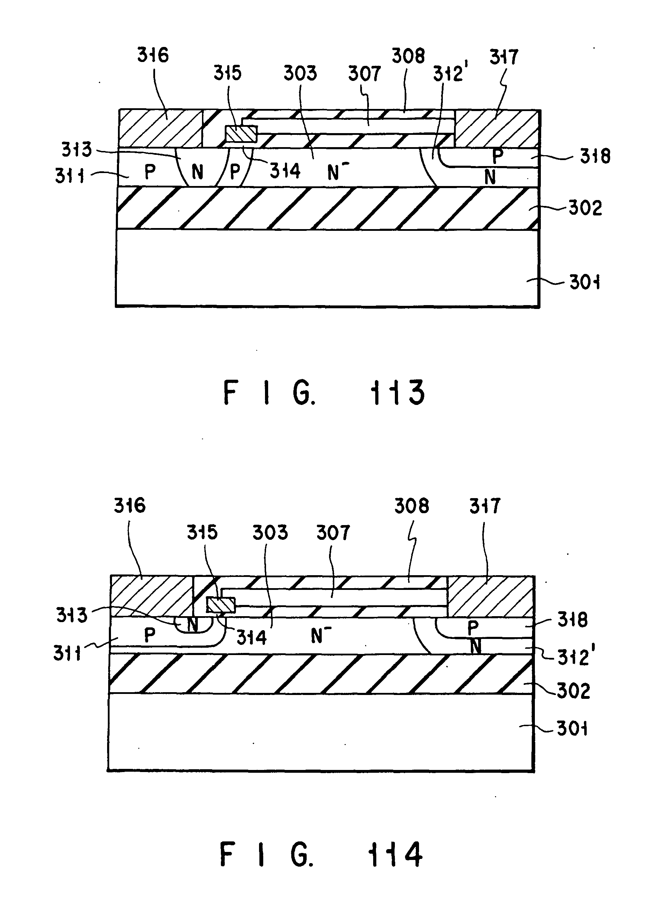

Figs. 112 and 113 are examples useful for understanding the invention in which either the source layer or the drain layer is formed to have a depth contacting the oxide film 302 in the example of IGBT. In the case of IGBT, since the source and drain layers do not relate to the high breakdown voltage characteristic, there is no influence on the high breakdown voltage characteristic even if such a modification is made. Particularly in Fig. 113, the p type drain layer does not contact the oxide film 302 and the channel using the p type reverse layer can be prevented from being formed in the bottom portion of the active layer.

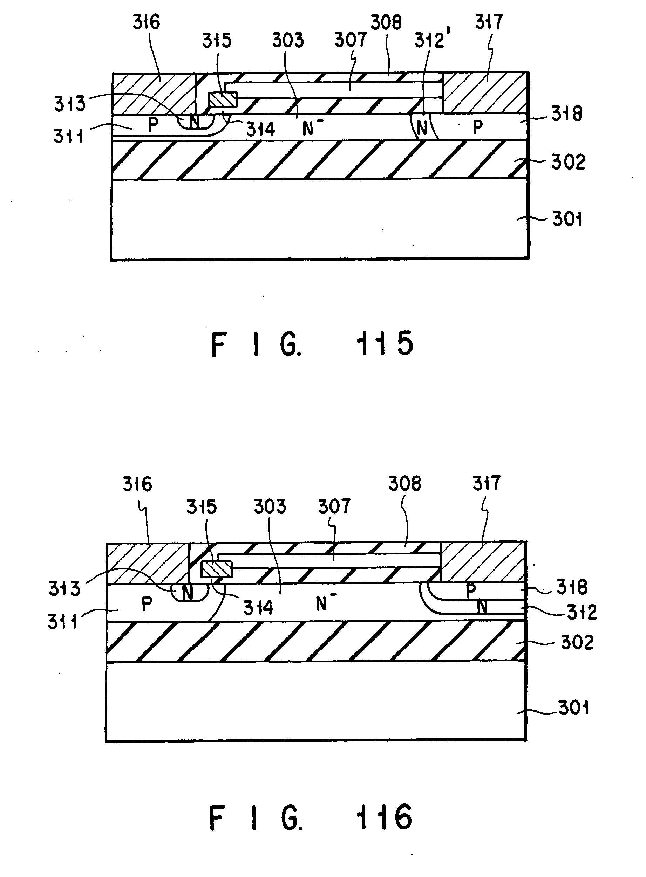

Figs. 114 and 115 are examples useful for understanding the invention in which the p type base layer 311 is formed to have a depth which does not reach to the oxide film 302 in IGBT of the examples of Figs. 73 and 74. In IGBT, there is the problem in field concentration of the side of the n type base layer on the drain side at the time of application of reverse bias. Due to this, if an n type base layer 312' is formed to a depth reaching to the oxide film, high breakdown voltage characteristic can be sufficiently obtained.

Reversing to Figs. 114 and 115, Figs. 116 and 117 are examples useful for understanding the invention in which the n type base layer 312' is formed to a depth which does not reach to the oxide film 302. In this case, the high breakdown voltage can be also obtained if the thickness of the active layer remaining under the n type base layer 312' is sufficiently small.

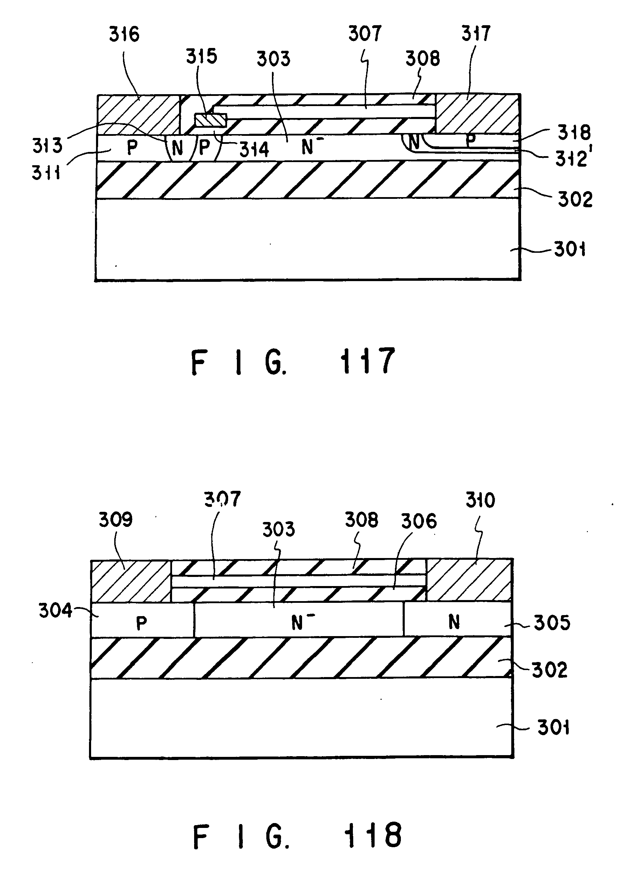

Fig. 118 is an example useful for understanding the present invention in which the p type anode layer 304 and the n type cathode layer 305 are formed by not impurity diffusion from the top portion but lateral impurity diffusion, and the junction surface is formed to be substantially vertical to the active layer. The similar modifications can be made in the other embodiments explained so far.

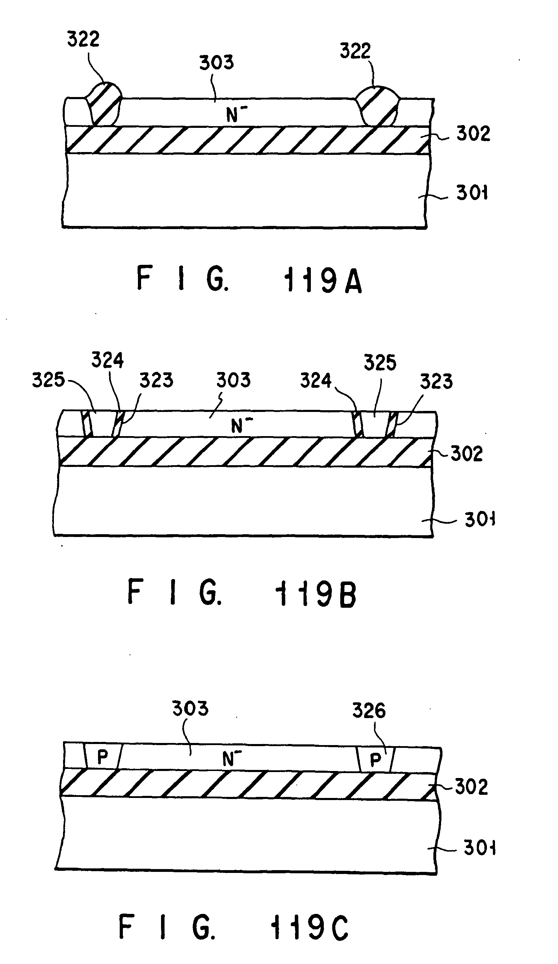

In the above examples, the explanation of the lateral isolation of the element was omitted. However, the isolation structure as shown in Figs. 119A to 119C can be used.

Fig. 119A shows that a silicon oxide film 322 for lateral isolation is formed to have a depth reaching to the silicon oxide film 302 of the bottom portion of the active layer 303 by LOCOS. According to the present invention, since the active layer 303 is formed to be 2 $\mu$m, the complete dielectric isolation structure can be easily obtained by such LOCOS.

In Fig. 119B, an isolation groove 323 having a depth reaching to the silicon oxide film 302 is formed and a silicon oxide film 324 is formed on the side surface thereof. Thereafter, for example, a polycrystalline silicon film 325 is buried therein.

Fig. 119C shows a pn junction isolation structure using a p type diffusion layer 326. Since the thickness of the active layer 303 is thin, the lateral isolation can be easily performed without ensuring the large area in the isolation region.

In each example of diode, MOSFET and IGBT, the conductivity type of each portion can be opposed.

As explained above, there is formed the dielectric isolation structure in which the high impurity concentration layer to which high voltage is applied reaches to the base insulating film. Also, the high resistance film in which the uniform potential distribution is formed is arranged on the surface of the active layer, thereby obtaining the semiconductor device wherein the lateral element isolation is easily performed and excellent high breakdown voltage characteristic is shown.

As a specific example of the semiconductor device having high breakdown voltage relating to the second specific form useful for understanding the present invention, it has been explained that the high resistance film is formed on the high resistance semiconductor layer through the insulating layer or not therethrough. However, the high resistance film is not always necessary to be formed in view of the feature of the high breakdown voltage semiconductor device relating to the above-explained second specific form of the present invention. Therefore, the following explains an example in which the high resistance film is not formed.

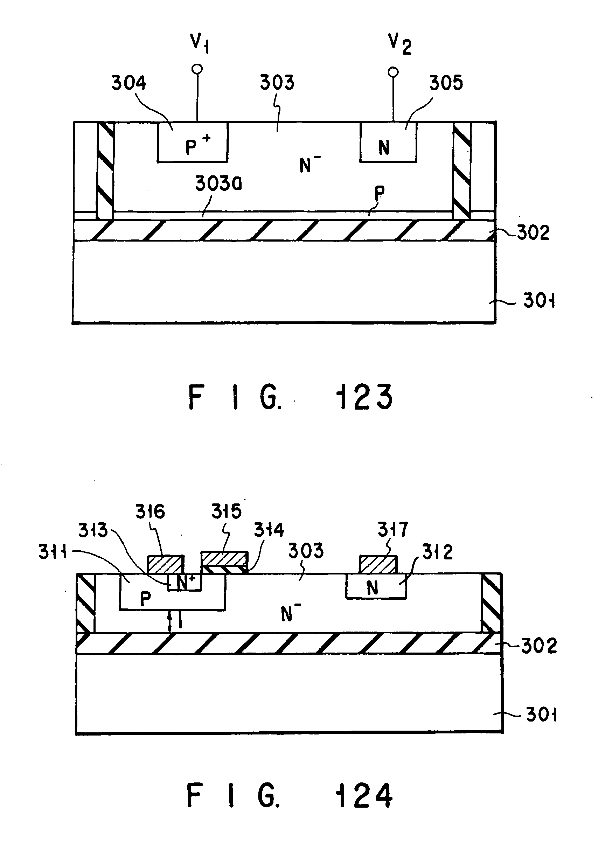

Fig. 123 is a lateral type diode relating to an example useful for understanding the present invention. The n type high resistance silicon layer (active layer) 303 is formed on the silicon substrate 301 through the silicon oxide film (first insulating film) 302. The thickness of the silicon oxide film 302 is about 1 to 5 $\mu$m. The n-type active layer 303 has and the total amount of impurities of $1.0 \times 10^{10}$/cm$^2$ to $2.0 \times 10^{12}$/cm$^2$, preferably $0.5 \times 10^{12}$ to $1.8 \times 10^{12}$/cm$^2$. The p type anode layer 304 having high impurity concentration and the n type cathode layer 305 having high impurity concentration are formed in the active layer 303 to be separated from each other with a predetermined distance. The p type anode layer 304 and the n type cathode layer 305 are formed to have the depth which does not reach to the silicon oxide film 302 as shown in the drawing. If voltage $V_1$ and voltage $V_2$ are applied to the p type anode layer 304 and the n type cathode layer 305, respectively, and voltages $V_1$ and $V_2$ are higher than the voltage Vsub of the silicon substrate 301, a p type channel region 303a is formed in the bottom portion of the high resistance silicon layer 303. since the p-type channel region 303a has positive charge, capacitance is formed together with the substrate 301. Thereby, influence of the potential of the substrate 301 is shielded, and the high resistance silicon layer 303 is prevented from being depleted.

Fig. 124 is a MOSFET showing other example in which the p- type channel region 303a shown in Fig. 123 is formed. The n- type active layer 303 is formed on the substrate 301 through the silicon oxide film 302. The p type base layer 311 and the n type drain layer 312 are formed in the active layer 303. The p type base layer 311 and the n type drain layer 312 are formed to have the depth which does not reach to the silicon oxide film 302.

The n type source layer 313 is formed in the p type base layer 311, and the the surface portion of the p type base layer 311, which is sandwiched between the n type source layer 313 and the n- type active layer 303, is used as a channel region, and the gate electrode 315 is formed on the channel region through the gate oxide film 314 having a thickness of about 60 nm.

The MOSFET shown in Fig. 124 is used as a switch on the high potential side of the circuit. If the MOSFET is turned on, both source potential and the drain potential become high potential to the substrate 301. In this case, if the influence of the potential of the substrate 301 is not shielded, the active layer 303 is depleted, and on-resistance of the MOSFET becomes extremely high.

However, the distance between the p type base layer 311 and the oxide film 302 and impurity concentration of the p type base layer 311 are suitably selected, a hole is injected from the p type base layer 311 and the p- channel region is formed in the bottom portion of the active layer 303 when the source potential $V_1$ is a certain constant value or more. Thereby, the active layer 303 is prevented from being depleted.

In this case, the source potential Vp to form the p⁻ type channel region can be obtained from the following equation.

$$Vp = qC_N l^2/2\varepsilon$$

wherein q: $1.6 \times 10^{-19}$ (C),
$C_N$: N type impurity concentration and
$\varepsilon$: dielectric constant ($1.05 \times 10^{-12}$ F/cm).
Vp is preferably 10 V or less. That is, $1 \leq 20 \, \varepsilon/qC_N$.

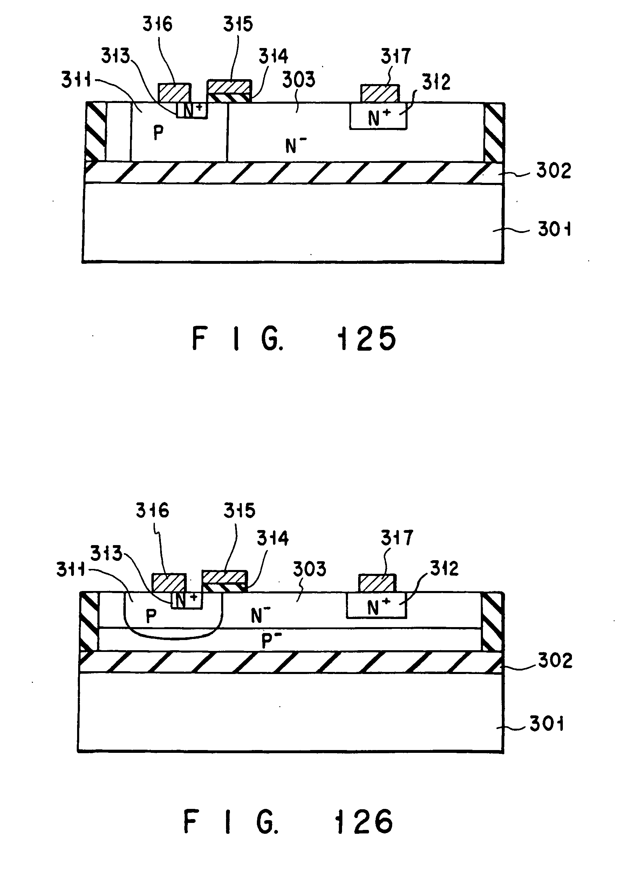

In order to set Vp to zero, the distance 1 may be changed to 0. In other words, the structure shown in Figs. 125 and 126 may be used.

In Fig. 124, if the conductivity type of the drain region 312 is changed to p type, the device becomes IGBT. For such IGBT, the potential of n⁻ type active layer is floating and the p-channel region on the bottom oxide layer 302 is always formed even if the distance is greater than zero. The n⁻ type active layer may be formed by impurity diffusion.

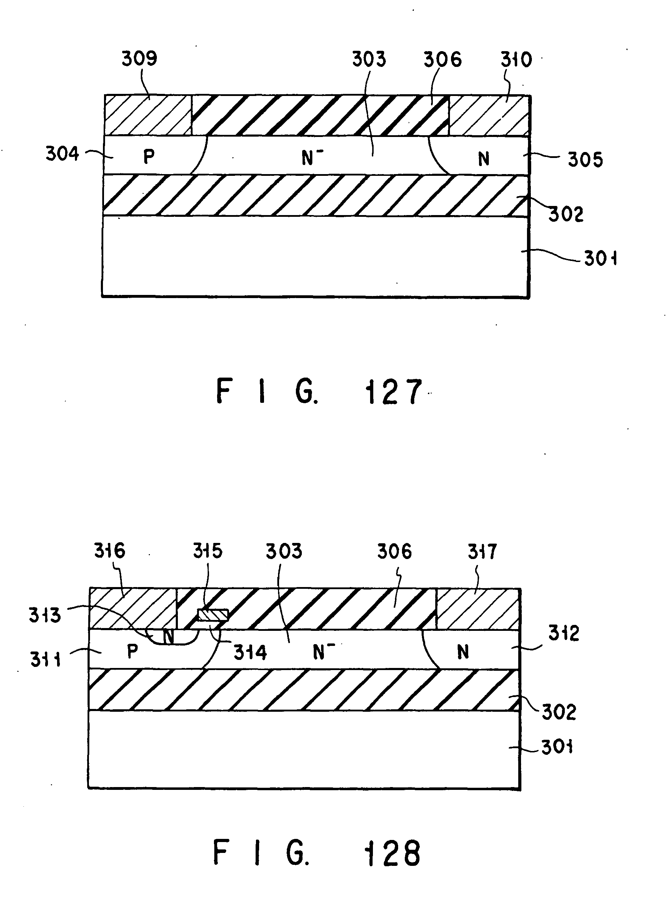

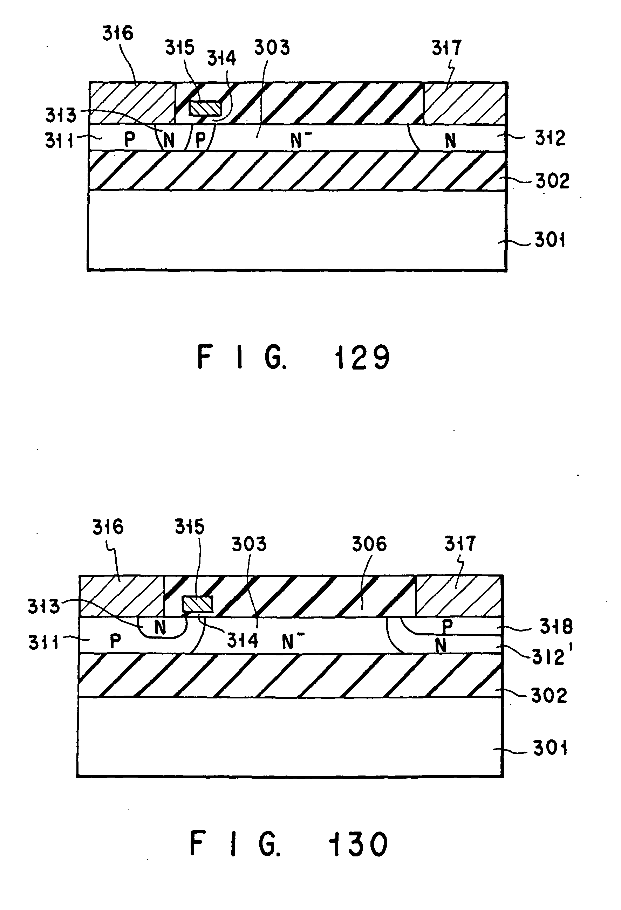

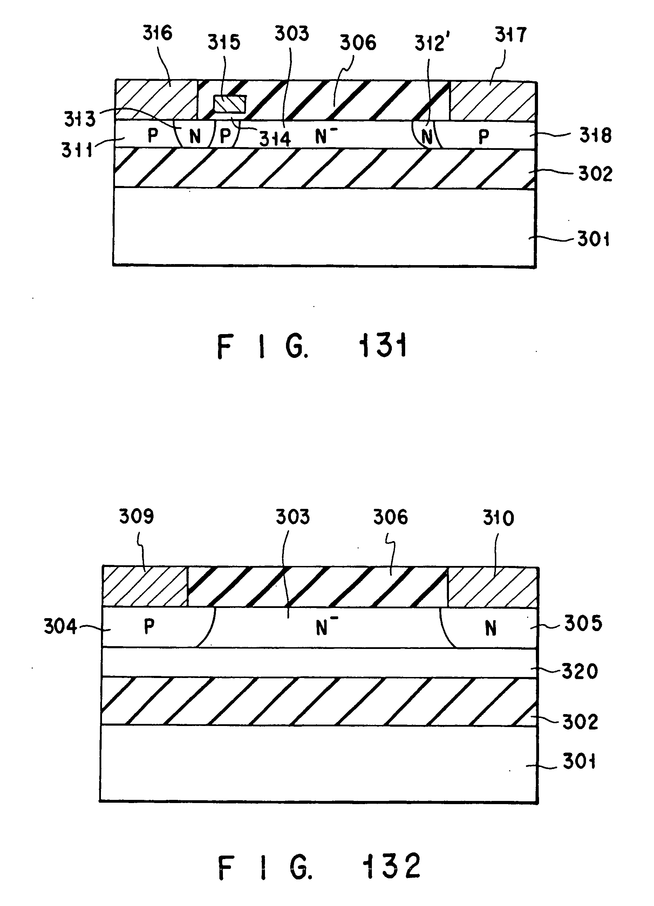

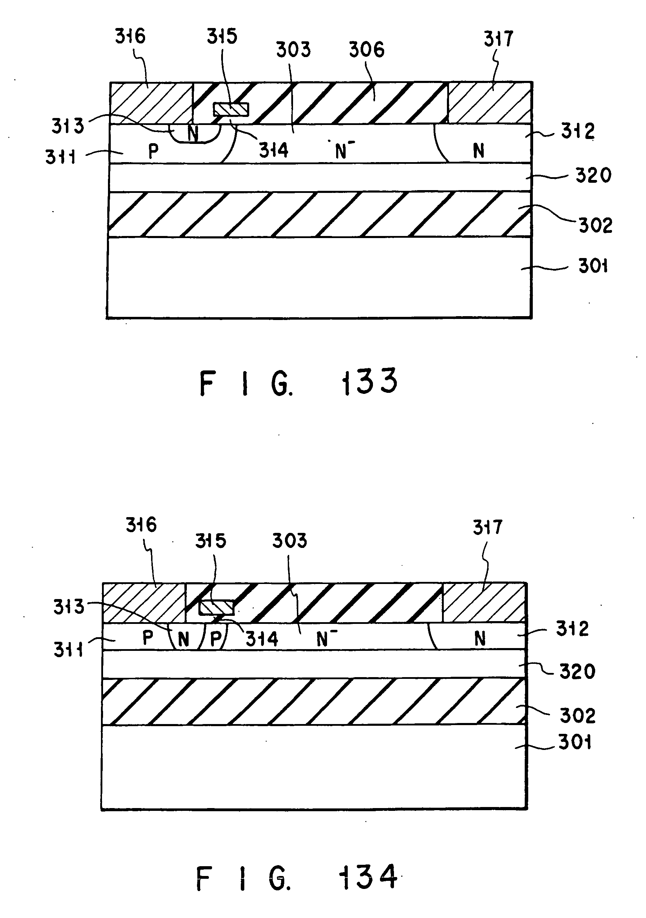

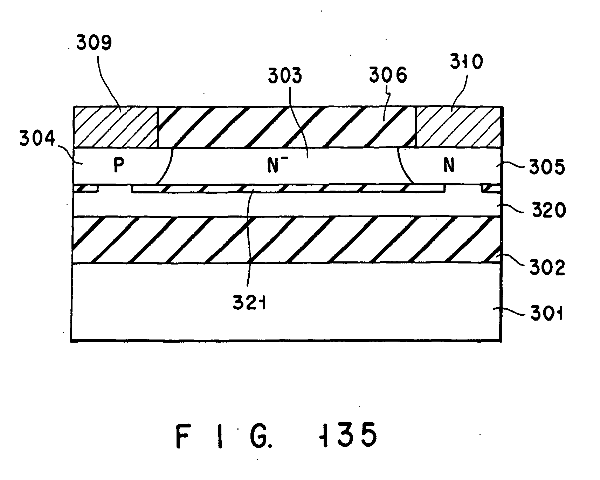

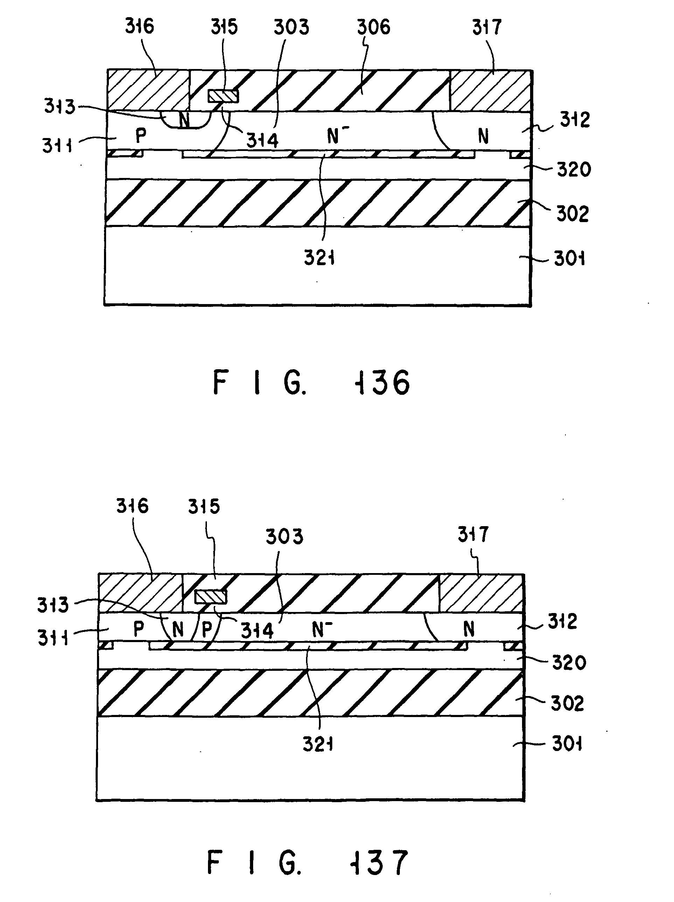

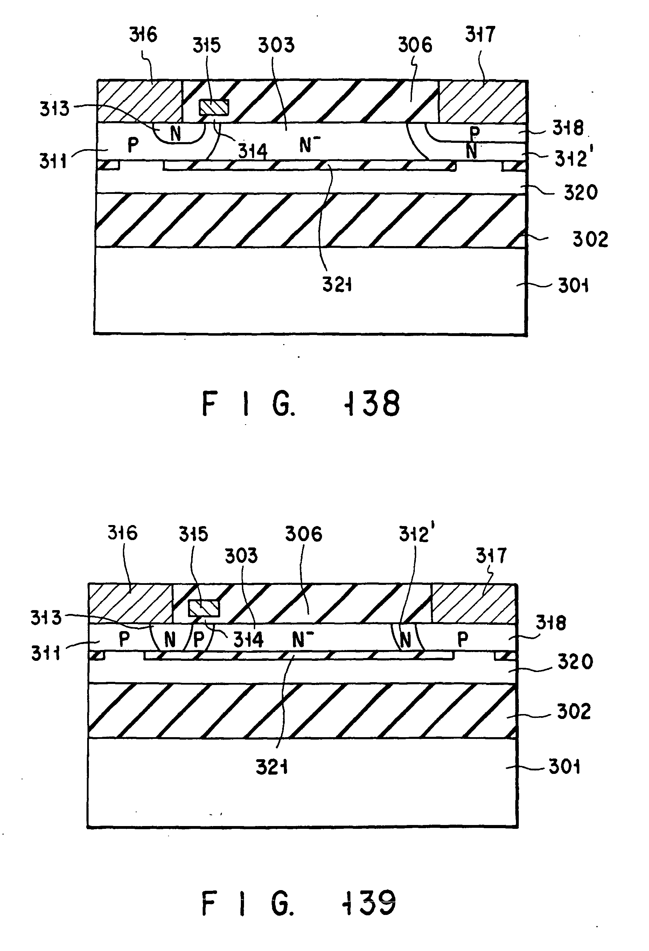

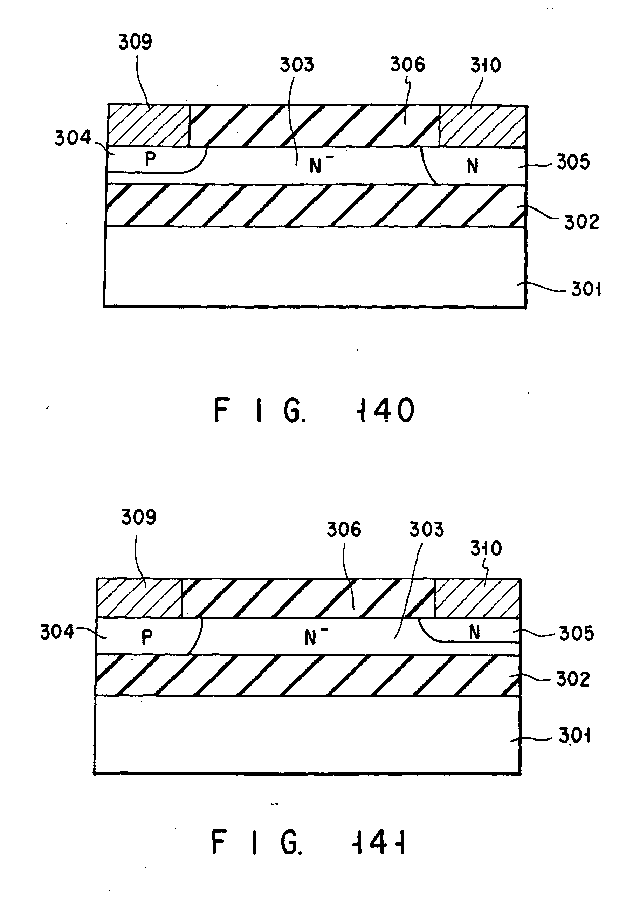

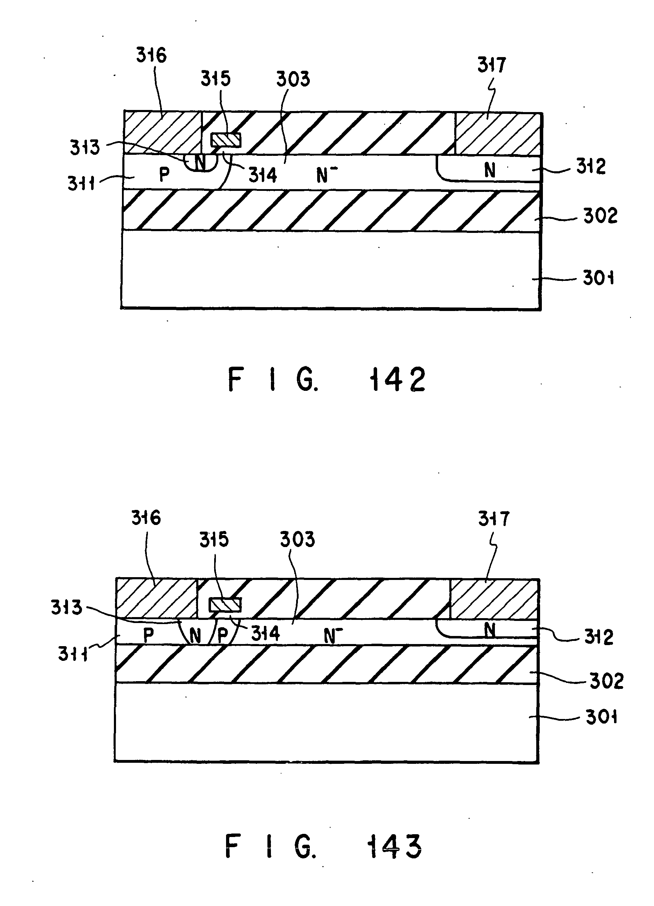

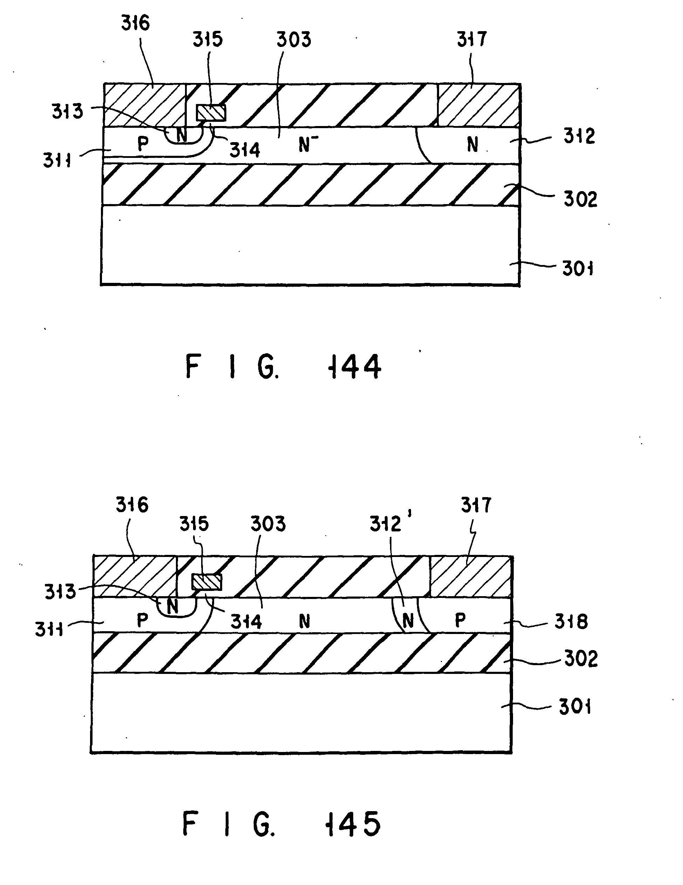

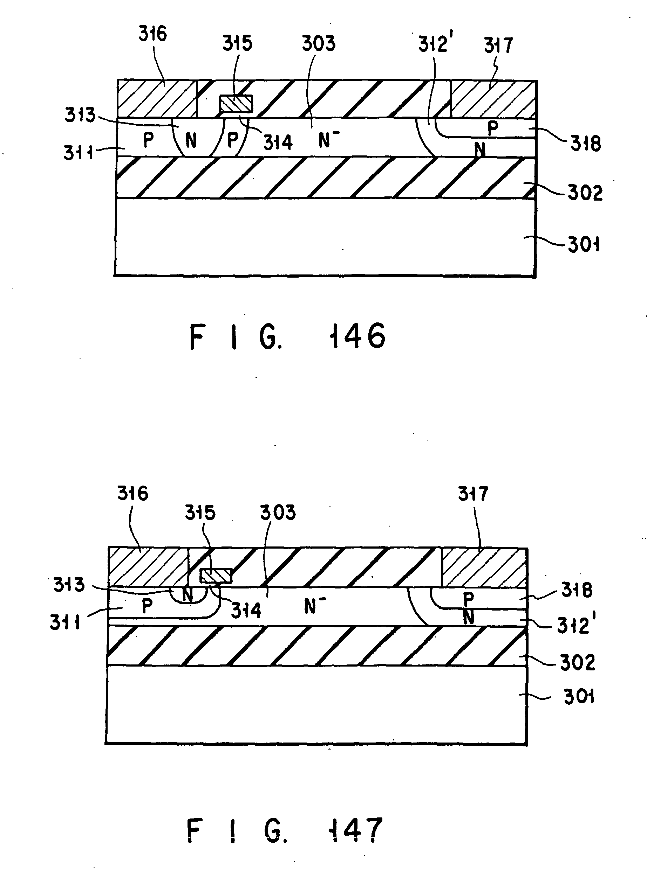

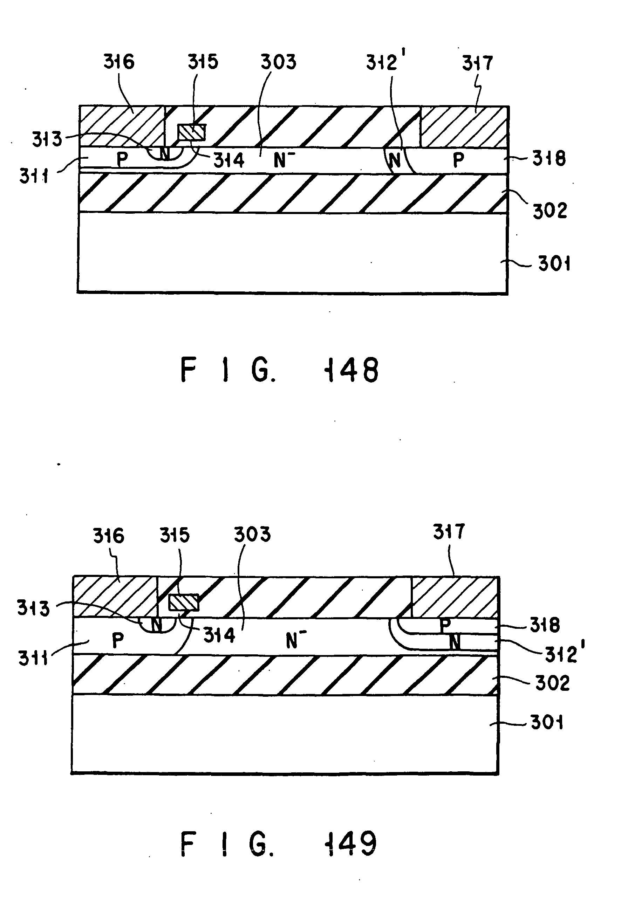

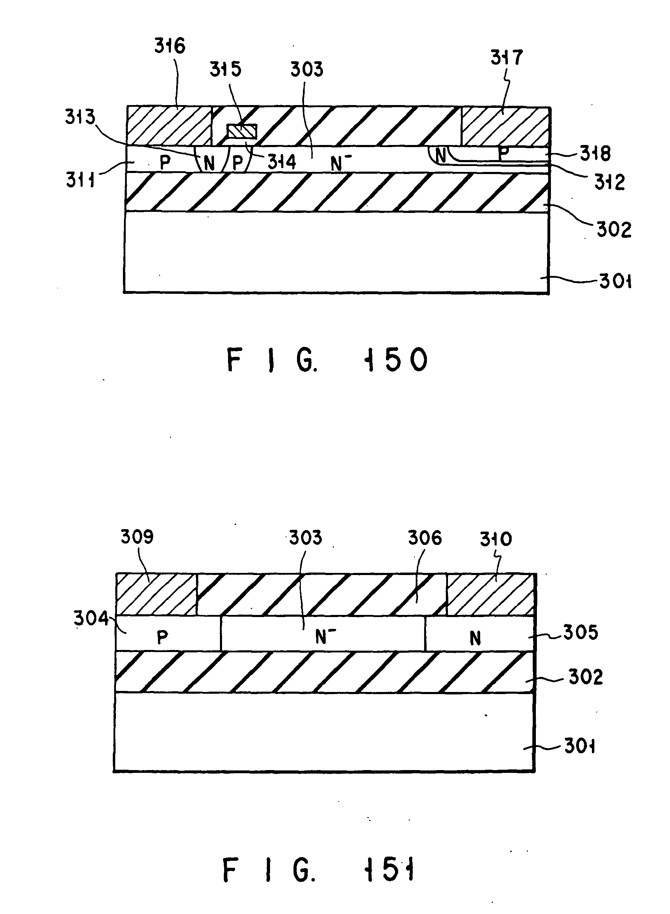

The structure in which the high resistance film is not formed on the high resistance semiconductor layer is not limited to the above-mentioned examples. There can be used the structure in which the high resistance film shown in Figs. 3 to 118 is removed from the high resistance semiconductor layer. Such the structure is shown in Figs. 127 to 151.

**Claims**

1. A semiconductor device which comprises:

   a substrate (1);
   an insulating layer (2) formed on said substrate (1);
   a high resistance semiconductor region (4) of a first conductivity type formed on said insulating layer (2);
   a dielectric isolation region (3) formed in said high resistance semiconductor layer (4);
   an element region formed in said high resistance semiconductor layer (4) isolated by said dielectric isolation region (3) in a lateral direction;
   a first low resistance region (6,203,22,11,17, 53, 74) of a first conductivity type formed in a central surface portion of said element region; and
   a second low resistance region (7, 201, 23, 12, 15, 55, 72) of a second conductivity type formed in a peripheral surface portion of said element region between said first low resistance region (6,203,22,11,17,53, 74) and said dielectric isolation region (3) to be separated from said first low resistance region (6,203,22,11,17, 53,74,);

   **characterized by** a third low resistance region (27, 31,33) of a first conductivity type formed contiguous with the isolation region (3)the device being configured such that a reverse bias voltage ($V_0$) applied between the first and second low resistance regions which causes a depletion layer generated between the insulating layer (2) and second (7, 201, 23, 12, 15, 55, 72) low resistance regions to electrically separate the first low resistance region from the third low resistance region is less than the breakdown voltage ($V_B$) between the second and third low resistance regions.

2. A device according to claim 1, **characterized by** further comprising a buffer layer (10) of a first conductivity type formed on a bottom portion of said element region.

3. A device according to claim 1 or 2, further **characterized in that** said second low resistance region (7, 201, 23, 12, 15, 55, 72) is contiguous with said third low resistance region (27, 31,33).

4. A device according to claim 1, further **characterized in that** said second low resistance region (7, 201, 23, 12, 15, 55, 72) is formed in a surface portion of said element region.

5. A device according to claim 1, further **characterized in that** said second low resistance region (7, 201, 23, 12, 15, 55, 72) extends from a surface portion of said element region to said insulating layer (2).

**Patentansprüche**

1. Halbleiterbauelement, das umfasst:

ein Substrat (1);
eine auf dem Substrat (1) ausgebildete Isolierschicht (2);
eine auf der Isolierschicht (2) ausgebildete hochohmige Halbleiterregion (4) eines ersten Leitfähigkeitstyps;
eine in der hochohmigen Halbleiterschicht (4) ausgebildete dielektrische Isolationsregion (3);
eine in der hochohmigen Halbleiterschicht (4) ausgebildete Elementregion, die durch die dielektrische Isolationsregion (3) in seitlicher Richtung isoliert ist;
eine erste niederohmige Region (6, 203, 22, 11, 17, 53, 74) eines ersten Leitfähigkeitstyps, die in einem zentralen Oberflächenbereich der Elementregion ausgebildet ist; und
eine zweite niederohmige Region (7, 201, 23, 12, 15, 55, 72) eines zweiten Leitfähigkeitstyps, die in einem peripheren Oberflächenbereich der Elementregion zwischen der ersten niederohmigen Region (6, 203, 22, 11, 17, 53, 74) und der dielektrischen Isolationsregion (3) unter Abtrennung von der ersten niederohmigen Region (6, 203, 22, 11, 17, 53, 74) ausgebildet ist;

wobei das Bauelement durch eine dritte niederohmige Region (27, 31, 33) eines ersten Leitfähigkeitstyps, die angrenzend an die Isolationsregion (3) ausgebildet ist, gekennzeichnet ist, wobei das Bauelement derart konfiguriert ist, dass eine zwischen den ersten und zweiten niederohmigen Regionen angelegte Umkehrvorspannung ($V_0$), die bewirkt, dass eine zwischen der Isolierschicht (2) und den zweiten (7, 201, 23, 12, 15, 55, 72) niederohmigen Regionen erzeugte Sperrschicht die erste niederohmige Region von der dritten niederohmigen Region elektrisch trennt, geringer als die Durchbruchspannung ($V_B$) zwischen den zweiten und dritten niederohmigen Regionen ist.

2. Bauelement nach Anspruch 1, das **dadurch gekennzeichnet ist, dass** es ferner eine auf einem unteren Bereich der Elementregion ausgebildete Pufferschicht (10) eines ersten Leitfähigkeitstyps umfasst.

3. Bauelement nach Anspruch 1 oder 2, das ferner **dadurch gekennzeichnet ist, dass** die zweite niederohmige Region (7, 201, 23, 12, 15, 55, 72) an die dritte niederohmige Region (27, 31, 33) angrenzt.

4. Bauelement nach Anspruch 1, das ferner **dadurch gekennzeichnet ist, dass** die zweite niederohmige Region (7, 201, 23, 12, 15, 55, 72) in einem Oberflächenbereich der Elementregion ausgebildet ist.

5. Bauelement nach Anspruch 1, das ferner **dadurch gekennzeichnet ist, dass** sich die zweite niederohmige Region (7, 201, 23, 12, 15, 55, 72) von einem Oberflächenbereich der Elementregion zur Isolierschicht (2) erstreckt.

**Revendications**

1. Dispositif à semi-conducteur qui comprend:

un substrat (1);
une couche isolante (2) qui est formée sur ledit substrat (1);
une région semi-conductrice haute résistance (4) d'un premier type de conductivité qui est formée sur ladite couche isolante (2);
une région d'isolation diélectrique (3) qui est formée dans ladite couche semi-conductrice haute résistance (4);
une région d'élément qui est formée dans ladite couche semi-conductrice haute résistance (4), laquelle est isolée par ladite région d'isolation diélectrique (3) dans une direction latérale;
une première région faible résistance (6, 203, 22, 11, 17, 53, 74) d'un premier type de conductivité qui est formée dans une portion de surface centrale de ladite région d'élément; et
une deuxième région faible résistance (7, 201, 23. 12, 15, 55, 72) d'un second type de conductivité qui est formée dans une portion de surface périphérique de ladite région d'élément entre ladite première région faible résistance (6, 203, 22, 11, 17, 53, 74) et ladite région d'isolation diélectrique (3), laquelle est séparée de ladite première région faible résistance (6, 203, 22, 11, 17, 53, 74);
**caractérisé par** une troisième région faible résistance (27, 31, 33) d'un premier type de conductivité qui est contiguë à la région d'isolation (3), le dispositif étant configuré de sorte qu'une tension de polarisation inverse ($V_0$) appliquée entre les première et deuxième régions faible résistance et qui fait en sorte qu'une couche de déplétion générée entre la couche isolante (2) et les deuxièmes régions faible résistance (7, 201, 23, 12, 15, 55, 72) sépare électriquement la première région faible résistance de la troisième région faible résistance est moindre que la tension de claquage ($V_B$) entre les deuxième et troisième régions faible résistance.

2. Dispositif selon la revendication 1, **caractérisée en outre en ce qu'**il comprend une couche tampon (10) d'un premier type de conductivité formée sur une portion inférieure de ladite région d'élément.

3. Dispositif selon la revendication 1 ou 2, **caractérisé en outre en ce que** ladite deuxième région faible résistance (7, 201, 23, 12, 15, 55, 72) est contiguë à ladite troisième région faible résistance (27, 31, 33).

4. Dispositif selon la revendication 1, **caractérisé en outre en ce que** ladite deuxième région faible résistance (7, 201, 23, 12, 15, 55, 72) est formée sur une portion de surface de ladite région d'élément.

5. Dispositif selon la revendication 1, **caractérisé en outre en ce que** ladite deuxième région faible résistance (7, 201, 23, 12, 15, 55, 72) s'étend depuis une portion de surface de ladite région d'élément jusqu'à ladite couche d'isolation (2).

EP 1 202 352 B1

K   A

105   104   111   110   103   111   104   105

p+   n+   p+

107   106   107

p+   108   n⁻ (p⁻)   p+

109   p+   109

p+

102

p+

101

F I G.  1

FIG. 2

FIG 3

EP 1 202 352 B1

K    A

5    3         9              8    4    9         3    5

p+                n+                p+

7         6              10         7

n⁻⁻

n⁻

2

1

F I G.   4

F I G. 5

F I G. 6

F I G. 7

F I G. 8

F I G. 9

F I G. 10

F I G. 11

F I G. 12

32

F I G. 13

EP 1 202 352 B1

F I G. 14

EP 1 202 352 B1

F I G. 15

F I G. 16

F I G. 17

F I G. 18

F I G. 19

F I G. 20

F I G. 21

F I G. 22

F I G.   23

F I G.   24

F I G. 25

F I G. 26

F I G.  27

EP 1 202 352 B1

F I G. 28

F I G. 29

F I G. 30

F I G. 31

F I G. 32

F I G. 33

EP 1 202 352 B1

A    K

25    24    4    25

5    3    3    5

p+    p+    p+    n+    23    22    p−    23    n+    p+

2

1

F I G.  34

F I G. 35

F I G. 36

F I G. 37

F I G. 38

F I G. 39

F I G. 40

F I G. 41

F I G. 42

K      A

5   3       9        8    4    9     3   5

$p^+$       $n^+$        $p^+$

7      6    $n^-$ $(p^-)$     7

71             2

1

F I G.    43

S     G         D

79        78    4    82    81     80

3     p   73   $n^+$   77      $n^-$    74   n   $p^+$   75

72       71    2

1

F I G.    44

F I G. 45

F I G. 46

F I G. 47

F I G. 48

F I G. 49

F I G. 50

F I G. 51

EP 1 202 352 B1

F I G. 52

FIG. 53

F I G. 54

F I G. 55

FIG. 56A

FIG. 56B

FIG. 56C

FIG. 56D

FIG. 56E

FIG. 56F

FIG. 56G

FIG. 56H

FIG. 56I

234  235  238

FIG. 56J

234  235  238

FIG. 56K

234  235  238  239

FIG. 56L

234  235

FIG. 56M

4

235  234

240  1

FIG. 56N

4

235  234

1

FIG. 56O

FIG. 56P

F I G. 57

F I G. 58

F I G.  59

F I G.  60

F I G. 61

F I G. 62

F I G. 63

F I G. 64

F I G. 65

F I G. 66

F I G. 67

F I G. 68

F I G. 69

F I G. 70

F I G. 71

F I G. 72

F I G. 73

F I G. 74

309 307 308 310
303 306

304 ~ P    N⁻    N ~ 305

302

301

F I G. 75

316 315 307 308 317
303 306

313 N
311 P    N⁻    N ~ 312
314

302

301

F I G. 76

F I G. 77

F I G. 78

F I G. 79

F I G. 80

F I G.    81

F I G.    82

F I G. 83

F I G. 84

F I G. 85

F I G. 86

F I G. 87

F I G. 88

309 307 303 308 306 310

304 P N⁻ N 305

320

302

301

F I G. 89

316 315 307 303 308 306 317

313

311 P N N⁻ N 312

314

320

302

301

F I G. 90

F I G. 91

F I G. 92

F I G. 93

F I G. 94

F I G. 95

F I G. 96

F I G. 97

F I G. 98

F I G. 99

F I G. 100

F I G. 101

F I G. 102

309 307 303 308 306 310

304 P N⁻ N 305

320

302

321 301

F I G. 103

316 315 307 303 308 306 317

313
311 P N N⁻ N 312
314

320

302

321 301

F I G. 104

F I G. 105

F I G. 106

F I G. 107

F I G. 108

F I G. 109

F I G. 110

316 315 303 307 308 317

313

311 P N 314 N⁻ N 312

302

301

FIG. 111

315 308

316 303 307 312' 317

313

311 P N 314 N⁻ N P 318

302

301

FIG. 112

F I G. 113

F I G. 114

F I G. 115

F I G. 116

F I G. 117

F I G. 118

322          303          322

N⁻

302

301

F I G.    119A

325    324    323    303    324    325    323

N⁻

302

301

F I G.    119B

303          326

P    N⁻    P

302

301

F I G.    119C

F I G. 120

F I G. 121

F I G. 122

F I G. 123

F I G. 124

F I G. 125

F I G. 126

F I G. 127

F I G. 128

F I G. 129

F I G. 130

316 315 303 306 312' 317

313

311 P N P 314 N⁻ N P 318

302

301

F I G. 131

309 303 306 310

304 P N⁻ N 305

320

302

301

F I G. 132

F I G. 133

F I G. 134

F I G. 135

316  315  303  306  317

313

311  P    N    314    N⁻    N    312

320

302

321  301

F I G. 136

316  315

303

315

317

313

311  P  N  P  314    N⁻    N    312

320

302

321  301

F I G. 137

F I G. 138

F I G. 139

309    303    306    310

304    P    N⁻    N    305

302

301

F I G. 140

309    306    303    310

304    P    N⁻    N    305

302

301

F I G. 141

316    315    303                   317

313
311                                      312

P   N    314    N⁻           N

302

301

F I G.    142

316    315    303                   317

313
311                                      312

P   N  P   314    N⁻           N

302

301

F I G.    143

F I G. 144

F I G. 145

F I G. 146

F I G. 147

316    315    303    312'    317

313

311    P    N    314    N⁻    N    P    318

302

301

F I G.    148

316    315    303    317

313

311    P    N    314    N⁻    318
312'

P
N

302

301

F I G.    149

F I G. 150

F I G. 151

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 3806164 A1
- US 4729008 A
- US 4807012 A
- EP 0280535 A